# EUROPÄISCHE PATENTSCHRIFT

(11) **EP 3 548 535 B1**
(45) Veröffentlichungstag und Bekanntmachung des Hinweises auf die Patenterteilung: **16.11.2022**
(21) Anmeldenummer: 17804190.1
(22) Anmeldetag: 27.11.2017
(51) Int. Cl.: C08G 61/12, C08K 5/01, C08K 5/03, C08L 65/00, H01L 51/00, H01L 51/50

(54) **POLYMERE MIT ASYMMETRISCHEN WIEDERHOLUNGSEINHEITEN**
POLYMERS WITH ASYMMETRIC REPEATING UNITS
POLYMÈRES COMPRENANT DES MOTIFS RÉPÉTITIFS ASYMÉTRIQUES

(30) Priorität: 30.11.2016 EP 16201317
(43) Veröffentlichungstag der Anmeldung: 09.10.2019
(73) Patentinhaber: Merck Patent GmbH, 64293 Darmstadt (DE)
(72) Erfinder: BURKHART, Beate, 64293 Darmstadt (DE); SCHEIBLE, Katja Maria, 64287 Darmstadt (DE); KOENEN, Nils, 64347 Griesheim (DE); HEIL, Holger, 60316 Frankfurt Am Main (DE)
(86) Internationale Anmeldenummer: PCT/EP2017/080486
(87) Internationale Veröffentlichungsnummer: WO 2018/099847

(56) Entgegenhaltungen:
- EP-A1- 1 831 326
- EP-A2- 1 558 662
- WO-A1-2016/107668
- WO-A1-2016/159292
- US-A1- 2009 321 723

## Beschreibung

Die vorliegende Erfindung betrifft Polymere mit asymmetrischen Wiederholungseinheiten, Verfahren zu deren Herstellung sowie deren Verwendung in elektronischen bzw. optoelektronischen Vorrichtungen, insbesondere in organischen Elektrolumineszenzvorrichtungen, sogenannten OLEDs (OLED = Organic Light Emitting Diodes). Darüber hinaus betrifft die vorliegende Erfindung auch organische Elektrolumineszenzvorrichtungen enthaltend diese Polymere.

In elektronischen bzw. optoelektronischen Vorrichtungen, insbesondere in organischen Elektrolumineszenzvorrichtungen (OLED) werden Komponenten verschiedener Funktionalität benötigt. In OLEDs liegen die verschiedenen Funktionalitäten dabei normalerweise in verschiedenen Schichten vor. Man spricht in diesem Fall von mehrschichtigen OLED-Systemen. Diese mehrschichtigen OLED-Systeme weisen dabei unter anderem ladungsinjizierende Schichten, wie z.B. elektronen- und lochinjizierende Schichten, ladungstransportierende Schichten, wie z.B. elektronen- und lochleitende Schichten, sowie Schichten auf, die lichtemittierende Komponenten enthalten. Diese mehrschichtigen OLED-Systeme werden in der Regel durch das aufeinanderfolgende schichtweise Aufbringen hergestellt.

Werden dabei mehrere Schichten aus Lösung aufgebracht, ist darauf zu achten, dass eine bereits aufgebrachte Schicht nach deren Trocknung nicht durch das nachfolgende Aufbringen der Lösung zur Herstellung der nächsten Schicht zerstört wird. Dies kann beispielsweise dadurch erreicht werden, dass eine Schicht unlöslich gemacht wird, beispielsweise durch Vernetzung. Solche Verfahren werden z.B. in der EP 0 637 899 und der WO 96/20253 offenbart.

Darüber hinaus ist es aber auch notwendig, die Funktionalitäten der einzelnen Schichten von der Materialseite her so aufeinander abzustimmen, dass möglichst gute Ergebnisse, z.B. hinsichtlich Lebensdauer, Effizienz, etc. erreicht werden. So haben insbesondere die Schichten, die direkt an eine emittierende Schicht angrenzen, insbesondere die lochtransportierende Schicht (HTL = Hole Transport Layer), einen signifikanten Einfluss auf die Eigenschaften der angrenzenden emittierenden Schicht.

Eine der Aufgaben der vorliegenden Erfindung lag deshalb in der Bereitstellung von Verbindungen, die einerseits aus Lösung verarbeitet werden können und die andererseits bei der Verwendung in elektronischen bzw. opto-elektronischen Vorrichtungen, vorzugsweise in OLEDs, und hier insbesondere in deren Lochtransportschicht, zu einer Verbesserung der Eigenschaften der Vorrichtung, d.h. insbesondere der OLED, führen.

Überraschenderweise wurde gefunden, dass Polymere, welche asymmetrische Wiederholungseinheiten aufweisen, insbesondere bei Verwendung in der lochtransportierenden Schicht von OLEDs zu einer deutlichen Erhöhung der Lebensdauer dieser OLEDs führen.

Gegenstand der vorliegenden Anmeldung ist somit ein Polymer, das 1 bis 100 mol% mindestens einer Wiederholungseinheit der folgenden Formel (la) aufweist: 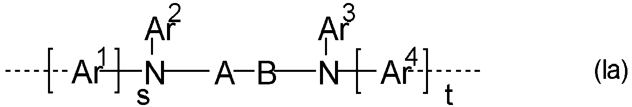 wobei
- A: ein polycyclisches, aromatisches oder heteroaromatisches Ringsystem mit 10 bis 30 aromatischen oder heteroaromatischen Ringatomen ist, das mit einem oder mehreren Resten R substituiert sein kann,
- B: ein mono- oder polycyclisches, aromatisches oder heteroaromatisches Ringsystem mit 5 bis 10 aromatischen oder heteroaromatischen Ringatomen ist, das mit einem oder mehreren Resten R substituiert sein kann,
wobei die Anzahl der aromatischen oder heteroaromatischen Ringatome von A größer ist als die Anzahl der aromatischen oder heteroaromatischen Ringatome von B,
- Ar¹, Ar², Ar³: und Ar⁴ bei jedem Auftreten, jeweils gleich oder verschieden, ein mono- oder polycyclisches, aromatisches oder heteroaromatisches Ringsystem mit 5 bis 60 aromatischen Ringatomen ist, das mit einem oder mehreren Resten R substituiert sein kann,
- s und t,: jeweils gleich oder verschieden, 0 oder 1 sind,
- R: bei jedem Auftreten gleich oder verschieden H, eine geradkettige Alkyl- oder Alkoxygruppe mit 1 bis 10 C-Atomen oder eine Alkenyl- oder Alkinylgruppe mit 2 bis 10 C-Atomen oder eine verzweigte oder cyclische Alkyl- oder Alkoxygruppe mit 3 bis 10 C-Atomen, die jeweils mit einem oder mehreren Resten R¹ substituiert sein kann, wobei eine oder mehrere nicht benachbarte CH₂-Gruppen durch R¹C=CR¹, C≡C, C=O, C=NR¹, NR¹, O oder CONR¹ ersetzt sein können, oder ein aromatisches oder heteroaromatisches Ringsystem mit 5 bis 20 aromatischen Ringatomen, das jeweils durch einen oder mehrere Reste R¹ substituiert sein kann, oder eine Aryloxy- oder Heteroaryloxygruppe mit 5 bis 20 aromatischen Ringatomen, die durch einen oder mehrere Reste R¹ substituiert sein kann, oder eine Aralkyl- oder Heteroaralkylgruppe mit 5 bis 20 aromatischen Ringatomen, die durch einen oder mehrere Reste R¹ substituiert sein kann, oder eine Diarylaminogruppe, Diheteroarylaminogruppe oder Arylheteroarylaminogruppe mit 10 bis 20 aromatischen Ringatomen, welche durch einen oder mehrere Reste R¹ substituiert sein kann, oder eine vernetzbare Gruppe Q, wobei zwei oder mehrere Reste R auch miteinander ein mono- oder polycyclisches, aliphatisches, aromatisches und/oder benzoannelliertes Ringsystem bilden können;
- R¹: bei jedem Auftreten gleich oder verschieden H, D, F oder ein aliphatischer Kohlenwasserstoffrest mit 1 bis 20 C-Atomen, ein aromatischer und/oder ein heteroaromatischer Kohlenwasserstoffrest mit 5 bis 20 C-Atomen ist, in dem auch ein oder mehrere H-Atome durch F ersetzt sein können; wobei zwei oder mehrere Substituenten R¹ auch miteinander ein mono- oder polycyclisches, aliphatisches, aromatisches oder heteroaromatisches Ringsystem bilden können;
- Q: eine endständige oder cyclische Alkenylgruppe, eine endständige Dienyl- oder Alkinylgruppe, eine Alkenyloxy-, Dienyloxy- oder Alkinyloxygruppe, eine Acrylsäuregruppe, eine Oxetan- oder
Oxirangruppe, eine Silangruppe oder eine Cyclobutangruppe ist, und und
die gestrichelten Linien Bindungen zu benachbarten Wiederholungseinheiten im Polymer darstellen.

In der vorliegenden Anmeldung sind unter dem Begriff Polymer sowohl polymere Verbindungen, oligomere Verbindungen sowie Dendrimere zu verstehen. Die erfindungsgemäßen polymeren Verbindungen weisen vorzugsweise 10 bis 10000, besonders bevorzugt 10 bis 5000 und ganz besonders bevorzugt 10 bis 2000 Wiederholungseinheiten auf. Die erfindungsgemäßen oligomeren Verbindungen weisen vorzugsweise 3 bis 9 Wiederholungseinheiten auf. Der Verzweigungs-Faktor der Polymere liegt dabei zwischen 0 (lineares Polymer, ohne Verzweigungs-stellen) und 1 (vollständig verzweigtes Dendrimer).

Die erfindungsgemäßen Polymere weisen vorzugsweise ein Molekulargewicht M_{w} im Bereich von 10.000 bis 1.000.000 g/mol, besonders bevorzugt ein Molekulargewicht M_{w} im Bereich von 20.000 bis 500.000 g/mol und ganz besonders bevorzugt ein Molekulargewicht M_{w} im Bereich von 25.000 bis 200.000 g/mol auf. Die Bestimmung des Molekulargewichts M_{w} erfolgt mittels GPC (= Gelpermeationschromatographie) gegen einen internen Polystyrolstandard.

Bei den erfindungsgemäßen Polymeren handelt es sich entweder um konjugierte, teilkonjugierte oder nicht-konjugierte Polymere. Bevorzugt sind konjugierte oder teilkonjugierte Polymere.

Die Wiederholungseinheiten der Formel (la) können erfindungsgemäß in die Haupt- oder in die Seitenkette des Polymeren eingebaut werden. Vorzugsweise werden die Wiederholungseinheiten der Formel (la) jedoch in die Hauptkette des Polymeren eingebaut. Bei Einbau in die Seitenkette des Polymeren können die Wiederholungseinheiten der Formel (la) entweder mono- oder bivalent sein, d.h. sie weisen entweder eine oder zwei Bindungen zu benachbarten Wiederholungseinheiten im Polymer auf.

"Konjugierte Polymere" im Sinne der vorliegenden Anmeldung sind Polymere, die in der Hauptkette hauptsächlich sp²-hybridisierte (bzw. gegebenenfalls auch sp-hybridisierte) Kohlenstoffatome enthalten, die auch durch entsprechend hybridisierte Heteroatome ersetzt sein können. Dies bedeutet im einfachsten Fall abwechselndes Vorliegen von Doppel- und Einfachbindungen in der Hauptkette, aber auch Polymere mit Einheiten wie beispielsweise einem meta-verknüpften Phenylen sollen im Sinne dieser Anmeldung als konjugierte Polymere gelten. "Hauptsächlich" meint, dass natürlich (unwillkürlich) auftretende Defekte, die zu Konjugationsunterbrechungen führen, den Begriff "konjugiertes Polymer" nicht entwerten. Als konjugierte Polymere gelten ebenfalls Polymere mit einer konjugierten Hauptkette und nicht-konjugierten Seitenketten. Des Weiteren wird in der vorliegenden Anmeldung ebenfalls als konjugiert bezeichnet, wenn sich in der Hauptkette beispielsweise Arylamineinheiten, Arylphosphineinheiten, bestimmte Heterocyclen (d.h. Konjugation über N-, O- oder S-Atome) und/oder metallorganische Komplexe (d.h. Konjugation über das Metallatom) befinden. Analoges gilt für konjugierte Dendrimere. Hingegen werden Einheiten wie beispielsweise einfache Alkylbrücken, (Thio)Ether-, Ester-, Amid- oder Imidverknüpfungen eindeutig als nicht-konjugierte Segmente definiert.

Unter einem teilkonjugierten Polymer soll in der vorliegenden Anmeldung ein Polymer verstanden werden, das konjugierte Regionen enthält, die durch nicht-konjugierte Abschnitte, gezielte Konjugationsunterbrecher (z.B. Abstandsgruppen) oder Verzweigungen voneinander getrennt sind, z.B. in dem längere konjugierte Abschnitte in der Hauptkette durch nicht-konjugierte Abschnitte unterbrochen sind, bzw. das längere konjugierte Abschnitte in den Seitenketten eines in der Hauptkette nicht-konjugierten Polymers enthält. Konjugierte und teilkonjugierte Polymere können auch konjugierte, teilkonjugierte oder nicht-konjugierte Dendrimere enthalten.

Unter dem Begriff "Dendrimer" soll in der vorliegenden Anmeldung eine hochverzweigte Verbindung verstanden werden, die aus einem multifunktionellen Zentrum (core) aufgebaut ist, an das in einem regelmäßigen Aufbau verzweigte Monomere gebunden werden, so dass eine baumartige Struktur erhalten wird. Dabei können sowohl das Zentrum als auch die Monomere beliebige verzweigte Strukturen annehmen, die sowohl aus rein organischen Einheiten als auch Organometallverbindungen oder Koordinationsverbindungen bestehen. "Dendrimer" soll hier allgemein so verstanden werden, wie dies z.B. von M. Fischer und F. Vögtle (Angew. Chem., Int. Ed. 1999, 38, 885) beschrieben ist.

Unter dem Begriff "mono- oder polycyclisches, aromatisches Ringsystem" wird in der vorliegenden Anmeldung ein aromatisches Ringsystem mit 6 bis 60, vorzugsweise 6 bis 30 und besonders bevorzugt 6 bis 24 aromatischen Ringatomen verstanden, das nicht notwendigerweise nur aromatische Gruppen enthält, sondern in dem auch mehrere aromatische Einheiten durch eine kurze nicht-aromatische Einheit (< 10 % der von H verschiedenen Atome, vorzugsweise < 5 % der von H verschiedenen Atome), wie beispielsweise ein sp³-hybridisiertes C-Atom bzw. O- oder N-Atom, eine CO-Gruppe etc., unterbrochen sein können. So sollen beispielsweise auch Systeme wie z.B. 9,9'-Spirobifluoren, 9,9-Diarylfluoren und 9,9-Dialkylfluoren, als aromatische Ringsysteme verstanden werden. Die aromatischen Ringsysteme können mono- oder polycyclisch sein, d.h. sie können einen Ring (z.B. Phenyl) oder mehrere Ringe aufweisen, welche auch kondensiert (z.B. Naphthyl) oder kovalent verknüpft sein können (z.B. Biphenyl), oder eine Kombination von kondensierten und verknüpften Ringen enthalten.

Bevorzugte aromatische Ringsysteme sind z.B. Phenyl, Biphenyl, Terphenyl, [1,1':3',1"]Terphenyl-2'-yl, Quarterphenyl, Naphthyl, Anthracen, Binaphthyl, Phenanthren, Dihydrophenanthren, Pyren, Dihydropyren, Chrysen, Perylen, Tetracen, Pentacen, Benzpyren, Fluoren, Inden, Indenofluoren und Spirobifluoren.

Unter dem Begriff "mono- oder polycyclisches, heteroaromatisches Ringsystem" wird in der vorliegenden Anmeldung ein aromatisches Ringsystem mit 5 bis 60, vorzugsweise 5 bis 30 und besonders bevorzugt 5 bis 24 aromatischen Ringatomen verstanden, wobei ein oder mehrere dieser Atome ein Heteroatom ist/sind. Das "mono- oder polycyclische, heteroaromatische Ringsystem" enthält nicht notwendigerweise nur aromatische Gruppen, sondern kann auch durch eine kurze nicht-aromatische Einheit (< 10 % der von H verschiedenen Atome, vorzugsweise < 5 % der von H verschiedenen Atome), wie beispielsweise ein sp³-hybridisiertes C-Atom bzw. O- oder N-Atom, eine CO-Gruppe etc., unterbrochen sein.

Die heteroaromatischen Ringsysteme können mono- oder polycyclisch sein, d.h. sie können einen Ring oder mehrere Ringe aufweisen, welche auch kondensiert oder kovalent verknüpft sein können (z.B. Pyridylphenyl), oder eine Kombination von kondensierten und verknüpften Ringen enthalten. Bevorzugt sind vollständig konjugierte Heteroarylgruppen.

Bevorzugte heteroaromatische Ringsysteme sind z.B. 5-gliedrige Ringe wie Pyrrol, Pyrazol, Imidazol, 1,2,3-Triazol, 1,2,4-Triazol, Tetrazol, Furan, Thiophen, Selenophen, Oxazol, Isoxazol, 1,2-Thiazol, 1,3-Thiazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 6-gliedrige Ringe wie Pyridin, Pyridazin, Pyrimidin, Pyrazin, 1,3,5-Triazin, 1,2,4-Triazin, 1,2,3-Triazin, 1,2,4,5-Tetrazin, 1,2,3,4-Tetrazin, 1,2,3,5-Tetrazin, oder Gruppen mit mehreren Ringen, wie Carbazol, Indenocarbazol, Indol, Isoindol, Indolizin, Indazol, Benzimidazol, Benzotriazol, Purin, Naphthimidazol, Phenanthrimidazol, Pyridimidazol, Pyrazinimidazol, Chinoxalinimidazol, Benzoxazol, Naphthoxazol, Anthroxazol, Phenanthroxazol, Isoxazol, Benzothiazol, Benzofuran, Isobenzofuran, Dibenzofuran, Chinolin, Isochinolin, Pteridin, Benzo-5,6-chinolin, Benzo-6,7-chinolin, Benzo-7,8-chinolin, Benzoisochinolin, Acridin, Phenothiazin, Phenoxazin, Benzopyridazin, Benzopyrimidin, Chinoxalin, Phenazin, Naphthyridin, Azacarbazol, Benzocarbolin, Phenanthridin, Phenanthrolin, Thieno[2,3b]thiophen, Thieno[3,2b]thiophen, Dithienothiophen, Isobenzothiophen, Dibenzothiophen, Benzothiadiazothiophen oder Kombinationen dieser Gruppen.

Das mono- oder polycyclische, aromatische oder heteroaromatische Ringsystem kann unsubstituiert oder substituiert sein. Substituiert heißt in der vorliegenden Anmeldung, dass das mono- oder polycyclische, aromatische oder heteroaromatische Ringsystem einen oder mehrere Substituenten R aufweist.

Bevorzugte Alkylgruppen mit 1 bis 10 C-Atomen sind in der folgenden Tabelle abgebildet:

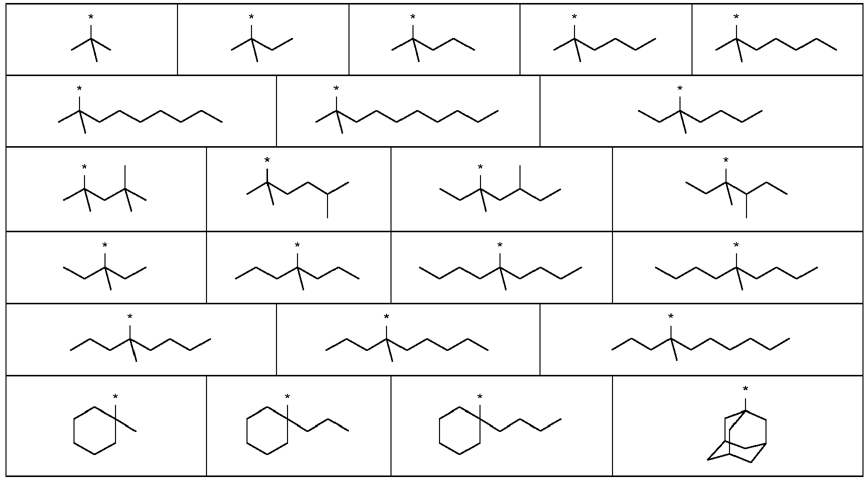

R¹ ist bei jedem Auftreten vorzugsweise gleich oder verschieden H, D, F oder ein aliphatischer Kohlenwasserstoffrest mit 1 bis 20 C-Atomen, ein aromatischer und/oder ein heteroaromatischer Kohlenwasserstoffrest mit 5 bis 20 C-Atomen, in dem auch ein oder mehrere H-Atome durch F ersetzt sein können; dabei können zwei oder mehrere Substituenten R¹ auch miteinander ein mono- oder polycyclisches, aliphatisches, aromatisches oder heteroaromatisches Ringsystem bilden.

R¹ ist bei jedem Auftreten besonders bevorzugt gleich oder verschieden H, D oder ein aliphatischer Kohlenwasserstoffrest mit 1 bis 20 C-Atomen, ein aromatischer und/oder ein heteroaromatischer Kohlenwasserstoffrest mit 5 bis 20 C-Atomen; dabei können zwei oder mehrere Substituenten R¹ auch miteinander ein mono- oder polycyclisches, aliphatisches, aromatisches oder heteroaromatisches Ringsystem bilden.

R¹ ist bei jedem Auftreten ganz besonders bevorzugt gleich oder verschieden H oder ein aliphatischer Kohlenwasserstoffrest mit 1 bis 10 C-Atomen, ein aromatischer und/oder ein heteroaromatischer Kohlenwasserstoffrest mit 5 bis 10 C-Atomen.

In einer ersten bevorzugten Ausführungsform der vorliegenden Erfindung ist in der Wiederholungseinheit der Formel (la) (s = t = 1) oder (s = t = 0), das heißt, dass die Wiederholungseinheit der Formel (la) bevorzugt die Struktur der folgenden Formeln (Ia1) oder (Ia2) aufweist: 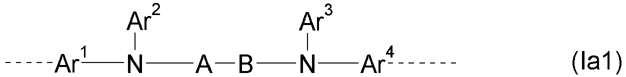 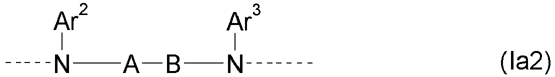 wobei A, B, Ar¹, Ar², Ar³ und Ar⁴ die oben in Bezug auf Formel (la) angegebenen Bedeutungen annehmen können.

In den Wiederholungseinheiten der Formeln (la), (Ia1) und (Ia2) ist das polycyclische, aromatische oder heteroaromatische Ringsystem A vorzugsweise ausgewählt aus den folgenden Einheiten A1 bis A8:

| | |
|---|---|
| 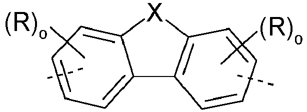 | 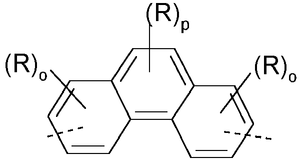 |
| A1 | A2 |
| 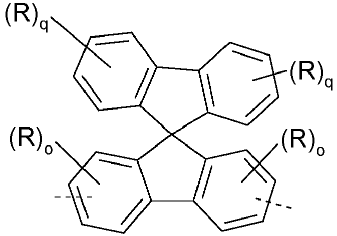 | 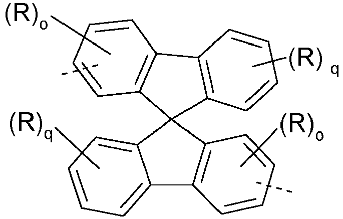 |
| A3 | A4 |
| 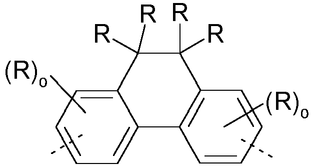 | 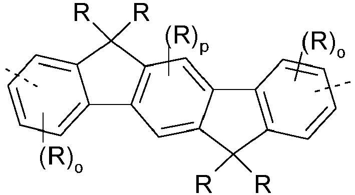 |
| A5 | A6 |
| 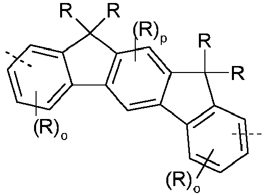 | 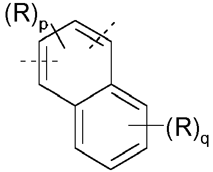 |
| A7 | A8 |

wobei R die oben angegebenen Bedeutungen annehmen kann,
X = CR², NR, SiR², O, S, C=O oder P=O, vorzugsweise CR², NR, O oder S, ist,
o = 0, 1, 2 oder 3 ist,
p = 0, 1 oder 2 ist, und
q = 0, 1, 2, 3 oder 4 ist.

In den Wiederholungseinheiten der Formeln (la), (Ia1) und (Ia2) ist das polycyclische, aromatische oder heteroaromatische Ringsystem A besonders bevorzugt ausgewählt aus den folgenden Einheiten A1a bis A8a:

| | |
|---|---|
| 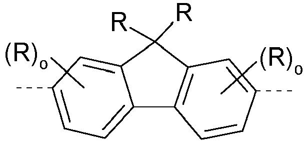 | 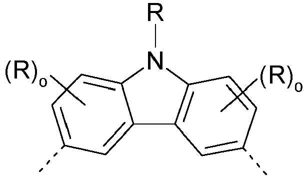 |
| A1a | A1b |
| 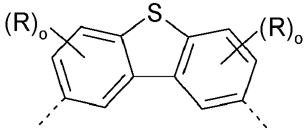 | 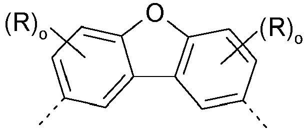 |
| A1c | A1d |
| 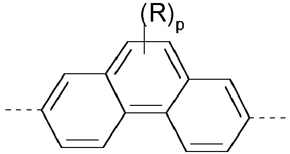 | 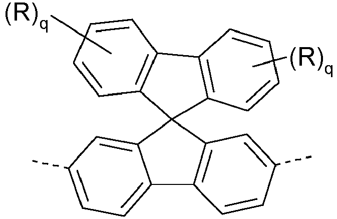 |
| A2a | A3a |
| 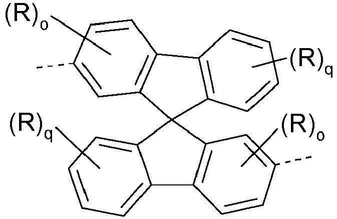 | 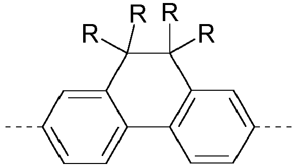 |
| A4a | A5a |
| 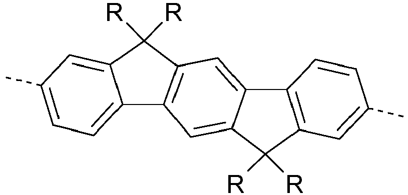 | 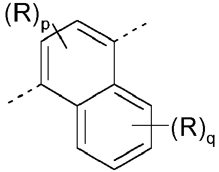 |
| A6a | A8a |

wobei R, o, p und q die oben angegebenen Bedeutungen annehmen können.

In den Wiederholungseinheiten der Formeln (Ia), (Ia1) und (Ia2) ist das polycyclische, aromatische oder heteroaromatische Ringsystem A ganz besonders bevorzugt ausgewählt aus den folgenden Einheiten A1aa bis A8aa:

| | |
|---|---|
| 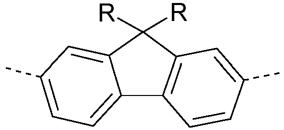 | 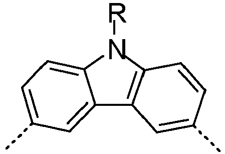 |
| A1aa | A1ba |
| 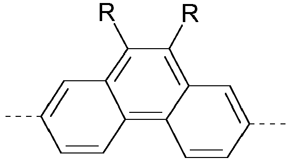 | 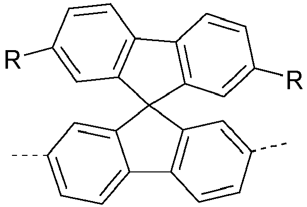 |
| A2aa | A3aa |
| 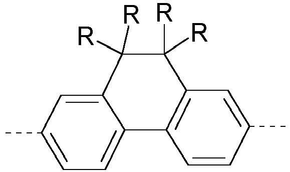 | 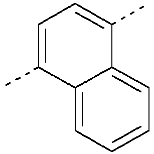 |
| A5aa | A8aa |

wobei R die oben angegebenen Bedeutungen annehmen kann.

In den Wiederholungseinheiten der Formeln (Ia), (Ia1) und (Ia2) ist das mono- oder polycyclische, aromatische oder heteroaromatische Ringsystem B vorzugsweise ausgewählt aus den folgenden Einheiten B1 bis B4:

| | |
|---|---|
| 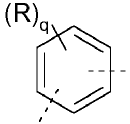 | 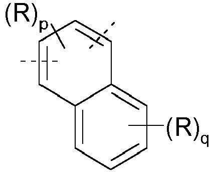 |
| B1 | B2 |
| 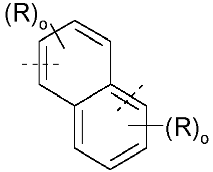 | 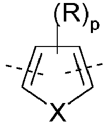 |
| B3 | B4 |

wobei R, o, p, q und X die oben in Bezug auf die Ringsysteme A angegebenen Bedeutungen annehmen können.

In den Wiederholungseinheiten der Formeln (Ia), (Ia1) und (Ia2) ist das mono- oder polycyclische, aromatische oder heteroaromatische Ringsystem B besonders bevorzugt ausgewählt aus den folgenden Einheiten B1a bis B4d:

| | |
|---|---|
| 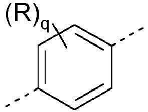 | 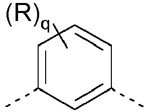 |
| B1a | B1b |
| 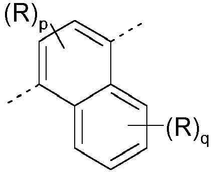 | 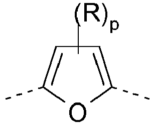 |
| B2a | B4a |
| 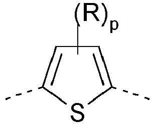 | 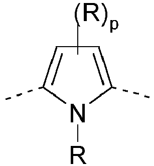 |
| B4b | B4c |
| 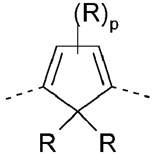 | |
| B4d | |

wobei R, p und q die oben in Bezug auf die Ringsysteme A angegebenen Bedeutungen annehmen können.

In den Wiederholungseinheiten der Formeln (Ia), (Ia1) und (Ia2) ist das mono- oder polycyclische, aromatische oder heteroaromatische Ringsystem B ganz besonders bevorzugt ausgewählt aus den folgenden Einheiten B1aa bis B4ca:

| | |
|---|---|
| 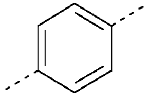 | 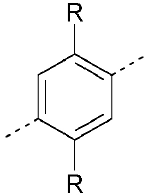 |
| B1aa | B1ab |
| 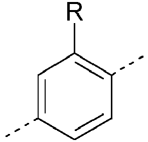 | 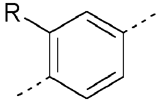 |
| B1ac | B1ad |
| 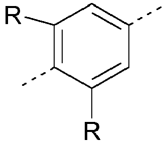 | 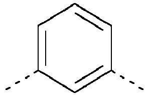 |
| B1ae | B1ba |
| 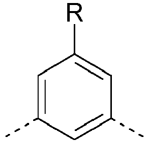 | 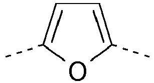 |
| B1bb | B4aa |
| 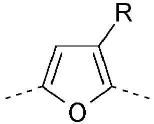 | 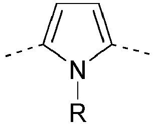 |
| B4ab | B4ca |

wobei R die oben in Bezug auf die Ringsysteme A angegebenen Bedeutungen annehmen kann.

In den Wiederholungseinheiten der Formeln (Ia), (Ia1) und (Ia2) sind die mono- oder polycyclischen, aromatischen oder heteroaromatischen Ringsysteme Ar² und Ar³ vorzugsweise ausgewählt aus den folgenden Einheiten Ar1 bis Ar10:

| | |
|---|---|
| 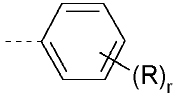 | 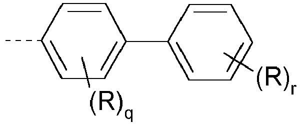 |
| Ar1 | Ar2 |
| 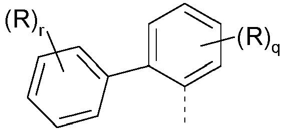 | 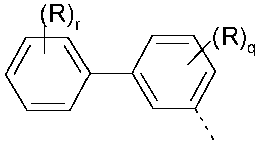 |
| Ar3 | Ar4 |
| 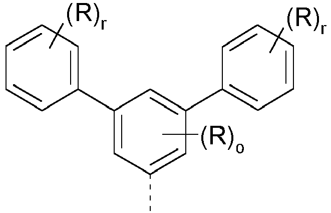 | 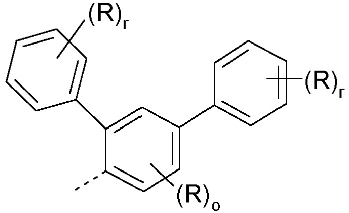 |
| Ar5 | Ar6 |
| 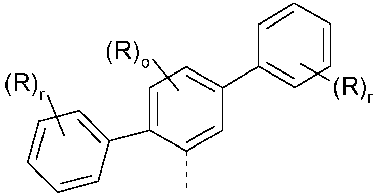 | 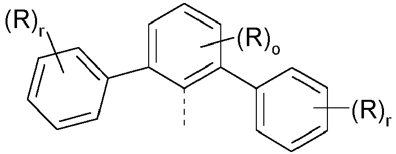 |
| Ar7 | Ar8 |
| 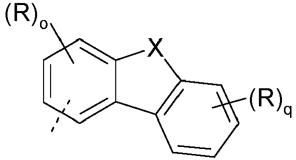 | 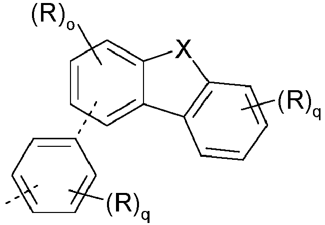 |
| Ar9 | Ar10 |

wobei R, o, q und X die oben in Bezug auf die Ringsysteme A angegebenen Bedeutungen annehmen können, und
r = 0, 1, 2, 3, 4 oder 5 ist.

In den Wiederholungseinheiten der Formeln (Ia), (Ia1) und (Ia2) sind die mono- oder polycyclischen, aromatischen oder heteroaromatischen Ringsysteme Ar² und Ar³ besonders bevorzugt ausgewählt aus den Einheiten Ar1 bis Ar10, wobei in den Einheiten Ar9 und Ar10 X ausgewählt ist aus CR², O, NR und S.

In den Wiederholungseinheiten der Formeln (Ia), (Ia1) und (Ia2) sind die mono- oder polycyclischen, aromatischen oder heteroaromatischen Ringsysteme Ar² und Ar³ ganz besonders bevorzugt ausgewählt aus den folgenden Einheiten Ar1a bis Ar10c:

| | |
|---|---|
| 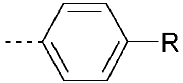 | 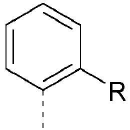 |
| Ar1a | Ar1b |
| 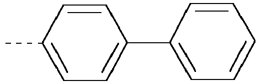 | 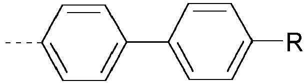 |
| Ar2a | Ar2b |
| 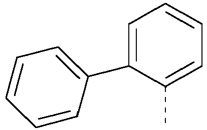 | 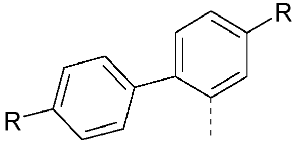 |
| Ar3a | Ar3b |
| 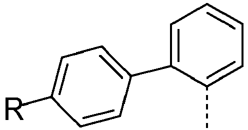 | |
| Ar3c | |
| 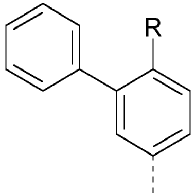 | 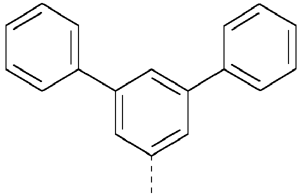 |
| Ar4a | Ar5a |
| 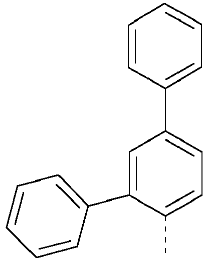 | 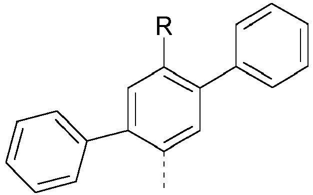 |
| Ar6a | Ar7a |
| 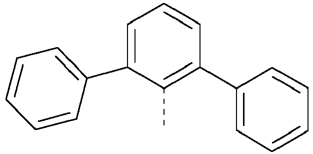 | 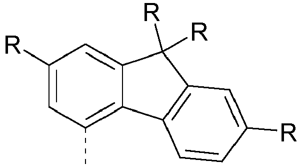 |
| Ar8a | Ar9a |
| 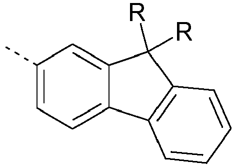 | 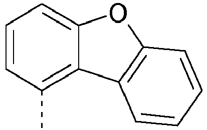 |
| Ar9b | Ar9c |
| 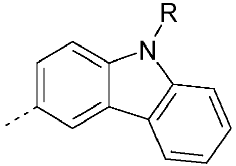 | 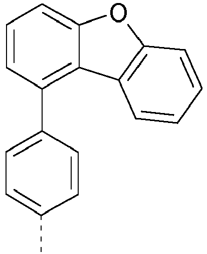 |
| Ar9d | Ar10a |
| 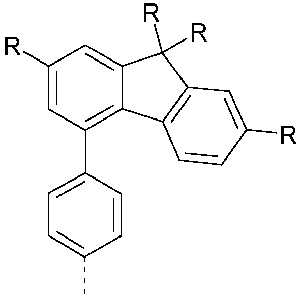 | 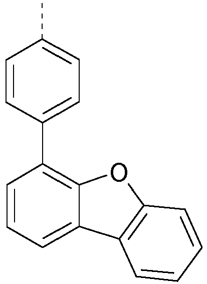 |
| Ar10b | Ar10c |

In den Wiederholungseinheiten der Formeln (Ia), (Ia1) und (Ia2) sind die mono- oder polycyclischen, aromatischen oder heteroaromatischen Ringsysteme Ar1 und Ar⁴ vorzugsweise ausgewählt aus den folgenden Einheiten Ar11 bis Ar18:

| | |
|---|---|
| 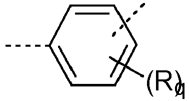 | 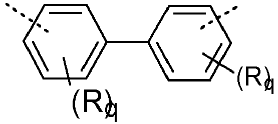 |
| Ar11 | Ar12 |
| 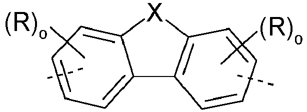 | 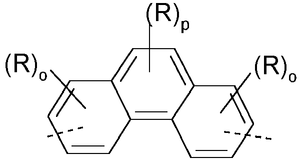 |
| Ar13 | Ar14 |
| 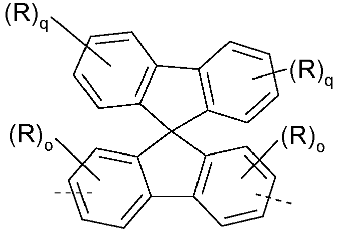 | 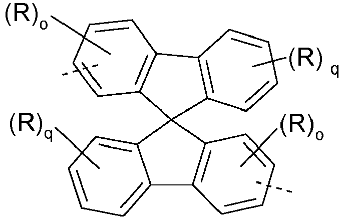 |
| Ar15 | Ar16 |
| 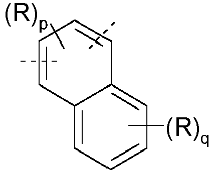 | 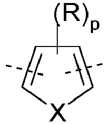 |
| Ar17 | Ar18 |

wobei R, o, q, p und X die oben in Bezug auf die Ringsysteme A angegebenen Bedeutungen annehmen können.

In den Wiederholungseinheiten der Formeln (Ia), (Ia1) und (Ia2) sind die mono- oder polycyclischen, aromatischen oder heteroaromatischen Ringsysteme Ar¹ und Ar⁴ besonders bevorzugt ausgewählt aus den folgenden Einheiten Ar11a bis Ar18d:

| | |
|---|---|
| 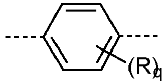 | 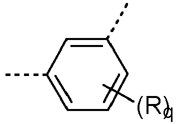 |
| Ar11a | Ar11b |
| 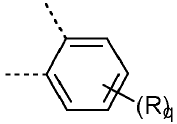 | 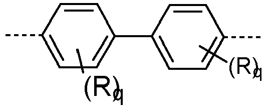 |
| Ar11c | Ar12a |
| 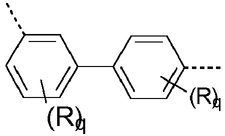 | 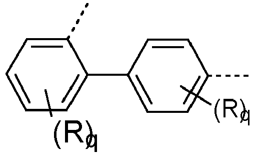 |
| Ar12b | Ar12c |
| 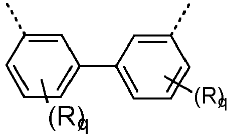 | 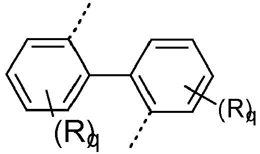 |
| Ar12d | Ar12e |
| 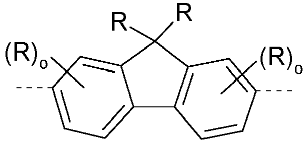 | 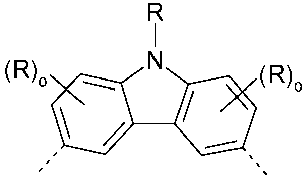 |
| A13a | A13b |
| 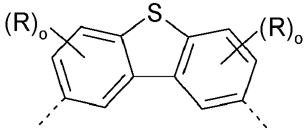 | 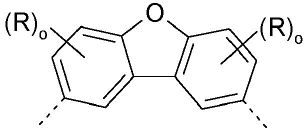 |
| Ar13c | Ar13d |
| 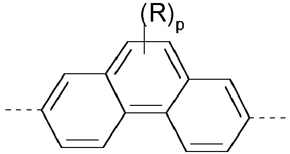 | 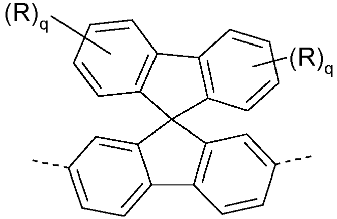 |
| Ar14a | Ar15a |
| 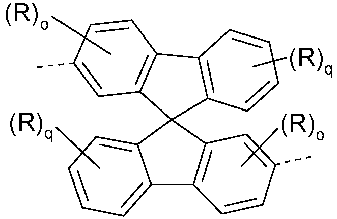 | 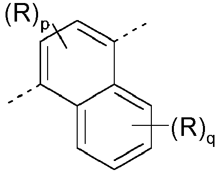 |
| Ar16a | Ar17a |
| 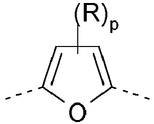 | 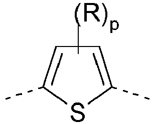 |
| Ar18a | Ar18b |
| 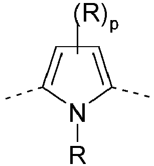 | 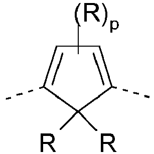 |
| Ar18c | Ar18d |

wobei R, o, q und p die oben in Bezug auf die Ringsysteme A angegebenen Bedeutungen annehmen können.

In den Wiederholungseinheiten der Formeln (Ia), (Ia1) und (Ia2) sind die mono- oder polycyclischen, aromatischen oder heteroaromatischen Ringsysteme Ar¹ und Ar⁴ ganz besonders bevorzugt ausgewählt aus den folgenden Einheiten Ar11aa bis Ar17aa:

| | |
|---|---|
| 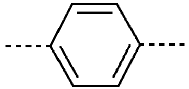 | 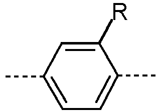 |
| Ar11aa | Ar11ab |
| 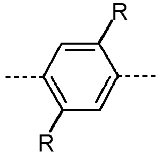 | 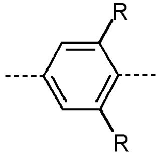 |
| Ar11ac | Ar11ad |
| 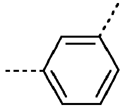 | 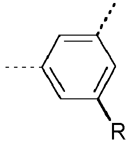 |
| Ar11ba | Ar11bb |
| 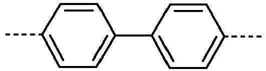 | 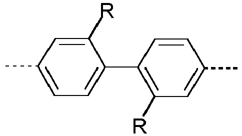 |
| Ar12aa | Ar12ab |
| 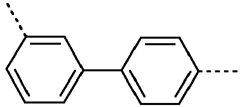 | 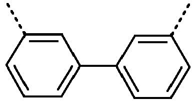 |
| Ar12ba | Ar12da |
| 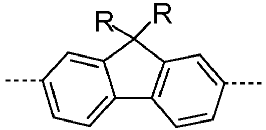 | 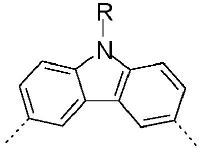 |
| Ar13aa | Ar13ba |
| 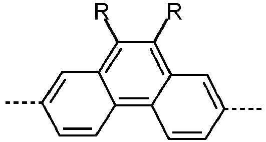 | 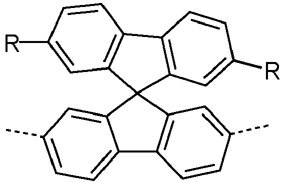 |
| Ar14aa | Ar15aa |
| 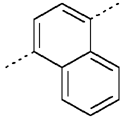 | |
| Ar17aa | |

wobei R die oben in Bezug auf die Ringsysteme A angegebenen Bedeutungen annehmen kann.

Bevorzugte Wiederholungseinheiten der Formel (Ia) sind die in der folgenden Tabelle dargestellten Wiederholungseinheiten, die sich aus den jeweiligen Bausteinen A, B, Ar¹, Ar², Ar³ und Ar⁴ zusammensetzen.

| Monomer | A | B | Ar1 | Ar2 | Ar3 | Ar4 |
|---|---|---|---|---|---|---|
| M33 | A1 | B1 | Ar11 | Ar1 | Ar1 | Ar11 |
| M34 | A1 | B1 | Ar11 | Ar2 | Ar2 | Ar11 |
| M35 | A1 | B1 | Ar11 | Ar3 | Ar3 | Ar11 |
| M36 | A1 | B1 | Ar11 | Ar4 | Ar4 | Ar11 |
| M37 | A1 | B1 | Ar11 | Ar5 | Ar5 | Ar11 |
| M38 | A1 | B1 | Ar11 | Ar6 | Ar6 | Ar11 |
| M39 | A1 | B1 | Ar11 | Ar7 | Ar7 | Ar11 |
| M40 | A1 | B1 | Ar11 | Ar8 | Ar8 | Ar11 |
| M41 | A1 | B1 | Ar11 | Ar9 | Ar9 | Ar11 |
| M42 | A1 | B1 | Ar11 | Ar10 | Ar10 | Ar11 |
| M43 | A1 | B1 | Ar12 | Ar1 | Ar1 | Ar12 |
| M44 | A1 | B1 | Ar12 | Ar2 | Ar2 | Ar12 |
| M45 | A1 | B1 | Ar12 | Ar3 | Ar3 | Ar12 |
| M46 | A1 | B1 | Ar12 | Ar4 | Ar4 | Ar12 |
| M47 | A1 | B1 | Ar12 | Ar5 | Ar5 | Ar12 |
| M48 | A1 | B1 | Ar12 | Ar6 | Ar6 | Ar12 |
| M49 | A1 | B1 | Ar12 | Ar7 | Ar7 | Ar12 |
| M50 | A1 | B1 | Ar12 | Ar8 | Ar8 | Ar12 |
| M51 | A1 | B1 | Ar12 | Ar9 | Ar9 | Ar12 |
| M52 | A1 | B1 | Ar12 | Ar10 | Ar10 | Ar12 |
| M53 | A1 | B1 | Ar13 | Ar1 | Ar1 | Ar13 |
| M54 | A1 | B1 | Ar13 | Ar2 | Ar2 | Ar13 |
| M55 | A1 | B1 | Ar13 | Ar3 | Ar3 | Ar13 |
| M56 | A1 | B1 | Ar13 | Ar4 | Ar4 | Ar13 |
| M57 | A1 | B1 | Ar13 | Ar5 | Ar5 | Ar13 |
| M58 | A1 | B1 | Ar13 | Ar6 | Ar6 | Ar13 |
| M59 | A1 | B1 | Ar13 | Ar7 | Ar7 | Ar13 |
| M60 | A1 | B1 | Ar13 | Ar8 | Ar8 | Ar13 |
| M61 | A1 | B1 | Ar13 | Ar9 | Ar9 | Ar13 |
| M62 | A1 | B1 | Ar13 | Ar10 | Ar10 | Ar13 |
| M63 | A1 | B1 | Ar14 | Ar1 | Ar1 | Ar14 |
| M64 | A1 | B1 | Ar14 | Ar2 | Ar2 | Ar14 |
| M65 | A1 | B1 | Ar14 | Ar3 | Ar3 | Ar14 |
| M66 | A1 | B1 | Ar14 | Ar4 | Ar4 | Ar14 |
| M67 | A1 | B1 | Ar14 | Ar5 | Ar5 | Ar14 |
| M68 | A1 | B1 | Ar14 | Ar6 | Ar6 | Ar14 |
| M69 | A1 | B1 | Ar14 | Ar7 | Ar7 | Ar14 |
| M70 | A1 | B1 | Ar14 | Ar8 | Ar8 | Ar14 |
| M71 | A1 | B1 | Ar14 | Ar9 | Ar9 | Ar14 |
| M72 | A1 | B1 | Ar14 | Ar10 | Ar10 | Ar14 |
| M73 | A1 | B1 | Ar15 | Ar1 | Ar1 | Ar15 |
| M74 | A1 | B1 | Ar15 | Ar2 | Ar2 | Ar15 |
| M75 | A1 | B1 | Ar15 | Ar3 | Ar3 | Ar15 |
| M76 | A1 | B1 | Ar15 | Ar4 | Ar4 | Ar15 |
| M77 | A1 | B1 | Ar15 | Ar5 | Ar5 | Ar15 |
| M78 | A1 | B1 | Ar15 | Ar6 | Ar6 | Ar15 |
| M79 | A1 | B1 | Ar15 | Ar7 | Ar7 | Ar15 |
| M80 | A1 | B1 | Ar15 | Ar8 | Ar8 | Ar15 |
| M81 | A1 | B1 | Ar15 | Ar9 | Ar9 | Ar15 |
| M82 | A1 | B1 | Ar15 | Ar10 | Ar10 | Ar15 |
| M83 | A1 | B1 | Ar16 | Ar1 | Ar1 | Ar16 |
| M84 | A1 | B1 | Ar16 | Ar2 | Ar2 | Ar16 |
| M85 | A1 | B1 | Ar16 | Ar3 | Ar3 | Ar16 |
| M86 | A1 | B1 | Ar16 | Ar4 | Ar4 | Ar16 |
| M87 | A1 | B1 | Ar16 | Ar5 | Ar5 | Ar16 |
| M88 | A1 | B1 | Ar16 | Ar6 | Ar6 | Ar16 |
| M89 | A1 | B1 | Ar16 | Ar7 | Ar7 | Ar16 |
| M90 | A1 | B1 | Ar16 | Ar8 | Ar8 | Ar16 |
| M91 | A1 | B1 | Ar16 | Ar9 | Ar9 | Ar16 |
| M92 | A1 | B1 | Ar16 | Ar10 | Ar10 | Ar16 |
| M93 | A1 | B1 | Ar17 | Ar1 | Ar1 | Ar17 |
| M94 | A1 | B1 | Ar17 | Ar2 | Ar2 | Ar17 |
| M95 | A1 | B1 | Ar17 | Ar3 | Ar3 | Ar17 |
| M96 | A1 | B1 | Ar17 | Ar4 | Ar4 | Ar17 |
| M97 | A1 | B1 | Ar17 | Ar5 | Ar5 | Ar17 |
| M98 | A1 | B1 | Ar17 | Ar6 | Ar6 | Ar17 |
| M99 | A1 | B1 | Ar17 | Ar7 | Ar7 | Ar17 |
| M100 | A1 | B1 | Ar17 | Ar8 | Ar8 | Ar17 |
| M101 | A1 | B1 | Ar17 | Ar9 | Ar9 | Ar17 |
| M102 | A1 | B1 | Ar17 | Ar10 | Ar10 | Ar17 |
| M103 | A1 | B1 | Ar18 | Ar1 | Ar1 | Ar18 |
| M104 | A1 | B1 | Ar18 | Ar2 | Ar2 | Ar18 |
| M105 | A1 | B1 | Ar18 | Ar3 | Ar3 | Ar18 |
| M106 | A1 | B1 | Ar18 | Ar4 | Ar4 | Ar18 |
| M107 | A1 | B1 | Ar18 | Ar5 | Ar5 | Ar18 |
| M108 | A1 | B1 | Ar18 | Ar6 | Ar6 | Ar18 |
| M109 | A1 | B1 | Ar18 | Ar7 | Ar7 | Ar18 |
| M110 | A1 | B1 | Ar18 | Ar8 | Ar8 | Ar18 |
| M111 | A1 | B1 | Ar18 | Ar9 | Ar9 | Ar18 |
| M112 | A1 | B1 | Ar18 | Ar10 | Ar10 | Ar18 |
| M113 | A1 | B2 | Ar11 | Ar1 | Ar1 | Ar11 |
| M114 | A1 | B3 | Ar12 | Ar3 | Ar3 | Ar12 |
| M115 | A1 | B4 | Ar11 | Ar9 | Ar9 | Ar11 |
| M116 | A2 | B1 | Ar11 | Ar3 | Ar3 | Ar11 |
| M117 | A3 | B1 | Ar12 | Ar7 | Ar7 | Ar12 |
| M118 | A4 | B1 | Ar11 | Ar3 | Ar3 | Ar11 |
| M119 | A5 | B1 | Ar11 | Ar3 | Ar3 | Ar11 |
| M120 | A6 | B1 | Ar11 | Ar3 | Ar3 | Ar11 |
| M121 | A7 | B1 | Ar11 | Ar3 | Ar3 | Ar11 |
| M122 | A8 | B1 | Ar11 | Ar3 | Ar3 | Ar11 |
| M123 | A1 | B1 | | Ar1 | Ar1 | |
| M124 | A1 | B1 | | Ar2 | Ar2 | |
| M125 | A1 | B1 | | Ar3 | Ar3 | |
| M126 | A1 | B1 | | Ar4 | Ar4 | |
| M127 | A1 | B1 | | Ar5 | Ar5 | |
| M128 | A1 | B1 | | Ar6 | Ar6 | |
| M129 | A1 | B1 | | Ar7 | Ar7 | |
| M130 | A1 | B1 | | Ar8 | Ar8 | |
| M131 | A1 | B1 | | Ar9 | Ar9 | |
| M132 | A1 | B1 | | Ar10 | Ar10 | |
| M133 | A1 | B1 | | Ar1 | Ar1 | |
| M134 | A1 | B1 | | Ar2 | Ar2 | |
| M135 | A1 | B1 | | Ar3 | Ar3 | |
| M136 | A1 | B1 | | Ar4 | Ar4 | |
| M137 | A1 | B1 | | Ar5 | Ar5 | |
| M138 | A1 | B1 | | Ar6 | Ar6 | |
| M139 | A1 | B1 | | Ar7 | Ar7 | |
| M140 | A1 | B1 | | Ar8 | Ar8 | |
| M141 | A1 | B1 | | Ar9 | Ar9 | |
| M142 | A1 | B1 | | Ar10 | Ar10 | |
| M143 | A1 | B1 | | Ar1 | Ar1 | |
| M144 | A1 | B1 | | Ar2 | Ar2 | |
| M145 | A1 | B1 | | Ar3 | Ar3 | |
| M146 | A1 | B1 | | Ar4 | Ar4 | |
| M147 | A1 | B1 | | Ar5 | Ar5 | |
| M148 | A1 | B1 | | Ar6 | Ar6 | |
| M149 | A1 | B1 | | Ar7 | Ar7 | |
| M150 | A1 | B1 | | Ar8 | Ar8 | |
| M151 | A1 | B1 | | Ar9 | Ar9 | |
| M152 | A1 | B1 | | Ar10 | Ar10 | |
| M153 | A1 | B1 | | Ar1 | Ar1 | |
| M154 | A1 | B1 | | Ar2 | Ar2 | |
| M155 | A1 | B1 | | Ar3 | Ar3 | |
| M156 | A1 | B1 | | Ar4 | Ar4 | |
| M157 | A1 | B1 | | Ar5 | Ar5 | |
| M158 | A1 | B1 | | Ar6 | Ar6 | |
| M159 | A1 | B1 | | Ar7 | Ar7 | |
| M160 | A1 | B1 | | Ar8 | Ar8 | |
| M161 | A1 | B1 | | Ar9 | Ar9 | |
| M162 | A1 | B1 | | Ar10 | Ar10 | |
| M163 | A1 | B1 | | Ar1 | Ar1 | |
| M164 | A1 | B1 | | Ar2 | Ar2 | |
| M165 | A1 | B1 | | Ar3 | Ar3 | |
| M166 | A1 | B1 | | Ar4 | Ar4 | |
| M167 | A1 | B1 | | Ar5 | Ar5 | |
| M168 | A1 | B1 | | Ar6 | Ar6 | |
| M169 | A1 | B1 | | Ar7 | Ar7 | |
| M170 | A1 | B1 | | Ar8 | Ar8 | |
| M171 | A1 | B1 | | Ar9 | Ar9 | |
| M172 | A1 | B1 | | Ar10 | Ar10 | |
| M173 | A1 | B1 | | Ar1 | Ar1 | |
| M174 | A1 | B1 | | Ar2 | Ar2 | |
| M175 | A1 | B1 | | Ar3 | Ar3 | |
| M176 | A1 | B1 | | Ar4 | Ar4 | |
| M177 | A1 | B1 | | Ar5 | Ar5 | |
| M178 | A1 | B1 | | Ar6 | Ar6 | |
| M179 | A1 | B1 | | Ar7 | Ar7 | |
| M180 | A1 | B1 | | Ar8 | Ar8 | |
| M181 | A1 | B1 | | Ar9 | Ar9 | |
| M182 | A1 | B1 | | Ar10 | Ar10 | |
| M183 | A1 | B1 | | Ar1 | Ar1 | |
| M184 | A1 | B1 | | Ar2 | Ar2 | |
| M185 | A1 | B1 | | Ar3 | Ar3 | |
| M186 | A1 | B1 | | Ar4 | Ar4 | |
| M187 | A1 | B1 | | Ar5 | Ar5 | |
| M188 | A1 | B1 | | Ar6 | Ar6 | |
| M189 | A1 | B1 | | Ar7 | Ar7 | |
| M190 | A1 | B1 | | Ar8 | Ar8 | |
| M191 | A1 | B1 | | Ar9 | Ar9 | |
| M192 | A1 | B1 | | Ar10 | Ar10 | |
| M193 | A1 | B1 | | Ar1 | Ar1 | |
| M194 | A1 | B1 | | Ar2 | Ar2 | |
| M195 | A1 | B1 | | Ar3 | Ar3 | |
| M196 | A1 | B1 | | Ar4 | Ar4 | |
| M197 | A1 | B1 | | Ar5 | Ar5 | |
| M198 | A1 | B1 | | Ar6 | Ar6 | |
| M199 | A1 | B1 | | Ar7 | Ar7 | |
| M200 | A1 | B1 | | Ar8 | Ar8 | |
| M201 | A1 | B1 | | Ar9 | Ar9 | |
| M202 | A1 | B1 | | Ar10 | Ar10 | |
| M203 | A1 | B2 | | Ar1 | Ar1 | |
| M204 | A1 | B3 | | Ar3 | Ar3 | |
| M205 | A1 | B4 | | Ar9 | Ar9 | |
| M206 | A2 | B1 | | Ar3 | Ar3 | |
| M207 | A3 | B1 | | Ar7 | Ar7 | |
| M208 | A4 | B1 | | Ar3 | Ar3 | |
| M209 | A5 | B1 | | Ar3 | Ar3 | |
| M210 | A6 | B1 | | Ar3 | Ar3 | |
| M211 | A7 | B1 | | Ar3 | Ar3 | |
| M212 | A8 | B1 | | Ar3 | Ar3 | |
| M393 | A1 | B1 | Ar11 | Ar1 | Ar2 | Ar11 |
| M394 | A1 | B1 | Ar11 | Ar3 | Ar9 | Ar11 |
| M395 | A1 | B1 | Ar11 | Ar3 | Ar4 | Ar11 |
| M396 | A1 | B1 | Ar11 | Ar2 | Ar3 | Ar11 |
| M397 | A1 | B1 | Ar11 | Ar5 | Ar8 | Ar11 |
| M398 | A1 | B1 | Ar12 | Ar3 | Ar6 | Ar12 |
| M399 | A1 | B1 | Ar12 | Ar3 | Ar7 | Ar12 |
| M400 | A1 | B1 | Ar12 | Ar3 | Ar3 | Ar11 |
| M401 | A1 | B1 | Ar11 | Ar3 | Ar3 | Ar13 |

Besonders bevorzugte Wiederholungseinheiten der Formel (la) sind die in der folgenden Tabelle dargestellten Wiederholungseinheiten, die sich aus den jeweiligen Bausteinen A, B, Ar¹, Ar², Ar³ und Ar⁴ zusammensetzen.

| Monomer | A | B | Ar1 | Ar2 | Ar3 | Ar4 |
|---|---|---|---|---|---|---|
| Mo45 | A1a | B1a | Ar11a | Ar1a | Ar1a | Ar11a |
| Mo46 | A1a | B1a | Ar11b | Ar1a | Ar1a | Ar11b |
| Mo47 | A1a | B1a | Ar11c | Ar1a | Ar1a | Ar11c |
| Mo48 | A1a | B1a | Ar11a | Ar1b | Ar1b | Ar11a |
| Mo49 | A1a | B1a | Ar12a | Ar1b | Ar1b | Ar12a |
| Mo50 | A1a | B1a | Ar12d | Ar2a | Ar2a | Ar12d |
| Mo51 | A1a | B1a | Ar11a | Ar3a | Ar3a | Ar11a |
| Mo52 | A1a | B1a | Ar12a | Ar3a | Ar3a | Ar12a |
| Mo53 | A1a | B1a | Ar13a | Ar3a | Ar3a | Ar13a |
| Mo54 | A1a | B1a | Ar15a | Ar3a | Ar3a | Ar15a |
| Mo55 | A1a | B1a | Ar11a | Ar3b | Ar3b | Ar11a |
| Mo56 | A1a | B1a | Ar11a | Ar3c | Ar3c | Ar11a |
| Mo57 | A1a | B1a | Ar12d | Ar3c | Ar3c | Ar12d |
| Mo58 | A1a | B1a | Ar12d | Ar4a | Ar4a | Ar12d |
| Mo59 | A1a | B1a | Ar16a | Ar5a | Ar5a | Ar16a |
| Mo60 | A1a | B1a | Ar11b | Ar6a | Ar6a | Ar11b |
| Mo61 | A1a | B1a | Ar11a | Ar7a | Ar7a | Ar11a |
| Mo62 | A1a | B1a | Ar13c | Ar8a | Ar8a | Ar13c |
| Mo63 | A1a | B1a | Ar11a | Ar9a | Ar9a | Ar11a |
| Mo64 | A1a | B1a | Ar17a | Ar9b | Ar9b | Ar17a |
| Mo65 | A1a | B1a | Ar13d | Ar9c | Ar9c | Ar13d |
| Mo66 | A1a | B1a | Ar12e | Ar9d | Ar9d | Ar12e |
| Mo67 | A1a | B1a | Ar11a | Ar10a | Ar10a | Ar11a |
| Mo68 | A1a | B1a | Ar18a | Ar10b | Ar10b | Ar18a |
| Mo69 | A1a | B1a | Ar18c | Ar10c | Ar10c | Ar18c |
| Mo70 | A1a | B1b | Ar11a | Ar3a | Ar3a | Ar11a |
| Mo71 | A1a | B1b | Ar11a | Ar9a | Ar9a | Ar11a |
| Mo72 | A1a | B1b | Ar12d | Ar9a | Ar9a | Ar12d |
| Mo73 | A1b | B2a | Ar13a | Ar5a | Ar5a | Ar13a |
| Mo74 | A1d | B1a | Ar12c | Ar8a | Ar8a | Ar12c |
| Mo75 | A2a | B1a | Ar11a | Ar3a | Ar3a | Ar11a |
| Mo76 | A3a | B1b | Ar12a | Ar9a | Ar9a | Ar12a |
| Mo77 | A3a | B1a | Ar11a | Ar9c | Ar9c | Ar11a |
| Mo78 | A3a | B1a | Ar12d | Ar3c | Ar3c | Ar12d |
| Mo79 | A4a | B1b | Ar18c | Ar7a | Ar7a | Ar18c |
| M₀8O | A5a | B4c | Ar13d | Ar9d | Ar9d | Ar13d |
| Mo81 | A6a | B4a | Ar18a | Ar8a | Ar8a | Ar18a |
| Mo82 | A1a | B1a | | Ar1a | Ar1a | |
| Mo83 | A1a | B1a | | Ar1a | Ar1a | |
| Mo84 | A1a | B1a | | Ar1a | Ar1a | |
| Mo85 | A1a | B1a | | Ar1b | Ar1b | |
| M086 | A1a | B1a | | Ar1b | Ar1b | |
| Mo87 | A1a | B1a | | Ar2a | Ar2a | |
| Mo88 | A1a | B1a | | Ar3a | Ar3a | |
| Mo89 | A1a | B1a | | Ar3a | Ar3a | |
| Mo90 | A1a | B1a | | Ar3a | Ar3a | |
| Mo91 | A1a | B1a | | Ar3a | Ar3a | |
| Mo92 | A1a | B1a | | Ar3b | Ar3b | |
| Mo93 | A1a | B1a | | Ar3c | Ar3c | |
| Mo94 | A1a | B1a | | Ar3c | Ar3c | |
| Mo95 | A1a | B1a | | Ar4a | Ar4a | |
| Mo96 | A1a | B1a | | Ar5a | Ar5a | |
| Mo97 | A1a | B1a | | Ar6a | Ar6a | |
| Mo98 | A1a | B1a | | Ar7a | Ar7a | |
| Mo99 | A1a | B1a | | Ar8a | Ar8a | |
| Mo100 | A1a | B1a | | Ar9a | Ar9a | |
| Mo101 | A1a | B1a | | Ar9b | Ar9b | |
| Mo102 | A1a | B1a | | Ar9c | Ar9c | |
| Mo103 | A1a | B1a | | Ar9d | Ar9d | |
| Mo104 | A1a | B1a | | Ar10a | Ar10a | |
| Mo105 | A1a | B1a | | Ar10b | Ar10b | |
| Mo106 | A1a | B1a | | Ar10c | Ar10c | |
| Mo107 | A1a | B1b | | Ar3a | Ar3a | |
| Mo108 | A1a | B1b | | Ar9a | Ar9a | |
| Mo109 | A1a | B1b | | Ar9a | Ar9a | |
| Mo110 | A1b | B2a | | Ar5a | Ar5a | |
| Mo111 | A1d | B1a | | Ar8a | Ar8a | |
| Mo112 | A2a | B1a | | Ar3a | Ar3a | |
| Mo113 | A3a | B1b | | Ar9a | Ar9a | |
| Mo114 | A3a | B1a | | Ar9c | Ar9c | |
| Mo115 | A3a | B1a | | Ar3c | Ar3c | |
| Mo116 | A4a | B1b | | Ar7a | Ar7a | |
| Mo117 | A5a | B4c | | Ar9d | Ar9d | |
| Mo118 | A6a | B4a | | Ar8a | Ar8a | |
| Mo193 | A1a | B1a | Ar11a | Ar3a | Ar3b | Ar11a |
| Mo194 | A1a | B1a | Ar11a | Ar3a | Ar9a | Ar11a |
| Mo195 | A1a | B1a | Ar12a | Ar2a | Ar2b | Ar12a |
| Mo196 | A1a | B1a | Ar11a | Ar3a | Ar3a | Ar11b |
| Mo197 | A1a | B1b | Ar12a | Ar3c | Ar3a | Ar12d |
| Mo198 | A1a | B1b | Ar11a | Ar9a | Ar9a | Ar12a |

Ganz besonders bevorzugte Wiederholungseinheiten der Formel (la) sind die in der folgenden Tabelle dargestellten Wiederholungseinheiten, die sich aus den jeweiligen Bausteinen A, B, Ar¹, Ar², Ar³ und Ar⁴ zusammensetzen.

| Monomer | A | B | Ar1 | Ar2 | Ar3 | Ar4 |
|---|---|---|---|---|---|---|
| Mon19 | A1aa | B1aa | Ar11aa | Ar3a | Ar3a | Ar11aa |
| Mon20 | A1aa | B1aa | Ar11aa | Ar3b | Ar3b | Ar11aa |
| Mon21 | A1aa | B1aa | Ar11aa | Ar3c | Ar3c | Ar11aa |
| Mon22 | A1aa | B1aa | Ar11aa | Ar9a | Ar9a | Ar11aa |
| Mon23 | A1aa | B1aa | Ar11aa | Ar2a | Ar2a | Ar11aa |
| Mon24 | A1aa | B1aa | Ar12aa | Ar3a | Ar3a | Ar12aa |
| Mon25 | A1aa | B1aa | Ar12ab | Ar3c | Ar3c | Ar12ab |
| Mon26 | A1aa | B1aa | Ar12da | Ar1a | Ar1a | Ar12da |
| Mon27 | A1aa | B1aa | Ar13aa | Ar2a | Ar2a | Ar13aa |
| Mon28 | A1aa | B1ab | Ar11aa | Ar3a | Ar3a | Ar11aa |
| Mon29 | A1aa | B1ab | Ar11aa | Ar3b | Ar3b | Ar11aa |
| Mon30 | A1aa | B1ab | Ar11aa | Ar3c | Ar3c | Ar11aa |
| Mon31 | A1aa | B1ab | Ar11aa | Ar9a | Ar9a | Ar11aa |
| Mon32 | A1aa | B1ab | Ar11aa | Ar2a | Ar2a | Ar11aa |
| Mon33 | A1aa | B1ab | Ar12aa | Ar9a | Ar9a | Ar12aa |
| Mon34 | A1aa | B1ac | Ar11aa | Ar3a | Ar3a | Ar11aa |
| Mon35 | A1aa | B1ac | Ar11aa | Ar3b | Ar3b | Ar11aa |
| Mon36 | A1aa | B1ac | Ar11aa | Ar3c | Ar3c | Ar11aa |
| Mon37 | A1aa | B1ac | Ar11aa | Ar9a | Ar9a | Ar11aa |
| Mon38 | A1aa | B1ac | Ar11aa | Ar2b | Ar2b | Ar11aa |
| Mon39 | A1aa | B1ad | Ar11aa | Ar3a | Ar3a | Ar11aa |
| Mon40 | A1aa | B1ae | Ar12aa | Ar8a | Ar8a | Ar12aa |
| Mon41 | A1aa | B1ba | Ar11aa | Ar3c | Ar3c | Ar11aa |
| Mon42 | A1ba | B1bb | Ar11bb | Ar10b | Ar10b | Ar11bb |
| Mon43 | A2aa | B4aa | Ar17aa | Ar5a | Ar5a | A17aa |
| Mon44 | A3aa | B1aa | A11aa | Ar3a | Ar3a | A11aa |
| Mon45 | A3aa | B1ab | A12aa | Ar9a | Ar9a | A12aa |
| Mon46 | A5aa | B4ca | A13ba | Ar10c | Ar10c | A13ba |
| Mon47 | A1aa | B1aa | | Ar3a | Ar3a | |
| Mon48 | A1aa | B1aa | | Ar3b | Ar3b | |
| Mon49 | A1aa | B1aa | | Ar3c | Ar3c | |
| Mon50 | A1aa | B1aa | | Ar9a | Ar9a | |
| Mon51 | A1aa | B1aa | | Ar2a | Ar2a | |
| Mon52 | A1aa | B1aa | | Ar3a | Ar3a | |
| Mon53 | A1aa | B1aa | | Ar3c | Ar3c | |
| Mon54 | A1aa | B1aa | | Ar1a | Ar1a | |
| Mon55 | A1aa | B1aa | | Ar2a | Ar2a | |
| Mon56 | A1aa | B1ab | | Ar3a | Ar3a | |
| Mon57 | A1aa | B1ab | | Ar3b | Ar3b | |
| Mon58 | A1aa | B1ab | | Ar3c | Ar3c | |
| Mon59 | A1aa | B1ab | | Ar9a | Ar9a | |
| Mon60 | A1aa | B1ab | | Ar2a | Ar2a | |
| Mon61 | A1aa | B1ab | | Ar9a | Ar9a | |
| Mon62 | A1aa | B1ac | | Ar3a | Ar3a | |
| Mon63 | A1aa | B1ac | | Ar3b | Ar3b | |
| Mon64 | A1aa | B1ac | | Ar3c | Ar3c | |
| Mon65 | A1aa | B1ac | | Ar9a | Ar9a | |
| Mon66 | A1aa | B1ac | | Ar2b | Ar2b | |
| Mon67 | A1aa | B1ad | | Ar3a | Ar3a | |
| Mon68 | A1aa | B1ae | | Ar8a | Ar8a | |
| Mon69 | A1aa | B1ba | | Ar3c | Ar3c | |
| Mon70 | A1ba | B1bb | | Ar10b | Ar10b | |
| Mon71 | A2aa | B4aa | | Ar5a | Ar5a | |
| Mon72 | A3aa | B1aa | | Ar3a | Ar3a | |
| Mon73 | A3aa | B1ab | | Ar9a | Ar9a | |
| Mon74 | A5aa | B4ca | | Ar10c | Ar10c | |
| Mon131 | A1aa | B1aa | Ar11aa | Ar3a | Ar3b | Ar11aa |
| Mon132 | A1aa | B1aa | Ar11aa | Ar9a | Ar9a | Ar12aa |

Der Anteil an Wiederholungseinheiten der Formel (Ia), (Ia1) oder (Ia2) im Polymer liegt im Bereich von 1 bis 100 mol%.

In einer ersten bevorzugten Ausführungsform enthält das erfindungsgemäße Polymer nur eine Wiederholungseinheit der Formel (Ia), (Ia1) oder (Ia2),, d.h. deren Anteil im Polymer beträgt 100 mol%. Es handelt sich in diesem Fall bei dem erfindungsgemäßen Polymer um ein Homopolymer.

In einer zweiten bevorzugten Ausführungsform liegt der Anteil an Wiederholungseinheiten der Formel (Ia), (Ia1) oder (Ia2) im Polymer im Bereich von 50 bis 95 mol%, besonders bevorzugt im Bereich von 60 bis 95 mol%, bezogen auf 100 mol% aller copolymerisierbaren Monomere, die im Polymer als Wiederholungseinheiten enthalten sind, d.h., dass das erfindungsgemäße Polymer neben einer oder mehrerer Wiederholungseinheiten der Formel (Ia), (Ia1) und/oder (Ia2), noch weitere, von den Wiederholungseinheiten der Formeln (Ia), (Ia1) und (Ia2) verschiedene Wiederholungseinheiten aufweist.

In einer dritten bevorzugten Ausführungsform liegt der Anteil an Wiederholungseinheiten der Formel (Ia), (Ia1) oder (Ia2) im Polymer im Bereich von 5 bis 50 mol%, besonders bevorzugt im Bereich von 25 bis 50 mol%, bezogen auf 100 mol% aller copolymerisierbaren Monomere, die im Polymer als Wiederholungseinheiten enthalten sind, d.h., dass das erfindungsgemäße Polymer neben einer oder mehrerer Wiederholungseinheiten der Formel (Ia), (Ia1) und/oder (Ia2) noch weitere, von den Wiederholungseinheiten der Formeln (Ia), (Ia1) und (Ia2) verschiedene Wiederholungseinheiten aufweist.

Diese, von den Wiederholungseinheiten der Formeln (Ia), (Ia1) und (Ia2) verschiedene Wiederholungseinheiten, sind unter anderem solche, wie sie in der WO 02/077060 A1, in der WO 2005/014689 A2 und in der WO 2013/156130 offenbart und umfangreich aufgelistet sind. Diese werden via Zitat als Bestandteil der vorliegenden Erfindung betrachtet. Die weiteren Wiederholungseinheiten können beispielsweise aus den folgenden Klassen stammen:
- Gruppe 1:: Einheiten, welche die Lochinjektions- und/oder Lochtransporteigenschaften der Polymere beeinflussen;
- Gruppe 2:: Einheiten, welche die Elektroneninjektions- und/oder Elektronentransporteigenschaften der Polymere beeinflussen;
- Gruppe 3:: Einheiten, die Kombinationen von Einzeleinheiten der Gruppe 1 und Gruppe 2 aufweisen;
- Gruppe 4:: Einheiten, welche die Emissionscharakteristik insoweit verändern, dass Elektrophosphoreszenz statt Elektrofluoreszenz erhalten werden kann;
- Gruppe 5:: Einheiten, welche den Übergang vom Singulett- zum Triplettzustand verbessern;
- Gruppe 6:: Einheiten, welche die Emissionsfarbe der resultierenden Polymere beeinflussen;
- Gruppe 7:: Einheiten, welche typischerweise als Polymergrundgerüst (Backbone) verwendet werden;
- Gruppe 8:: Einheiten welche die Delokalisierung der π-Elektronen im Polymer unterbrechen und damit die Konjugationlänge im Polymer verkürzen.

Bevorzugte erfindungsgemäße Polymere sind solche, bei denen mindestens eine Wiederholungseinheit Ladungstransporteigenschaften aufweist, d.h. die Einheiten aus der Gruppe 1 und/oder 2 enthalten.

Wiederholungseinheiten aus der Gruppe 1, die Lochinjektions- und/oder Lochtransporteigenschaften aufweisen, sind beispielsweise Triarylamin-, Benzidin-, Tetraaryl-para-phenylendiamin-, Triarylphosphin-, Phenothiazin-, Phenoxazin-, Dihydrophenazin-, Thianthren-, Dibenzo-para-dioxin-, Phenoxathiin-, Carbazol-, Azulen-, Thiophen-, Pyrrol- und Furanderivate und weitere O-, S- oder N-haltige Heterocyclen.

Wiederholungseinheiten aus der Gruppe 2, die Elektroneninjektions- und/oder Elektronentransporteigenschaften aufweisen, sind beispielsweise Pyridin-, Pyrimidin-, Pyridazin-, Pyrazin-, Oxadiazol-, Chinolin-, Chinoxalin-, Anthracen-, Benzanthracen-, Pyren-, Perylen-, Benzimidazol-, Triazin-, Keton-, Phosphinoxid- und Phenazinderivate, aber auch Triarylborane und weitere O-, S- oder N-haltige Heterocyclen.

Es kann bevorzugt sein, wenn in den erfindungsgemäßen Polymeren Einheiten aus der Gruppe 3 enthalten sind, in denen Strukturen, welche die Lochmobilität und welche die Elektronenmobilität erhöhen (also Einheiten aus Gruppe 1 und 2), direkt aneinander gebunden sind oder Strukturen enthalten sind, die sowohl die Lochmobilität als auch die Elektronenmobilität erhöhen. Einige dieser Einheiten können als Emitter dienen und verschieben die Emissionsfarbe ins Grüne, Gelbe oder Rote. Ihre Verwendung eignet sich also beispielsweise für die Erzeugung anderer Emissionsfarben aus ursprünglich blau emittierenden Polymeren.

Wiederholungseinheiten der Gruppe 4 sind solche, welche auch bei Raumtemperatur mit hoher Effizienz aus dem Triplettzustand Licht emittieren können, also Elektrophosphoreszenz statt Elektrofluoreszenz zeigen, was häufig eine Steigerung der Energieeffizienz bewirkt. Hierfür eignen sich zunächst Verbindungen, welche Schweratome mit einer Ordnungszahl von mehr als 36 enthalten. Bevorzugt sind Verbindungen, welche d- oder f-Übergangsmetalle enthalten, die die o. g. Bedingung erfüllen. Besonders bevorzugt sind hier entsprechende Wiederholungseinheiten, welche Elemente der Gruppen 8 bis 10 (Ru, Os, Rh, Ir, Pd, Pt) enthalten. Als Struktureinheiten für die erfindungsgemäßen Polymere kommen hier z.B. verschiedene Komplexe in Frage, wie sie z.B. in der WO 02/068435 A1, der WO 02/081488 A1, der EP 1239526 A2 und der WO 2004/026886 A2 beschrieben werden. Entsprechende Monomere werden in der WO 02/068435 A1 und in der WO 2005/042548 A1 beschrieben.

Wiederholungseinheiten der Gruppe 5 sind solche, welche den Übergang vom Singulett- zum Triplettzustand verbessern und welche, unterstützend zu den Wiederholungseinheiten der Gruppe 4 eingesetzt, die Phosphoreszenzeigenschaften dieser Wiederholungseinheiten verbessern. Hierfür kommen insbesondere Carbazol- und überbrückte Carbazoldimereinheiten in Frage, wie sie z.B. in der WO 2004/070772 A2 und der WO 2004/113468 A1 beschrieben werden. Weiterhin kommen hierfür Ketone, Phosphinoxide, Sulfoxide, Sulfone, Silan-Derivate und ähnliche Verbindungen in Frage, wie sie z.B. in der WO 2005/040302 A1 beschrieben werden.

Wiederholungseinheiten der Gruppe 6 sind neben den oben genannten solche, die mindestens noch eine weitere aromatische oder eine andere konjugierte Struktur aufweisen, welche nicht unter die o. g. Gruppen fallen, d. h. die die Ladungsträgermobilitäten nur wenig beeinflussen, die keine metall-organischen Komplexe sind oder die keinen Einfluss auf den Singulett-Triplett-Übergang haben. Derartige Wiederholungseinheiten können die Emissionsfarbe der resultierenden Polymere beeinflussen. Je nach Einheit können sie daher auch als Emitter eingesetzt werden. Bevorzugt sind dabei aromatische Strukturen mit 6 bis 40 C-Atomen oder auch Tolan-, Stilben- oder Bisstyrylarylenderivate, die jeweils mit einem oder mehreren Resten R substituiert sein können. Besonders bevorzugt ist dabei der Einbau von 1,4- oder 9,10-Anthrylen-, 1,6-, 2,7- oder 4,9-Pyrenylen-, 3,9- oder 3,10-Perylenylen-, 4,4'-Tolanylen-, 4,4'-Stilbenylen-, Benzothiadiazol- und ent-sprechenden Sauerstoffderivaten, Chinoxalin-, Phenothiazin-, Phenoxazin-, Dihydrophenazin-, Bis(thiophenyl)arylen-, Oligo(thiophenylen)-, Phenazin-, Rubren-, Pentacen- oder Perylenderivaten, die vorzugsweise substituiert sind, oder vorzugsweise konjugierte Push-Pull-Systeme (Systeme, die mit Donor- und Akzeptorsubstituenten substituiert sind) oder Systeme wie Squarine oder Chinacridone, die vorzugsweise substituiert sind.

Wiederholungseinheiten der Gruppe 7 sind Einheiten, die aromatische Strukturen mit 6 bis 40 C-Atomen beinhalten, welche typischerweise als Polymergrundgerüst (Backbone) verwendet werden. Dies sind beispielsweise 4,5-Dihydropyrenderivate, 4,5,9,10-Tetrahydropyrenderivate, Fluorenderivate, 9,9'-Spirobifluorenderivate, Phenanthrenderivate, 9,10-Dihydrophen-anthrenderivate, 5,7-Dihydrodibenzooxepinderivate und cis- und trans-Indenofluorenderivate aber auch 1,2-, 1,3- oder 1,4-Phenylen-, 1,2-, 1,3- oder 1,4-Naphthylen-, 2,2'-, 3,3'- oder 4,4'-Biphenylylen-, 2,2"-, 3,3"- oder 4,4"-Terphenylylen, 2,2'-, 3,3'- oder 4,4'-Bi-1,1'-naphthylylen- oder 2,2"'-, 3,3‴- oder 4,4‴-Quarterphenylylen-derivate.

Wiederholungseinheiten der Gruppe 8 sind solche, die konjugationsunterbrechende Eigenschaften besitzen, z.B. durch meta-Verknüpfung, sterische Hinderung oder Verwendung gesättigter Kohlenstoff- oder Siliziumatome. Solche Verbindung werden z.B. in der WO2006/063852, der WO 2012/048778 und der WO 2013/093490 offenbart. Die konjugationsunterbrechenden Eigenschaften der Wiederholungseinheiten der Gruppe 8 zeigen sich unter anderem durch eine Blauverschiebung der Absorptionskante des Polymers.

Bevorzugt sind erfindungsgemäße Polymere, die gleichzeitig neben Wiederholungseinheiten der Formel (Ia), (Ia1) und (Ia2) zusätzlich noch ein oder mehrere Einheiten ausgewählt aus den Gruppen 1 bis 8 enthalten. Es kann ebenfalls bevorzugt sein, wenn gleichzeitig mehr als eine weitere Wiederholungseinheit aus einer Gruppe vorliegt.

Bevorzugt sind dabei erfindungsgemäße Polymere, die neben mindestens einer Wiederholungseinheit der Formel (Ia), (Ia1) und (Ia2) noch Einheiten aus der Gruppe 7 enthalten.

Ebenfalls bevorzugt ist es, wenn die erfindungsgemäßen Polymere Einheiten enthalten, die den Ladungstransport oder die Ladungsinjektion verbessern, also Einheiten aus der Gruppe 1 und/oder 2.

Besonders bevorzugt ist es weiterhin, wenn die erfindungsgemäßen Polymere Wiederholungseinheiten aus der Gruppe 7 und Einheiten aus der Gruppe 1 und/oder 2 enthalten.

Enthält das erfindungsgemäße Polymer eine oder mehrere Einheiten ausgewählt aus den Gruppen 1 bis 8, so kann eine oder mehrere dieser Einheiten, vorzugsweise eine Einheit aus der Gruppe 1, eine oder mehrere, vorzugsweise eine, vernetzbare Gruppe aufweisen.

Die erfindungsgemäßen Polymere sind entweder Homopolymere aus Wiederholungseinheiten der Formel (Ia), (Ia1) und (Ia2) oder Copolymere. Die erfindungsgemäßen Polymere können linear oder verzweigt sein, vorzugsweise linear. Erfindungsgemäße Copolymere können dabei neben einer oder mehreren Wiederholungseinheiten der Formel (Ia), (Ia1) und (Ia2) potentiell eine oder mehrere weitere Strukturen aus den oben aufgeführten Gruppen 1 bis 8 besitzen.

Die erfindungsgemäßen Copolymere können statistische, alternierende oder blockartige Strukturen aufweisen oder auch mehrere dieser Strukturen abwechselnd besitzen. Besonders bevorzugt weisen die erfindungsgemäßen Copolymere statistische oder alternierende Strukturen auf. Besonders bevorzugt sind die Copolymere statistische oder alternierende Copolymere. Wie Copolymere mit blockartigen Strukturen erhalten werden können und welche weiteren Wiederholungseinheiten dafür besonders bevorzugt sind, ist beispielsweise ausführlich in der WO 2005/014688 A2 beschrieben. Ebenso sei an dieser Stelle nochmals hervorgehoben, dass das Polymer auch dendritische Strukturen haben kann.

In einer weiteren Ausführungsform der vorliegenden Erfindung enthalten die erfindungsgemäßen Polymere neben einer oder mehrerer Wiederholungseinheiten der Formel (Ia), (Ia1) und/oder (Ia2) sowie gegebenenfalls weiteren Wiederholungseinheiten ausgewählt aus den oben genannten Gruppen 1 bis 8 noch mindestens eine, vorzugsweise eine Wiederholungseinheit, die eine vernetzbare Gruppe Q aufweist.

"Vernetzbare Gruppe Q" im Sinne der vorliegenden Erfindung bedeutet eine funktionelle Gruppe, die in der Lage ist, eine Reaktion einzugehen und so eine unlösliche Verbindung zu bilden. Die Reaktion kann dabei mit einer weiteren, gleichen Gruppe Q, einer weiteren, verschiedenen Gruppe Q oder einem beliebigen anderen Teil derselben oder einer anderen Polymerkette erfolgen. Bei der vernetzbaren Gruppe handelt es sich somit um eine reaktive Gruppe. Dabei erhält man als Ergebnis der Reaktion der vernetzbaren Gruppe eine entsprechend vernetzte Verbindung. Die chemische Reaktion kann auch in der Schicht durchgeführt werden, wobei eine unlösliche Schicht entsteht. Die Vernetzung kann gewöhnlich durch Wärme oder durch UV-, Mikrowellen-, Röntgen- oder Elektronenstrahlung unterstützt werden, gegebenenfalls in Gegenwart eines Initiators. "Unlöslich" im Sinne der vorliegenden Erfindung bedeutet vorzugsweise, dass das erfindungsgemäße Polymer nach der Vernetzungsreaktion, also nach der Reaktion der vernetzbaren Gruppen, bei Raumtemperatur in einem organischen Lösungsmittel eine Löslichkeit aufweist, die mindestens einen Faktor 3, vorzugsweise mindestens einen Faktor 10, geringer ist als die des entsprechenden, nicht-vernetzten, erfindungsgemäßen Polymers in demselben organischen Lösungsmittel.

Die Wiederholungseinheit, die die vernetzbare Gruppe Q trägt, kann dabei in einer ersten Ausführungsform ausgewählt werden aus den Wiederholungseinheiten der Formeln (Ia), (Ia1) und (Ia2).

In einer ersten bevorzugten Ausführungsform sind die Wiederholungseinheiten, die die vernetzbare Gruppe Q tragen, die folgenden, aus der Wiederholungseinheit der Formel (la) abgeleiteten Wiederholungseinheiten der Formeln (IIIa) bis (IIIf): 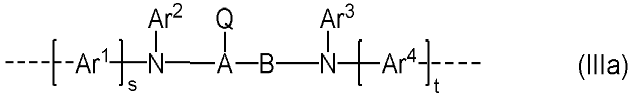 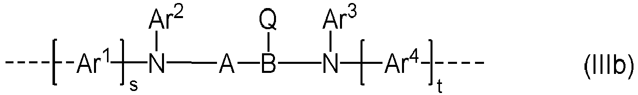 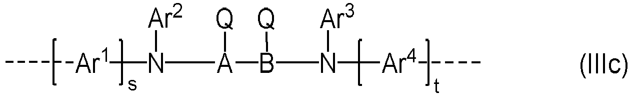 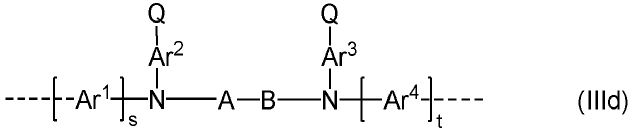 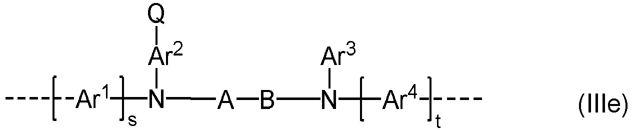 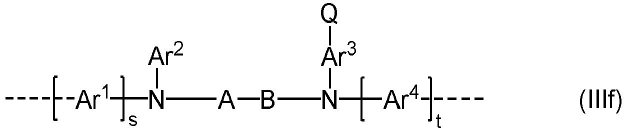 wobei A, B, Ar¹, Ar², Ar³, Ar⁴, Q, s und t die oben in Bezug auf Formel (la) angegebenen Bedeutungen annehmen können.

In einer ersten besonders bevorzugten Ausführungsform sind die Wiederholungseinheiten, die die vernetzbare Gruppe Q tragen, die folgenden, aus der Wiederholungseinheit der Formel (Ia1) abgeleiteten Wiederholungseinheiten der Formeln (IIIa) bis (IIIf): 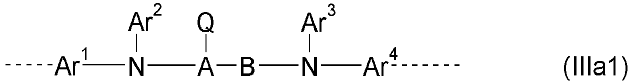 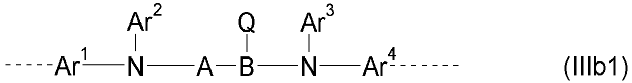 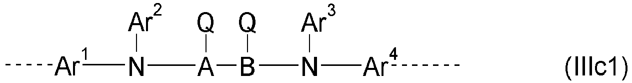 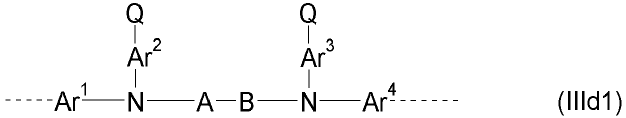 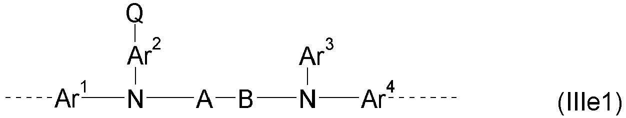 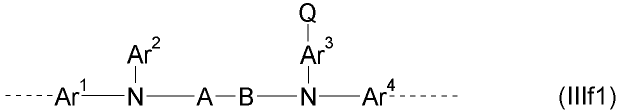 wobei A, B, Ar¹, Ar², Ar³, Ar⁴ und Q die oben in Bezug auf Formel (la) angegebenen Bedeutungen annehmen können.

In einer zweiten besonders bevorzugten Ausführungsform sind die Wiederholungseinheiten, die die vernetzbare Gruppe Q tragen, die folgenden, aus der Wiederholungseinheit der Formel (Ia1) abgeleiteten Wiederholungseinheiten der Formeln (IVa) bis (IVf): 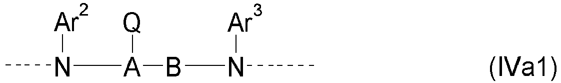 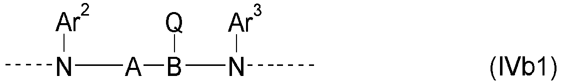 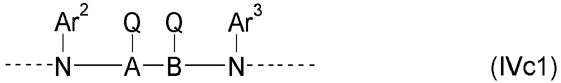 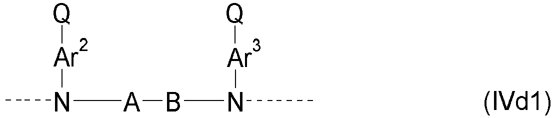 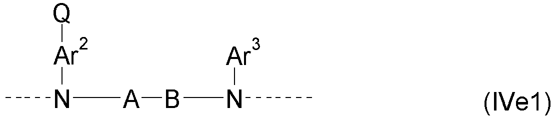 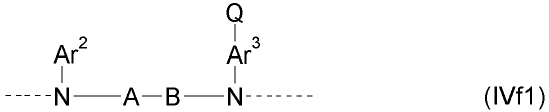 wobei A, B, Ar¹, Ar², Ar³, Ar⁴ und Q die oben in Bezug auf Formel (la) angegebenen Bedeutungen annehmen können.

Erfindungsgemäß vernetzbare Gruppen Q sind die im Folgenden aufgeführten Gruppen:
a) Endständige oder cyclische Alkenyl- bzw. endständige Dienyl- und Alkinylgruppen:
   Geeignet sind Einheiten, die eine endständige oder cyclische Doppelbindung, eine endständige Dienylgruppe oder eine endständige Dreifachbindung enthalten, insbesondere endständige oder cyclische Alkenyl-, endständige Dienyl- bzw. endständige Alkinylgruppen mit 2 bis 40 C-Atomen, vorzugsweise mit 2 bis 10 C-Atomen, wobei auch einzelne CH₂-Gruppen und/oder einzelne H-Atome durch die oben genannten Gruppen R ersetzt sein können. Weiterhin eignen sich auch Gruppen, die als Vorstufen zu betrachten sind und die in situ zu einer Bildung einer Doppel- oder Dreifachbindung in der Lage sind.
b) Alkenyloxy-, Dienyloxy- bzw. Alkinyloxygruppen:
   Weiterhin geeignet sind Alkenyloxy-, Dienyloxy- bzw. Alkinyloxygruppen, vorzugsweise Alkenyloxygruppen.
c) Acrylsäuregruppen:
   Weiterhin geeignet sind Acrylsäureeinheiten im weitesten Sinne, vorzugsweise Acrylester, Acrylamide, Methacrylester und
   Methacrylamide. Besonders bevorzugt sind C₁₋₁₀-Alkylacrylat und C₁₋₁₀-Alkylmethacrylat.
   Die Vernetzungsreaktion der oben unter a) bis c) genannten Gruppen kann über einen radikalischen, einen kationischen oder einen anionischen Mechanismus aber auch über Cycloaddition erfolgen.
   Es kann sinnvoll sein, einen entsprechenden Initiator für die Vernetzungsreaktion zuzugeben. Geeignete Initiatoren für die radikalische Vernetzung sind beispielsweise Dibenzoylperoxid, AIBN oder TEMPO. Geeignete Initiatoren für die kationische Vernetzung sind beispielsweise AlCl₃, BF₃, Triphenylmethylperchlorat oder Tropyliumhexachlorantimonat. Geeignete Initiatoren für die anionische Vernetzung sind Basen, insbesondere Butyllithium.
   In einer bevorzugten Ausführungsform der vorliegenden Erfindung wird die Vernetzung jedoch ohne den Zusatz eines Initiators durchgeführt und ausschließlich thermisch initiiert. Diese Bevorzugung wird dadurch begründet, dass die Abwesenheit des Initiators Verunreinigungen der Schicht verhindert, die zu einer Verschlechterung der Deviceeigenschaften führen könnten.
d) Oxetane und Oxirane:
   Eine weitere geeignete Klasse vernetzbarer Gruppen Q sind Oxetane und Oxirane, die durch Ringöffnung kationisch vernetzen.
   Es kann sinnvoll sein, einen entsprechenden Initiator für die Vernetzungs-reaktion zuzugeben. Geeignete Initiatoren sind beispielsweise AlCl₃, BF₃, Triphenylmethylperchlorat oder Tropyliumhexachlorantimonat. Ebenso können Photosäuren als Initiatoren zugegeben werden.
e) Silane:
   Weiterhin geeignet als Klasse vernetzbarer Gruppen sind Silangruppen SiR₃, wobei mindestens zwei Gruppen R, bevorzugt alle drei Gruppen R für Cl oder eine Alkoxygruppe mit 1 bis 20 C-Atomen stehen.
   Diese Gruppe reagiert in der Anwesenheit von Wasser zu einem Oligo- oder Polysiloxan.
f) Cyclobutangruppen

Die oben unter a) bis f) genannten vernetzbaren Gruppen Q sind dem Fachmann generell bekannt, ebenso wie die geeigneten Reaktionsbedingungen, die zur Reaktion dieser Gruppen verwendet werden.

Bevorzugte vernetzbare Gruppen Q umfassen Alkenylgruppen der folgenden Formel Q1, Dienylgruppen der folgenden Formel Q2, Alkinylgruppen der folgenden Formel Q3, Alkenyloxygruppen der folgenden Formel Q4, Dienyloxygruppen der folgenden Formeln Q5, Alkinyloxygruppen der folgenden Formel Q6, Acrylsäuregruppen der folgenden Formeln Q7 und Q8, Oxetangruppen der folgenden Formeln Q9 und Q10, Oxirangruppen der folgenden Formel Q 11, Cyclobutangruppen der folgenden Formeln Q12, Q13 und Q14:

| | |
|---|---|
| 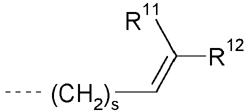 | 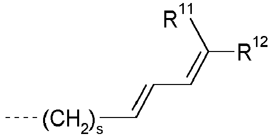 |
| Q1 | Q2 |
| 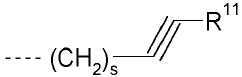 | 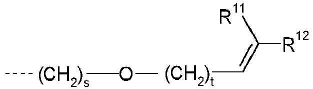 |
| Q3 | Q4 |
| 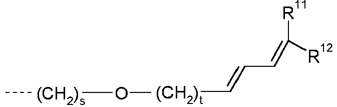 | 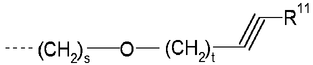 |
| Q5 | Q6 |
| 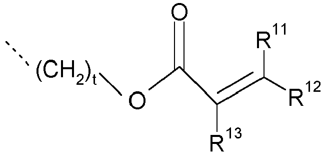 | 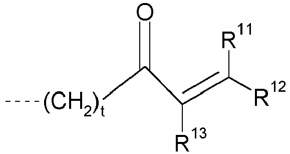 |
| Q7 | Q8 |
| 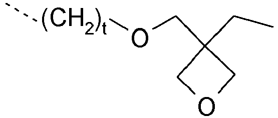 | 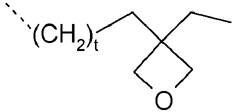 |
| Q9 | Q10 |
| 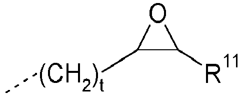 Q9 | 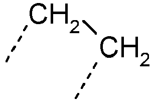 |
| Q11 | Q12 |
| 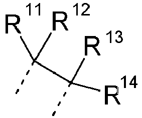 | 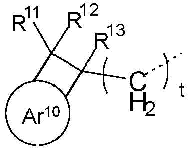 |
| Q13 | Q14 |

Die Reste R¹¹, R¹², R¹³ und R¹⁴ in den Formeln Q1 bis Q8, Q11, Q13 und Q14 sind bei jedem Auftreten, gleich oder verschieden, H, eine geradkettige oder verzweigte Alkylgruppe mit 1 bis 6 C-Atomen, vorzugsweise 1 bis 4 C-Atomen. Besonders bevorzugt sind die R¹¹, R¹², R¹³ und R¹⁴ H, Methyl, Ethyl, n-Propyl, iso-Propyl, n-Butyl, sec-Butyl oder tert-Butyl und ganz besonders bevorzugt H oder Methyl. Die verwendeten Indices haben die folgende Bedeutung: s = 0 bis 8; und t = 1 bis 8. Ar¹⁰ in der Formel Q14 kann die gleichen Bedeutungen annehmen kann wie Ar¹ in Formel (I).

Die gestrichelte Bindung in den Formeln Q1 bis Q11 und Q14 sowie die gestrichelten Bindungen in den Formeln Q12 und Q13 stellen die Anknüpfung der vernetzbaren Gruppe an die Struktureinheiten dar.

Die vernetzbaren Gruppen der Formeln Q1 bis Q14 können dabei direkt mit der Struktureinheit verknüpft sein, oder aber indirekt, über ein weiteres, mono- oder polycyclisches, aromatisches oder heteroaromatisches Ringsystem Ar¹⁰, wie in den folgenden Formeln Q15 bis Q28 dargestellt:

| | |
|---|---|
| 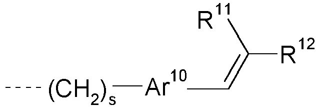 | 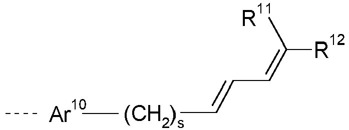 |
| Q15 | Q16 |
| 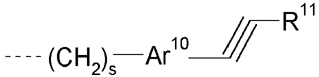 | 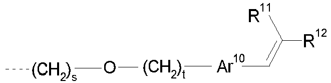 |
| Q17 | Q18 |
| 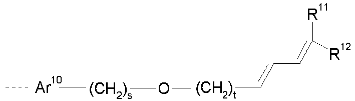 | 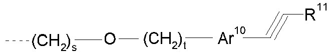 |
| Q19 | Q20 |
| 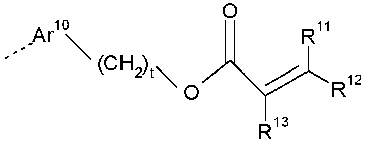 | 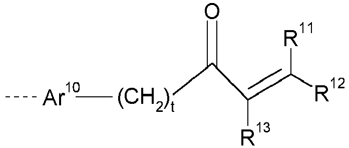 |
| Q21 | Q22 |
| 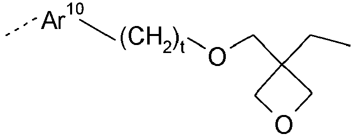 | 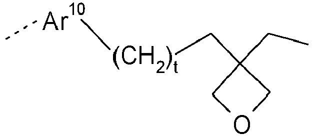 |
| Q23 | Q24 |
| 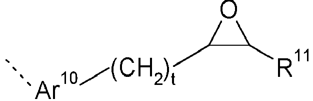 | 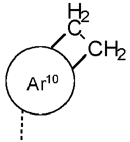 |
| Q25 | Q26 |
| 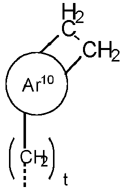 | 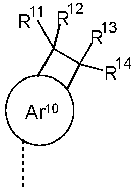 |
| Q27 | Q28 |

wobei Ar10 in den Formeln Q15 bis Q28 die gleichen Bedeutungen annehmen kann wie Ar¹ in Formel (I).

Besonders bevorzugte vernetzbare Gruppen Q sind die folgenden:

| | |
|---|---|
| 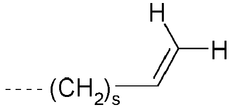 | 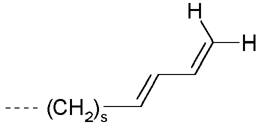 |
| Q1a | Q2a |
| 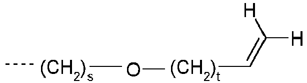 | 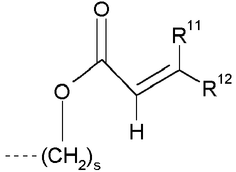 |
| Q4a | Q7a |
| 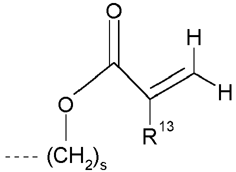 | 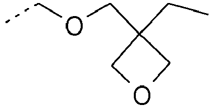 |
| Q7b | Q9a |
| 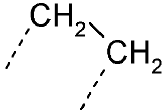 | 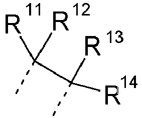 |
| Q12 | Q13 |
| 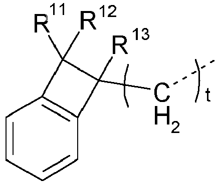 | 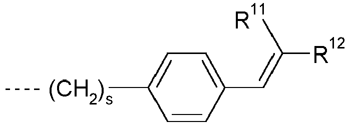 |
| Q14a | Q15a |
| 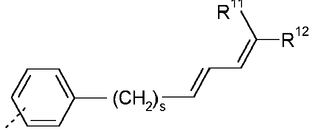 | 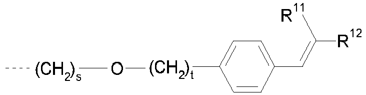 |
| Q16a | Q18a |
| 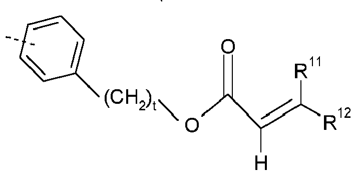 | 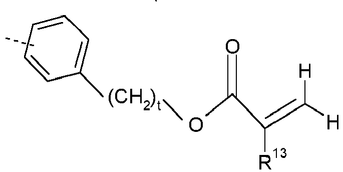 |
| Q21a | Q21b |
| 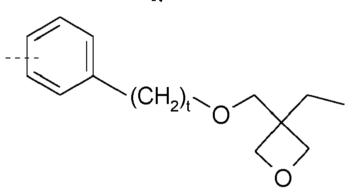 | 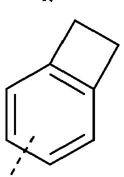 |
| Q23a | Q26a |
| 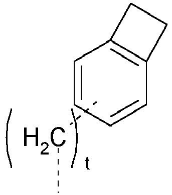 | 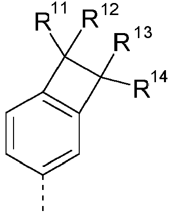 |
| Q27a | Q28a |

Die Reste R¹¹, R¹² ,R¹³ und R¹⁴ sind bei jedem Auftreten, gleich oder verschieden, H oder eine geradkettige oder verzweigte Alkylgruppe mit 1 bis 6 C-Atomen, vorzugsweise 1 bis 4 C-Atomen. Besonders bevorzugt sind die Reste R¹¹, R¹² ,R¹³ und R¹⁴ Methyl, Ethyl, n-Propyl, iso-Propyl, n-Butyl, sec-Butyl oder tert-Butyl und ganz besonders bevorzugt Methyl.

Die verwendeten Indices haben die folgende Bedeutung: s = 0 bis 8 und t = 1 bis 8.

Ganz besonders bevorzugte vernetzbare Gruppen Q sind die folgenden:

| | |
|---|---|
| 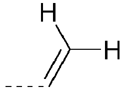 | 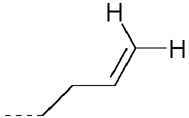 |
| Q1b | Q1c |
| 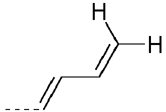 | 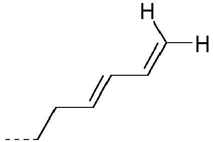 |
| Q2b | Q2c |
| 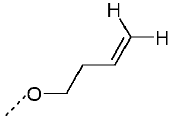 | 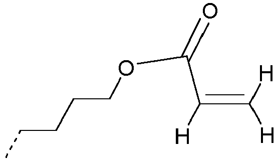 |
| Q4b | Q7c |
| 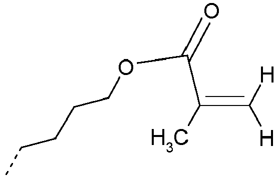 | 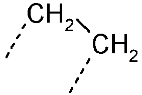 |
| Q7d | Q12b |
| 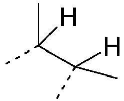 | 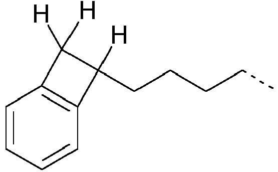 |
| Q13a | Q14b |
| 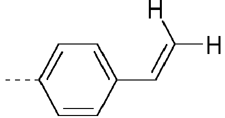 | 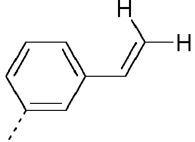 |
| Q15b | Q15c |
| 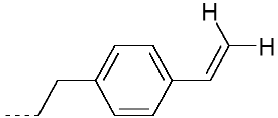 | 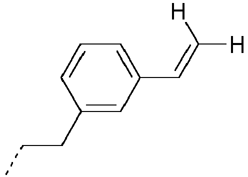 |
| Q15d | Q15e |
| 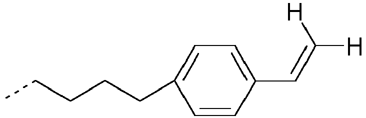 | 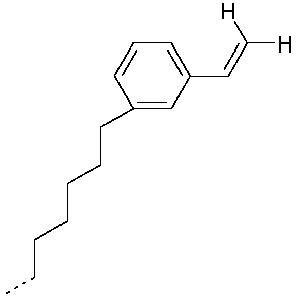 |
| Q15f | Q15g |
| 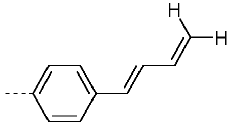 | 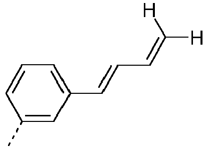 |
| Q16b | Q16c |
| 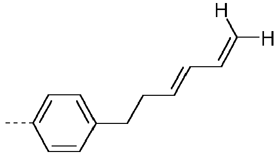 | 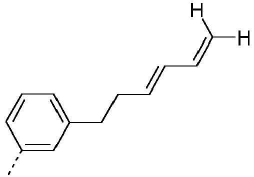 |
| Q16d | Q16e |
| 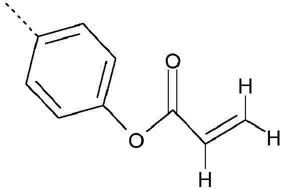 | 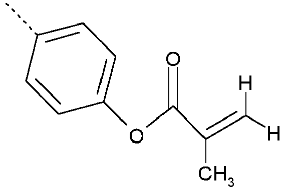 |
| Q21c | Q21d |
| 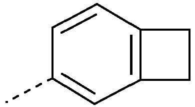 | 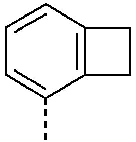 |
| Q26b | Q26c |
| 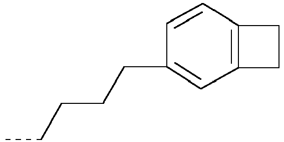 | 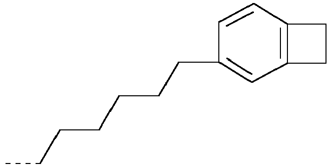 |
| Q27b | Q27c |

In den Wiederholungseinheiten der Formeln (IIIa) und (IIIc), in denen das polycyclische, aromatische oder heteroaromatische Ringsystem A mindestens eine vernetzbare Gruppe Q aufweist, ist A vorzugsweise ausgewählt aus den folgenden Einheiten A11a bis A16b:

| | |
|---|---|
| 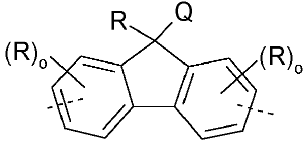 | 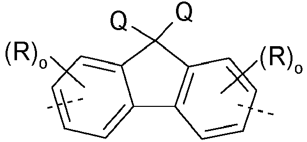 |
| A11a | A11b |
| 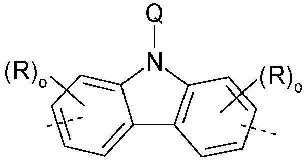 | 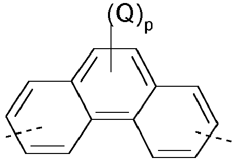 |
| A11c | A12 |
| 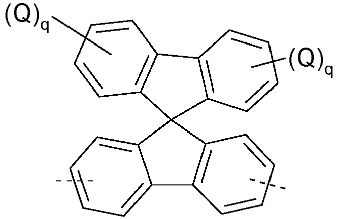 | 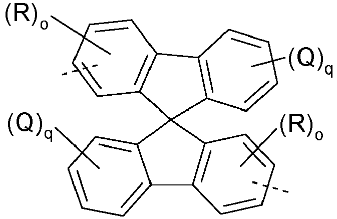 |
| A13 | A14 |
| 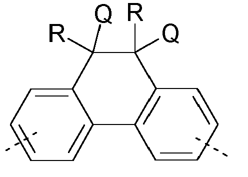 | 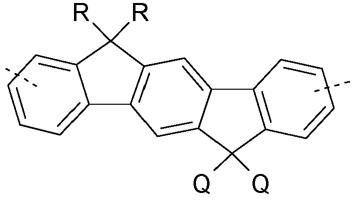 |
| A15 | A16a |
| 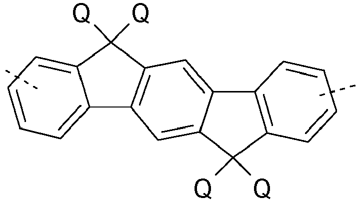 | |
| A16b | |

wobei R die oben angegebenen Bedeutungen annehmen kann, Q eine vernetzbare Gruppe ist,
o = 0, 1, 2 oder 3 ist,
p = 0, 1 oder 2 ist und
q = 0, 1, 2, 3 oder 4 ist.

In den Wiederholungseinheiten der Formeln (IIIa) und (IIIc), in denen das polycyclische, aromatische oder heteroaromatische Ringsystem A mindestens eine vernetzbare Gruppe Q aufweist, ist A besonders bevorzugt ausgewählt aus den folgenden Einheiten A11 a1 bis A13a1:

| | |
|---|---|
| 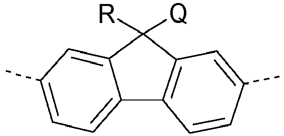 | 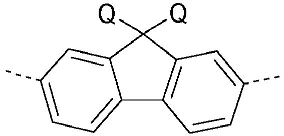 |
| A11a1 | A11b1 |
| 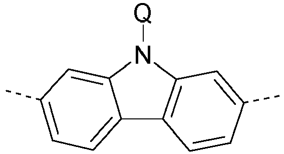 | 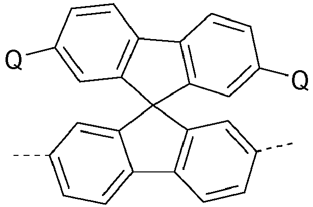 |
| A11c1 | A13a1 |

wobei R die oben angegebenen Bedeutungen annehmen kann und Q eine vernetzbare Gruppe ist.

In den Wiederholungseinheiten der Formeln (IIIb) und (IIIc), in denen das mono- oder polycyclische, aromatische oder hetero-aromatische Ringsystem B mindestens eine vernetzbare Gruppe Q aufweist, ist B vorzugsweise ausgewählt aus den folgenden Einheiten B11a bis B14f:

| | |
|---|---|
| 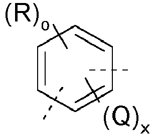 | 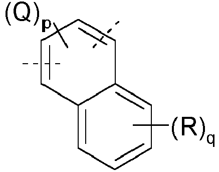 |
| B11a | B12a |
| 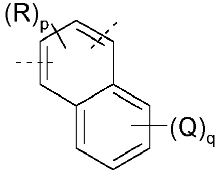 | 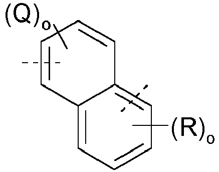 |
| B12b | B13a |
| 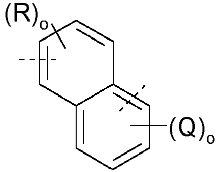 | 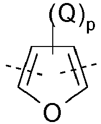 |
| B13b | B14a |
| 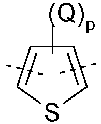 | 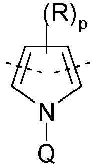 |
| B14b | B14c |
| 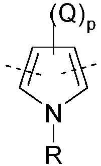 | 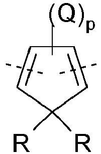 |
| B14d | B14e |
| 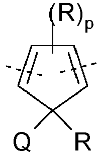 | |
| B14f | |

wobei R die oben angegebenen Bedeutungen annehmen kann, Q eine vernetzbare Gruppe ist,
o = 0, 1,2 oder 3 ist,
p = 0, 1 oder 2 ist,
q = 0, 1, 2, 3 oder 4 ist, und
x = 1, 2, 3 oder 4 ist, wobei gilt x + o ≤ 4.

In den Wiederholungseinheiten der Formeln (IIIb) und (IIIc), in denen das mono- oder polycyclische, aromatische oder hetero-aromatische Ringsystem B mindestens eine vernetzbare Gruppe Q aufweist, ist B besonders bevorzugt ausgewählt aus den folgenden Einheiten B11a1 bis B14c1 :

| | |
|---|---|
| 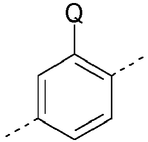 | 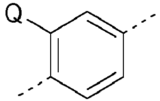 |
| B11a1 | B11a2 |
| 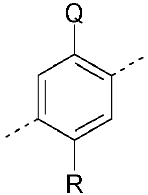 | 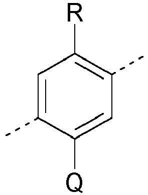 |
| B11a3 | B11a4 |
| 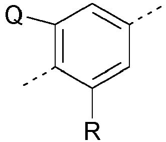 | 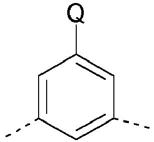 |
| B11a5 | B11a6 |
| 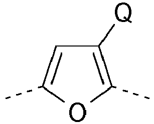 | 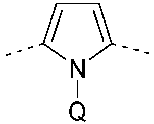 |
| B14a1 | B14c1 |

wobei R die oben angegebenen Bedeutungen annehmen kann und Q eine vernetzbare Gruppe ist.

In den Wiederholungseinheiten der Formeln (IIId), (IIIe) und (IIIf), in denen die mono- oder polycyclischen, aromatischen oder hetero-aromatischen Ringsysteme Ar² und/oder Ar³ mindestens eine vernetzbare Gruppe Q aufweisen, ist Ar² und Ar³ vorzugsweise ausgewählt aus den folgenden Einheiten Ar11a bis Ar20c:

| | |
|---|---|
| 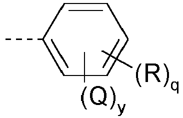 | 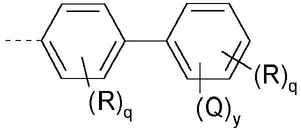 |
| Ar11a | Ar12a |
| 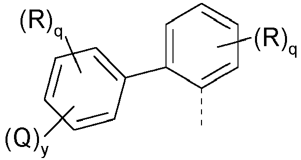 | 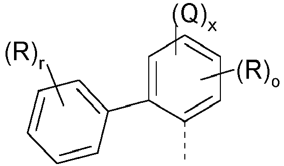 |
| Ar13a | Ar13b |
| 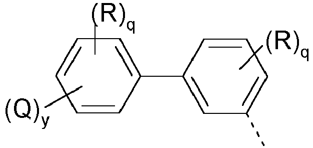 | 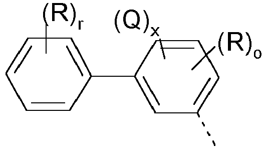 |
| Ar14a | Ar14b |
| 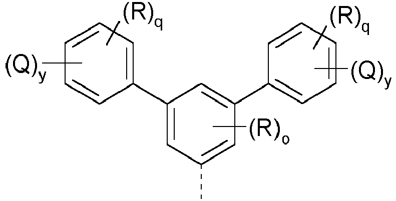 | 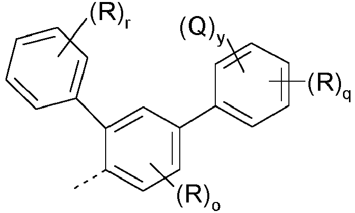 |
| Ar15a | Ar16a |
| 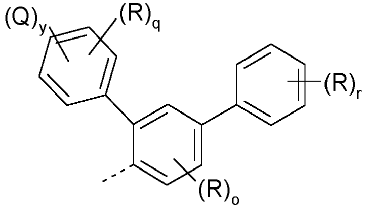 | 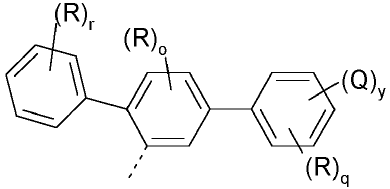 |
| Ar16b | Ar17a |
| 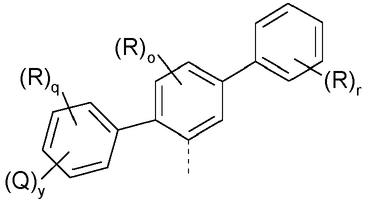 | 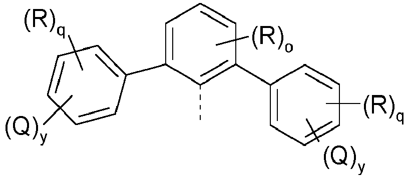 |
| Ar17b | Ar18a |
| 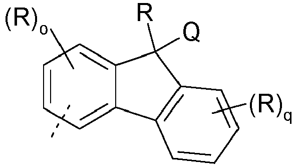 | 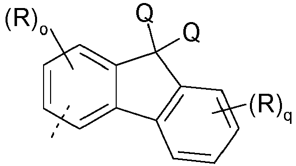 |
| Ar19a | Ar19b |
| 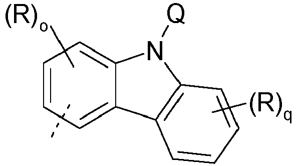 | 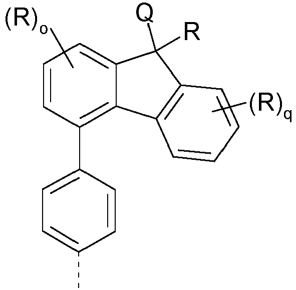 |
| Ar19c | Ar20a |
| 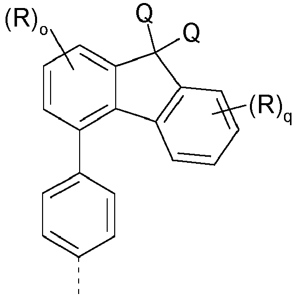 | 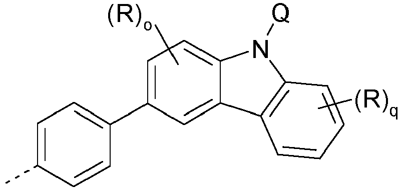 |
| Ar20b | Ar20c |

wobei R die oben angegebenen Bedeutungen annehmen kann, Q eine vernetzbare Gruppe ist,
o = 0, 1,2 oder 3 ist,
p = 0, 1 oder 2 ist,
q = 0, 1, 2, 3 oder 4 ist,
r = 0, 1, 2, 3, 4 oder 5 ist,
x = 1,2, 3 oder 4 ist, wobei gilt x + o ≤ 4, und
y = 1, 2, 3, 4 oder 5 ist, wobei gilt y + q ≤ 5.

In den Wiederholungseinheiten der Formeln (IIId), (IIIe) und (IIIf), in denen die mono- oder polycyclischen, aromatischen oder hetero-aromatischen Ringsysteme Ar² und/oder Ar³ mindestens eine vernetzbare Gruppe Q aufweisen, ist Ar² und Ar³ besonders bevorzugt ausgewählt aus den folgenden Einheiten Ar11a1 bis Ar20c1:

| | |
|---|---|
| 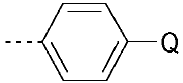 | 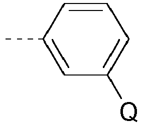 |
| Ar11 a1 | Ar11 a2 |
| 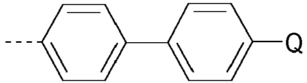 | 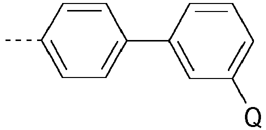 |
| Ar12a1 | Ar12a2 |
| 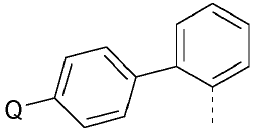 | 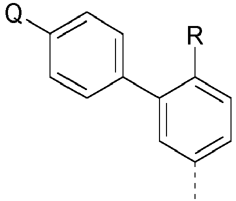 |
| Ar13a1 | Ar14a1 |
| 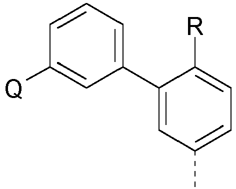 | 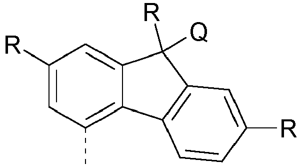 |
| Ar14a2 | Ar19a1 |
| 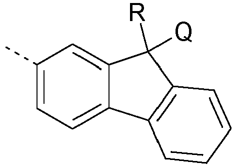 | 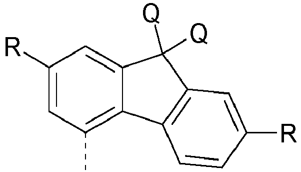 |
| Ar19a2 | Ar19b1 |
| 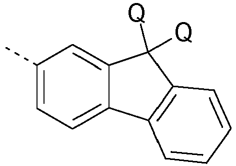 | 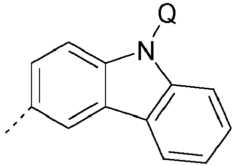 |
| Ar19b2 | Ar19c1 |
| 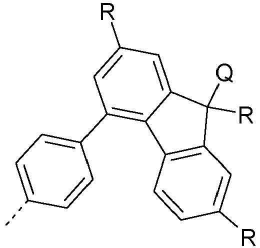 | 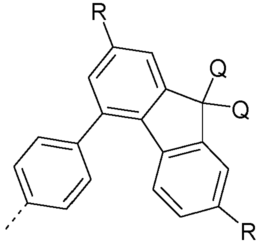 |
| Ar20a1 | Ar20b1 |
| 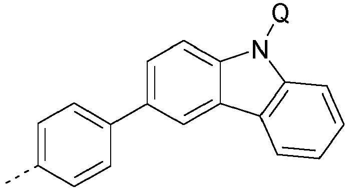 | |
| Ar20c1 | |

wobei R die oben angegebenen Bedeutungen annehmen kann und Q eine vernetzbare Gruppe ist.

In den Wiederholungseinheiten der Formeln (IIIa) bis (IIIf) sind die mono- oder polycyclischen, aromatischen oder heteroaromatischen Ringsysteme Ar¹ und/oder Ar⁴ vorzugsweise ausgewählt aus den Einheiten Ar11 bis Ar18 und besonders bevorzugt ausgewählt aus den Einheiten Ar11a bis Ar18d.

Bevorzugte Wiederholungseinheiten der Formeln (IIIa) bis (IIIf) sind die in der folgenden Tabelle dargestellten Wiederholungseinheiten, die sich aus den jeweiligen Bausteinen A, B, Ar¹, Ar², Ar³ und Ar⁴ zusammensetzen.

| Monomer | A | B | Ar1 | Ar2 | Ar3 | Ar4 | Q |
|---|---|---|---|---|---|---|---|
| MX30 | A11a1 | B1aa | Ar11 aa | Ar3a | Ar3a | Ar11 aa | Q15b |
| MX31 | A11a1 | B1aa | Ar11 aa | Ar3b | Ar3b | Ar11 aa | Q15d |
| MX32 | A11a1 | B1aa | Ar11 aa | Ar3c | Ar3c | Ar11 aa | Q26b |
| MX33 | A11a1 | B1aa | Ar11 aa | Ar9a | Ar9a | Ar11 aa | Q27c |
| MX34 | A11b1 | B1aa | Ar12d | Ar2a | Ar2a | Ar12d | Q16d |
| MX35 | A11b1 | B1aa | Ar11a | Ar3a | Ar3a | Ar11a | Q14b |
| MX36 | A1aa | B11a1 | Ar12aa | Ar9a | Ar9a | Ar12aa | Q15e |
| MX37 | A1aa | B11a1 | Ar11 aa | Ar3a | Ar3a | Ar11 aa | Q14b |
| MX38 | A2aa | B14a1 | Ar11 aa | Ar3b | Ar3b | Ar11 aa | Q1b |
| MX39 | A3aa | B11a6 | Ar11 aa | Ar10b | Ar10b | Ar11 aa | Q2b |
| MX40 | A11a1 | B11a1 | Ar11 aa | Ar3a | Ar3a | Ar11 aa | Q15b |
| MX41 | A11a1 | B11a1 | Ar11 aa | Ar3b | Ar3b | Ar11 aa | Q15d |
| MX42 | A11a1 | B11a1 | Ar11 aa | Ar3c | Ar3c | Ar11 aa | Q26b |
| MX43 | A13a1 | B11a6 | Ar12aa | Ar9a | Ar9a | Ar12aa | Q15g |
| MX44 | A1aa | B1aa | Ar11 aa | Ar13a1 | Ar13a1 | Ar11 aa | Q1b |
| MX45 | A1aa | B1aa | Ar11 aa | Ar12a1 | Ar12a1 | Ar11 aa | Q1b |
| MX46 | A1aa | B1aa | Ar11 aa | Ar11 a1 | Ar11 a1 | Ar11 aa | Q12b |
| MX47 | A1aa | B1aa | Ar11 aa | Ar19a1 | Ar19a1 | Ar11 aa | Q15f |
| MX48 | A1aa | B1aa | Ar11 aa | Ar12a2 | Ar12a2 | Ar11 aa | Q1b |
| MX49 | A1aa | B1aa | Ar12aa | Ar13a1 | Ar13a1 | Ar12aa | Q13a |
| MX50 | A1aa | B1aa | Ar12ab | Ar14a2 | Ar14a2 | Ar12ab | Q15c |
| MX51 | A1aa | B1aa | Ar12da | Ar11 a1 | Ar11 a1 | Ar12da | Q1b |
| MX52 | A1aa | B1aa | Ar13aa | Ar12a2 | Ar12a2 | Ar13aa | Q12b |
| MX53 | A1aa | B1ab | Ar11 aa | Ar13a1 | Ar13a1 | Ar11 aa | Q1c |
| MX54 | A1aa | B1ab | Ar11 aa | Ar19a1 | Ar19a1 | Ar11 aa | Q27c |
| MX55 | A1aa | B1ab | Ar11 aa | Ar19b1 | Ar19b1 | Ar11 aa | Q15g |
| MX56 | A1aa | B1ab | Ar11 aa | Ar20a1 | Ar20a1 | Ar11 aa | Q26b |
| MX57 | A1aa | B1ab | Ar11 aa | Ar20b1 | Ar20b1 | Ar11 aa | Q15b |
| MX58 | A1aa | B1ab | Ar12aa | Ar19a2 | Ar19a2 | Ar12aa | Q15e |
| MX59 | A1aa | B1ac | Ar11 aa | Ar13a1 | Ar13a1 | Ar11 aa | Q1b |
| MX60 | A1aa | B1ac | Ar11 aa | Ar11 a1 | Ar11 a1 | Ar11 aa | Q12b |
| MX61 | A1aa | B1ac | Ar11 aa | Ar11 a2 | Ar11 a2 | Ar11 aa | Q1b |
| MX62 | A1aa | B1ac | Ar11 aa | Ar12a1 | Ar12a1 | Ar11 aa | Q4b |
| MX63 | A1aa | B1ac | Ar11 aa | Ar12a2 | Ar12a2 | Ar11 aa | Q13a |
| MX64 | A1aa | B1ad | Ar11 aa | Ar19b1 | Ar19b1 | Ar11 aa | Q26b |
| MX65 | A1aa | B1ae | Ar12aa | Ar20b1 | Ar20b1 | Ar12aa | Q15b |
| MX66 | A1aa | B1ba | Ar11 aa | Ar20c1 | Ar20c1 | Ar11 aa | Q27c |
| MX67 | A1ba | B1bb | Ar11 bb | Ar20a1 | Ar20a1 | Ar11 bb | Q15g |
| MX68 | A2aa | B4aa | Ar17aa | Ar11 a1 | Ar11 a1 | A17aa | Q1b |
| MX69 | A3aa | B1aa | A11aa | Ar12a1 | Ar12a1 | A11aa | Q12b |
| MX70 | A3aa | B1ab | A12aa | Ar19a1 | Ar19a1 | A12aa | Q27c |
| MX71 | A5aa | B4ca | A13ba | Ar12a2 | Ar12a2 | A13ba | Q4b |
| MX72 | A1aa | B1aa | Ar11 aa | Ar3a | Ar13a1 | Ar11 aa | Q1b |
| MX73 | A1aa | B1aa | Ar11 aa | Ar2a | Ar12a1 | Ar11 aa | Q1b |
| MX74 | A1aa | B1aa | Ar11 aa | Ar1a | Ar11 a1 | Ar11 aa | Q12b |
| MX75 | A1aa | B1aa | Ar11 aa | Ar9a | Ar19a1 | Ar11 aa | Q15f |
| MX76 | A1aa | B1aa | Ar11 aa | Ar2a | Ar12a2 | Ar11 aa | Q1b |
| MX77 | A1aa | B1aa | Ar12aa | Ar3a | Ar13a1 | Ar12aa | Q13a |
| MX78 | A1aa | B1aa | Ar12ab | Ar4a | Ar14a2 | Ar12ab | Q15c |
| MX79 | A2aa | B4aa | Ar17aa | Ar1a | Ar11 a1 | A17aa | Q1b |
| MX80 | A3aa | B1aa | A11aa | Ar2a | Ar12a1 | A11aa | Q12b |
| MX81 | A3aa | B1ab | A12aa | Ar9a | Ar19a1 | A12aa | Q27c |
| MX82 | A5aa | B4ca | A13ba | Ar2a | Ar12a2 | A13ba | Q4b |
| MX83 | A1aa | B1aa | Ar11 aa | Ar13a1 | Ar3a | Ar11 aa | Q1b |
| MX84 | A1aa | B1aa | Ar11 aa | Ar12a1 | Ar2a | Ar11 aa | Q1b |
| MX85 | A1aa | B1aa | Ar11 aa | Ar11 a1 | Ar1a | Ar11 aa | Q12b |
| MX86 | A1aa | B1aa | Ar11 aa | Ar19a1 | Ar9a | Ar11 aa | Q15f |
| MX87 | A1aa | B1aa | Ar11 aa | Ar12a2 | Ar2a | Ar11 aa | Q1b |
| MX88 | A1aa | B1aa | Ar12aa | Ar13a1 | Ar3a | Ar12aa | Q13a |
| MX89 | A1aa | B1ac | Ar11 aa | Ar11 a2 | Ar1a | Ar11 aa | Q1b |
| MX90 | A2aa | B4aa | Ar17aa | Ar11 a1 | Ar11 | A17aa | Q1b |
| MX91 | A3aa | B1aa | A11aa | Ar12a1 | Ar2a | A11aa | Q12b |
| MX92 | A3aa | B1ab | A12aa | Ar19a1 | Ar9a | A12aa | Q27c |
| MX93 | A5aa | B4ca | A13ba | Ar12a2 | Ar2a | A13ba | Q4b |

Die erfindungsgemäßen Polymere enthaltend Wiederholungseinheiten der Formel (la), (Ia1) und/oder (Ia2 ) werden in der Regel durch Polymerisation von einer oder mehreren Monomersorten hergestellt, von denen mindestens ein Monomer im Polymer zu Wiederholungseinheiten der Formel (la), (Ia1) und/oder (Ia2) führt. Geeignete Polymerisationsreaktionen sind dem Fachmann bekannt und in der Literatur beschrieben. Besonders geeignete und bevorzugte Polymerisationsreaktionen, die zu C-C- bzw. C-N-Verknüpfungen führen, sind folgende:
(A) SUZUKI-Polymerisation;
(B) YAMAMOTO-Polymerisation;
(C) STILLE-Polymerisation;
(D) HECK-Polymerisation;
(E) NEGISHI-Polymerisation;
(F) SONOGASHIRA-Polymerisation;
(G) HIYAMA-Polymerisation; und
(H) HARTWIG-BUCHWALD-Polymerisation.

Wie die Polymerisation nach diesen Methoden durchgeführt werden kann und wie die Polymere dann vom Reaktionsmedium abgetrennt und aufgereinigt werden können, ist dem Fachmann bekannt und in der Literatur, beispielsweise in der WO 03/048225 A2, der WO 2004/037887 A2 und der WO 2004/037887 A2 im Detail beschrieben.

Die C-C-Verknüpfungen sind vorzugsweise ausgewählt aus den Gruppen der SUZUKI-Kupplung, der YAMAMOTO-Kupplung und der STILLE-Kupplung; die C-N-Verknüpfung ist vorzugsweise eine Kupplung gemäß HARTWIG-BUCHWALD.

Gegenstand der vorliegenden Erfindung ist somit auch ein Verfahren zur Herstellung der erfindungsgemäßen Polymere, das dadurch gekennzeichnet ist, dass sie durch Polymerisation gemäß SUZUKI, Polymerisation gemäß YAMAMOTO, Polymerisation gemäß STILLE oder Polymerisation gemäß HARTWIG-BUCHWALD hergestellt werden.

Zur Synthese der erfindungsgemäßen Polymere werden die entsprechenden Monomere der Formel (MI) benötigt, 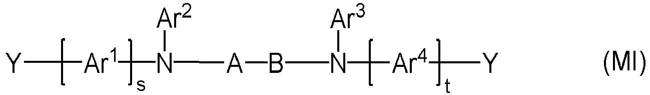 wobei A, B, Ar¹, Ar², Ar³ und Ar⁴ sowie s und t die in Bezug auf die Wiederholungseinheit der Formel (la) angegebenen Bedeutungen annehmen kann.

Die Monomere der Formel (MI), die in den erfindungsgemäßen Polymeren zu Wiederholungseinheiten der Formel (la) führen, sind Verbindungen, die entsprechend substituiert sind und an zwei Positionen geeignete Funktionalitäten aufweisen, die es erlauben, diese Monomereinheit in das Polymer einzubauen. Diese Monomere der Formel (MI) sind somit ebenfalls Gegenstand der vorliegenden Erfindung. Die Gruppe Y stellt, gleich oder verschieden, eine für eine Polymerisationsreaktion geeignete Abgangsgruppe dar, so dass der Einbau der Monomerbausteine in polymere Verbindungen ermöglicht wird. Vorzugsweise stellt Y eine chemische Funktionalität dar, welche gleich oder verschieden ausgewählt ist aus der Klasse der Halogene, O-Tosylate, O-Triflate, O-Sulfonate, Borsäureester, teilfluorierten Silylgruppen, Diazoniumgruppen und zinnorganischen Verbindungen.

Das Grundgerüst der Monomerverbindungen lässt sich nach Standardmethoden funktionalisieren, beispielsweise durch Friedel-Crafts-Alkylierung oder -Acylierung. Weiterhin lässt sich das Grundgerüst nach Standardmethoden der organischen Chemie halogenieren. Die halogenierten Verbindungen lassen sich in zusätzlichen Funktionalisierungsschritten wahlweise weiter umsetzen. Beispielsweise können die halogenierten Verbindungen entweder direkt oder nach Überführung in ein Boronsäurederivat oder zinnorganisches Derivat als Ausgangsstoffe für die Umsetzung zu Polymeren, Oligomeren oder Dendrimeren eingesetzt werden.

Die genannten Methoden stellen lediglich eine Auswahl aus den dem Fachmann bekannten Reaktionen dar, welche dieser, ohne erfinderisch tätig zu werden, zur Synthese der erfindungsgemäßen Verbindungen einsetzen kann.

Die erfindungsgemäßen Polymere können als Reinsubstanz, aber auch als Mischung zusammen mit weiteren beliebigen polymeren, oligomeren, dendritischen oder niedermolekularen Substanzen verwendet werden. Als niedermolekulare Substanz versteht man in der vorliegenden Erfindung Verbindungen mit einem Molekulargewicht im Bereich von 100 bis 3000 g/mol, vorzugsweise 200 bis 2000 g/mol. Diese weiteren Substanzen können z.B. die elektronischen Eigenschaften verbessern oder selbst emittieren. Als Mischung wird vor- und nachstehend eine Mischung enthaltend mindestens eine polymere Komponente bezeichnet. Auf diese Art können eine oder mehrere Polymerschichten bestehend aus einer Mischung (Blend) aus einem oder mehreren erfindungsgemäßen Polymeren mit einer Struktureinheit der Formel (la), (Ia1) und/oder (Ia2) und optional einem oder mehreren weiteren Polymeren mit einer oder mehreren niedermolekularen Substanzen hergestellt werden.

Ein weiterer Gegenstand der vorliegenden Erfindung ist somit ein Polymer Blend enthaltend ein oder mehrere erfindungsgemäße Polymere, sowie eine oder mehrere weitere polymere, oligomere, dendritische und/oder niedermolekulare Substanzen.

Gegenstand der Erfindung sind weiterhin Lösungen und Formulierungen aus einem oder mehreren erfindungsgemäßen Polymeren oder einem Polymer Blend in einem oder mehreren Lösungsmitteln. Wie solche Lösungen hergestellt werden können, ist dem Fachmann bekannt und beispielsweise in der WO 02/072714 A1, der WO 03/019694 A2 und der darin zitierten Literatur beschrieben.

Diese Lösungen können verwendet werden, um dünne Polymerschichten herzustellen, zum Beispiel durch Flächenbeschichtungsverfahren (z.B. Spin-coating) oder durch Druckverfahren (z.B. InkJet Printing).

Polymere enthaltend Wiederholungseinheiten, die eine vernetzbare Gruppe Q aufweisen, eignen sich besonders zur Herstellung von Filmen oder Beschichtungen, insbesondere zur Herstellung von strukturierten Beschichtungen, z.B. durch thermische oder lichtinduzierte in-situ-Polymerisation und in-situ-Vernetzung, wie beispielsweise in-situ-UV-Photopolymerisation oder Photopatterning. Dabei können sowohl entsprechende Polymere in Reinsubstanz verwendet werden, es können aber auch Formulierungen oder Mischungen dieser Polymere wie oben beschrieben verwendet werden. Diese können mit oder ohne Zusatz von Lösungsmitteln und/oder Bindemitteln verwendet werden. Geeignete Materialien, Verfahren und Vorrichtungen für die oben beschriebenen Methoden sind z.B. in der WO 2005/083812 A2 beschrieben. Mögliche Bindemittel sind beispielsweise Polystyrol, Polycarbonat, Poly(meth)-acrylate, Polyacrylate, Polyvinylbutyral und ähnliche, optoelektronisch neutrale Polymere.

Geeignete und bevorzugte Lösungsmittel sind beispielsweise Toluol, Anisol, o-, m- oder p-Xylol, Methylbenzoat, Mesitylen, Tetralin, Veratrol, THF, Methyl-THF, THP, Chlorbenzol, Dioxan, Phenoxytoluol, insbesondere 3-Phenoxytoluol, (-)-Fenchon, 1,2,3,5-Tetramethylbenzol, 1,2,4,5-tetramethylbenzol, 1-Methylnaphtalin, 2-Methylbenzothiazol, 2-Phenoxyethanol, 2-Pyrrolidinon, 3-Methylanisol, 4-Methylanisol, 3,4-Dimethylanisol, 3,5-Dimethylanisol, Acetophenon, α-Terpineol, Benzothiazol, Butylbenzoat, Cumol, Cyclohexanol, Cyclohexanon, Cyclohexylbenzol, Decalin, Dodecylbenzol, Ethylbenzoat, Indan, Methylbenzoat, NMP, p-Cymol, Phenetol, 1,4-Diisopropylbenzol, Dibenzylether, Diethylenglycolbutylmethylether, Triethylenglycolbutylmethylether, Diethylenglycoldibutylether, Triethylenglycoldimethylether, Diethylen-glycolmonobutylether, Tripropylenglycoldimethylether, Tetraethylenglycoldimethylether, 2-Isopropylnaphthalin, Pentylbenzol, Hexylbenzol, Heptylbenzol, Octylbenzol, 1,1-Bis(3,4-Dimethylphenyl)ethan oder Mischungen dieser Lösungsmittel. Ein weiterer Gegenstand der vorliegenden Erfindung ist somit die Verwendung eines Polymers, das Wiederholungseinheiten enthält, die eine vernetzbare Gruppe Q aufweisen, zur Herstellung eines vernetzten Polymers. Die vernetzbare Gruppe, die besonders bevorzugt eine Vinylgruppe oder Alkenylgruppe ist, wird vorzugsweise durch die WITTIG-Reaktion oder eine WITTIG-analoge Reaktion in das Polymer eingebaut. Ist die vernetzbare Gruppe eine Vinylgruppe oder Alkenylgruppe, so kann die Vernetzung durch radikalische oder ionische Polymerisation stattfinden, wobei diese thermisch oder durch Strahlung induziert werden kann. Bevorzugt ist die radikalische Polymerisation, die thermisch induziert wird, vorzugsweise bei Temperaturen von weniger als 250°C, besonders bevorzugt bei Temperaturen von weniger als 230°C.

Wahlweise wird während des Vernetzungsverfahrens ein zusätzliches Styrol-Monomer zugesetzt, um einen höheren Grad der Vernetzung zu erzielen. Vorzugsweise ist der Anteil des zugesetzten Styrol-Monomers im Bereich von 0,01 bis 50 mol%, besonders bevorzugt 0,1 bis 30 mol%, bezogen auf 100 mol% aller copolymerisierten Monomere, die im Polymer als Struktureinheiten enthalten sind.

Gegenstand der vorliegenden Erfindung ist somit auch ein Verfahren zur Herstellung eines vernetzten Polymers, das folgende Schritte umfasst:
(a) Bereitstellen von Polymeren, die Wiederholungseinheiten enthalten, die eine oder mehrere vernetzbare Gruppen Q aufweisen; und
(b) Radikalische oder ionische Vernetzung, vorzugsweise radikalische Vernetzung, die sowohl thermisch als auch durch Strahlung, vorzugsweise thermisch, induziert werden kann.

Die durch das erfindungsgemäße Verfahren hergestellten vernetzten Polymere sind in allen gängigen Lösungsmitteln unlöslich. Auf diese Weise lassen sich definierte Schichtdicken herstellen, die auch durch das Aufbringen nachfolgender Schichten nicht wieder gelöst bzw. angelöst werden.

Die vorliegende Erfindung betrifft somit auch ein vernetztes Polymer, das durch das zuvor genannte Verfahren erhältlich ist. Das vernetzte Polymer wird - wie vorstehend beschrieben - vorzugsweise in Form einer vernetzen Polymerschicht hergestellt. Auf die Oberfläche einer solchen vernetzten Polymerschicht kann aufgrund der Unlöslichkeit des vernetzten Polymers in sämtlichen Lösungsmitteln eine weitere Schicht aus einem Lösungsmittel mit den oben beschriebenen Techniken aufgebracht werden.

Die vorliegende Erfindung umfasst auch sogenannte Hybridvorrichtungen, in der eine oder mehrere Schichten, die aus Lösung prozessiert werden, und Schichten, die durch Aufdampfen von niedermolekularen Substanzen hergestellt werden, vorkommen können.

Die erfindungsgemäßen Polymere können in elektronischen oder optoelektronischen Vorrichtungen bzw. zu deren Herstellung verwendet werden.

Ein weiterer Gegenstand der vorliegenden Erfindung ist somit die Verwendung der erfindungsgemäßen Polymere in elektronischen oder optoelektronischen Vorrichtungen, vorzugsweise in organischen Elektrolumineszenzvorrichtungen (OLED), organischen Feld-Effekt-Transistoren (OFETs), organischen integrierten Schaltungen (O-ICs), organischen Dünnfilmtransistoren (TFTs), organischen Solarzellen (O-SCs), organischen Laserdioden (O-Laser), organischen photovoltaischen (OPV) Elementen oder Vorrichtungen oder organischen Photorezeptoren (OPCs), besonders bevorzugt in organischen Elektrolumineszenzvorrichtungen (OLED).

Im Fall der zuvor genannten Hybridvorrichtung spricht man in Verbindung mit organischen Elektrolumineszenzvorrichtungen von kombinierten PLED/SMOLED (Polymeric Light Emitting Diode/Small Molecule Organic Light Emitting Diode) Systemen.

Wie OLEDs hergestellt werden können, ist dem Fachmann bekannt und wird beispielsweise als allgemeines Verfahren ausführlich in der WO 2004/070772 A2 beschrieben, das entsprechend für den Einzelfall anzupassen ist.

Wie oben beschrieben, eignen sich die erfindungsgemäßen Polymere ganz besonders als Elektrolumineszenzmaterialien in derart hergestellten OLEDs oder Displays.

Als Elektrolumineszenzmaterialien im Sinne der vorliegenden Erfindung gelten Materialien, die als aktive Schicht Verwendung finden können. Aktive Schicht bedeutet, dass die Schicht befähigt ist, bei Anlegen eines elektrischen Feldes Licht abzustrahlen (lichtemittierende Schicht) und/oder dass sie die Injektion und/oder den Transport der positiven und/oder negativen Ladungen verbessert (Ladungsinjektions- oder Ladungstransportschicht).

Ein bevorzugter Gegenstand der vorliegenden Erfindung ist daher auch die Verwendung der erfindungsgemäßen Polymere in OLEDs, insbesondere als Elektrolumineszenzmaterial.

Gegenstand der vorliegenden Erfindung sind ferner elektronische oder optoelektronische Bauteile, vorzugsweise organische Elektrolumineszenzvorrichtungen (OLED), organische Feld-Effekt-Transistoren (OFETs), organische integrierte Schaltungen (O-ICs), organische Dünnfilmtransistoren (TFTs), organische Solarzellen (O-SCs), organische Laserdioden (O-Laser), organische photovoltaische (OPV) Elemente oder Vorrichtungen und organische Photorezeptoren (OPCs), besonders bevorzugt organische Elektrolumineszenzvorrichtungen, mit einer oder mehreren aktiven Schichten, wobei mindestens eine dieser aktiven Schichten ein oder mehrere erfindungsgemäße Polymere enthält. Die aktive Schicht kann beispielsweise eine lichtemittierende Schicht, eine Ladungstransportschicht und/oder eine Ladungsinjektionsschicht sein.

Im vorliegenden Anmeldungstext und auch in den im Weiteren folgenden Beispielen wird hauptsächlich auf die Verwendung der erfindungsgemäßen Polymere in Bezug auf OLEDs und entsprechende Displays abgezielt. Trotz dieser Beschränkung der Beschreibung ist es für den Fachmann ohne weiteres erfinderisches Zutun möglich, die erfindungsgemäßen Polymere als Halbleiter auch für die weiteren, oben beschriebenen Verwendungen in anderen elektronischen Vorrichtungen zu benutzen.

Die folgenden Beispiele sollen die Erfindung erläutern, ohne sie einzuschränken. Insbesondere sind die darin beschriebenen Merkmale, Eigenschaften und Vorteile der dem betreffenden Beispiel zu Grunde liegenden definierten Verbindungen auch auf andere, nicht im Detail aufgeführte, aber unter den Schutzbereich der Ansprüche fallende Verbindungen anwendbar, sofern an anderer Stelle nichts Gegenteiliges gesagt wird.

### Ausführungsbeispiele:

### Teil A: Synthese der Monomere

Alle Synthesen werden in einer Argon-Atmosphäre und in trockenen Lösungsmitteln durchgeführt, soweit nichts anderes beschrieben wird.

### Beispiel 1

### Synthese des Monomeren Mon-1

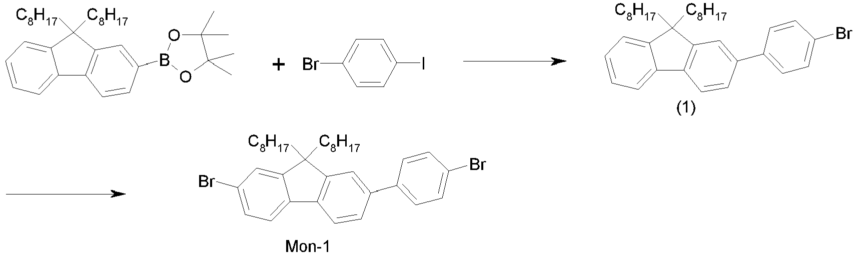

135 g (293 mmol) 2-(9,9-Dioctyl-9H-fluoren-2-yl)-[1,3,2]dioxaborolane und 87 g (299 mmol, 1.02 eq) 1-Bromo-4-iodbenzol werden in 2200 ml Ethylenglycoldimethylether vorgelegt und 68 g (655 mmol) Na₂CO₃ gelöst in 250 ml H₂O werden zugegeben. Das Gemisch wird mit Argon gesättigt, mit 10,2 g (8,8 mmol) Tetrakis(triphenylphosphin)palladium(0) versetzt und für 48 Stunden unter Rückfluß gerührt. Nach Abkühlen auf Raumtemperatur wir der Ansatz mit Wasser und Toluol versetzt und die organische Phase abgetrennt. Die organische Phase wird dreimal mit je 500 ml Wasser gewaschen, über Natriumsulfat getrocknet und am Rotationsverdampfer vom Lösungsmittel befreit. Das Rohprodukt wird anschließend in Heptan aufgenommen und über Kieselgel filtriert. Nach entfernen des Lösungsmittels verbleiben 130 g (240 mmol, 82% d. Th.) eines beigen Feststoffes (1).

130 g (240 mmol) des Feststoffes (1) und 42,6 g (240 mmol) N-Bromsuccinimid werden in 3300 ml DCM gelöst und die Mischung wird auf 40°C erhitzt. Anschließend wird 1 ml 33% Lösung HBr in Essigsäure zugegeben und die Mischung wird für 12 Stunden bei 40°C gerührt. Nach Abkühlen auf Raumtemperatur wir der Ansatz am Rotationsverdampfer vom Lösungsmittel befreit, in heißem Toluol gelöst und filtriert. Die orange Lösung wird erneut am Rotationsverdampfer eingeengt und der verbleibende Feststoff mehrmals in heißem Heptan gelöst und mit Ethanol gefällt. Es wurden 82 g (130 mmol, 55% d. Th.) Mon-1 erhalten.

### Beispiele 2 bis 6

### Synthese der Monomeren Mon-2 bis Mon-5 und Mon-16

Analog Beispiel 1 werden mit den in der folgenden Tabelle 1 dargestellten Edukten die Monomere Mon-2 bis Mon-5 und Mon-16 in den entsprechenden Ausbeuten erhalten.

**Tabelle 1**

| Beispiel | Bez. Produkt | Edukt | Produkt | Ausbeute (%) |
|---|---|---|---|---|
| 1 | Mon-1 | 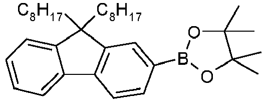 | 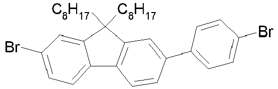 | 55 |
| 2 | Mon-2 | 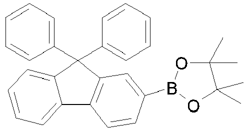 | 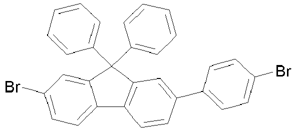 | 73 |
| 3 | Mon-3 | 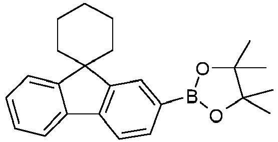 | 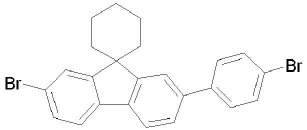 | 48 |
| 4 | Mon-4 | 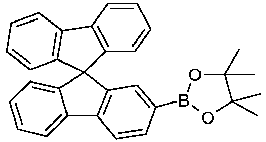 | 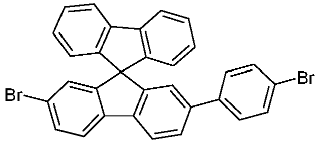 | 62 |
| 5 | Mon-5 | 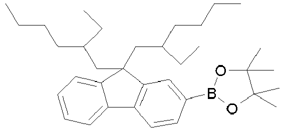 | 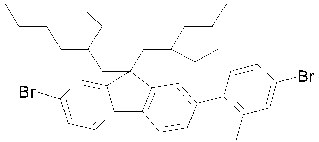 | 34 |
| 6 | Mon-16 | 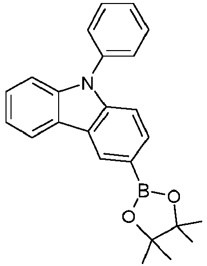 | 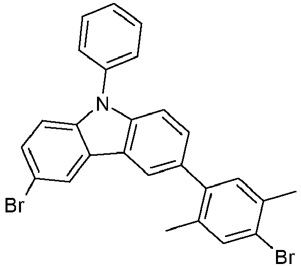 | 52 |

### Beispiel 7

### Synthese des Monomeren Mon-6

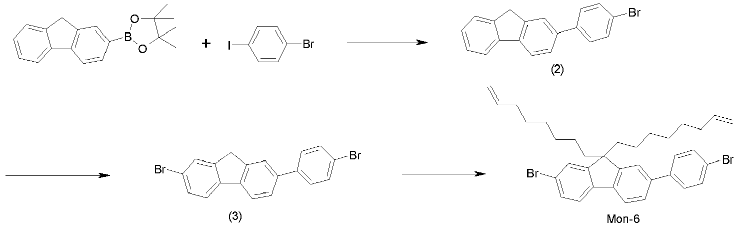

82,4 g (280 mmol) 2-(9H-Fluoren-2-yl)-4,4,5,5-tetramethyl-[1,3,2]dioxaborolane und 90,5 g (310 mmol) 1-Bromo-4-iodbenzol werden in 600 ml Ethylenglycoldimethylether vorgelegt und anschließend 65,7 g (620 mmol) Na₂CO₃ gelöst in 160 ml H₂O zugegeben. Das Gemisch wird mit Argon gesättigt, mit 10,2 g (8,8 mmol) Tetrakis(triphenylphosphin)-palladium(0) versetzt und für 48 Stunden unter Rückfluß gerührt. Anschließend wird die Mischung auf Raumtemperatur abgekühlt und mit 500 ml Wasser und 600 ml Toluol versetzt. Nach Phasentrennung wird die organische Phase dreimal mit je 500 ml Wasser gewaschen, über Natriumsulfat getrocknet und am Rotationsverdampfer vom Lösungsmittel befreit. Der verbleibende Feststoff wird in heißem Heptan ausgerührt und die Suspension abgesaugt. Es wurden 50,3 g (157 mmol, 56% d. Th.) eines weißen Feststoffes (2) erhalten.

50,3 g (157 mmol) Feststoff (2) werden zusammen mit 28,1 g (158 mmol) N-Bromsuccinimid in 1300 ml DCM gelöst und auf 40°C erhitzt. Anschließend wird ein Tropfen 33% Lösung HBr in Essigsäure zugegeben und die Mischung wird für 12 Stunden bei 40°C gerührt. Nach Abkühlen auf Raumtemperatur wird der Ansatz am Rotationsverdampfer vom Lösungsmittel befreit, in heißem Ethanol ausgerührt und filtriert. Nach Filtration über Kieselgel (Lösungsmittel: Toluol) wird die Lösung erneut eingeengt. Der Feststoff wird wieder in heißem Toluol aufgenommen, mit Ethanol ausgefällt, über Nacht ausgerührt, abgesaugt und mit Methanol nachgewaschen. Es wurden 53,3 g (133 mmol, 85% d. Th.) eines Feststoffes (3) erhalten.

9,5 g (23,5 mmol) Feststoff (3) werden in 190 ml trockenem DMSO gelöst. Zu dieser Lösung wird bei Raumtemperatur 13,8 g (144 mmol) Natrium-t-butylat gegeben. Die Suspension wird auf 80°C erhitzt und bei dieser Temperatur 18,4 g (94 mmol) 1-Brom-oct-8-en langsam zugetropft. Der Ansatz wird bei 80°C über Nacht gerührt. Anschließend wird die Mischung auf Raumtemperatur abgekühlt und mit 20 ml Toluol und 25 ml Wasser gequencht. Nach Phasentrennung wird die organische Phase dreimal mit je 500 ml Wasser gewaschen, über Natriumsulfat getrocknet und am Rotationsverdampfer vom Lösungsmittel befreit. Der Feststoff wird dann mit Heptan über eine Kieselgelfritte eluiert und das farblose Eluat am Rotationsverdampfer eingeengt. Umkristallisation aus Ethanol ergab 6,5 g (10,4 mmol, 45% d. Th.) Mon-6.

### Beispiele 8 und 9

### Synthese der Monomeren Mon-7 und Mon-8

Analog Beispiel 7 werden mit den in der folgenden Tabelle 2 dargestellten Edukten die Monomere Mon-7 und Mon-8 in den entsprechenden Ausbeuten erhalten.

**Tabelle 2**

| Beispiel | Bez. Produkt | Edukt | Produkt | Ausbeute (%) |
|---|---|---|---|---|
| 7 | Mon-6 | 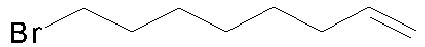 | 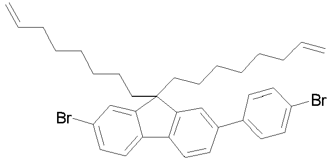 | 45 |
| 8 | Mon-7 | 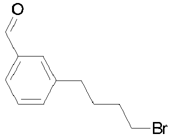 | 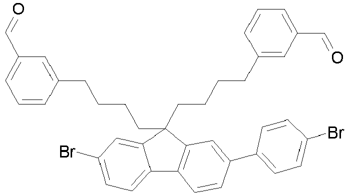 | 38 |
| 9 | Mon-8 | 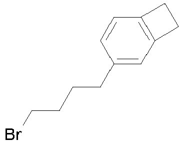 | 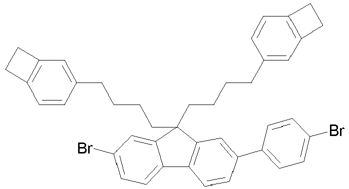 | 63 |

### Beispiel 10

### Synthese des Monomeren Mon-9

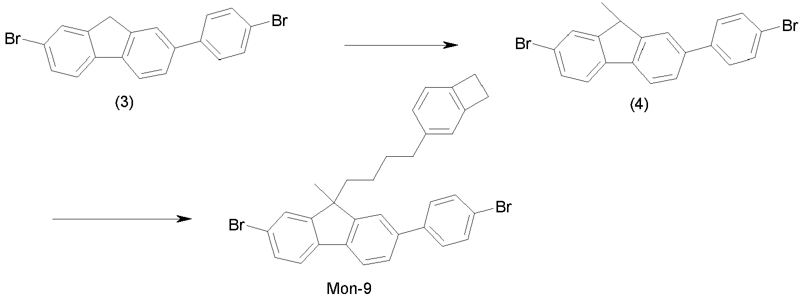

20 g (50 mmol) Feststoff (3) werden in 250 ml THF vorgelegt und auf -78°C abgekühlt. 28,7 ml (57,5 mmol) Lithiumdiisopropylamid (2 M in THF) werden langsam zugetropft, das Gemisch wird auf Raumtemperatur erwärmt und 15 Minuten nachgerührt. Anschließend wird wieder auf -78°C abgekühlt und 14,2 g (100 mmol) Methyliodid zugetropft, die Reaktion kommt über Nacht auf Raumtemperatur. Die Reaktion wird vorsichtig mit einer kleinen Menge Essigsäure gequencht und anschließend Wasser und Toluol zugegeben. Nach Phasentrennung wird die organische Phase dreimal mit je 500 ml Wasser gewaschen, über Natriumsulfat getrocknet und am Rotationsverdampfer vom Lösungsmittel befreit. Der verbleibende Feststoff wird in heißem Heptan ausgerührt und die Suspension abgesaugt. Es wurden 18,3 g (44 mmol, 88% d. Th.) eines Feststoffes (4) erhalten.

18,3 g (44 mmol) Feststoff (4) werden in 200 ml THF vorgelegt und auf -78°C abgekühlt. 66 ml (132 mmol) Lithiumdiisopropylamid (2 M in THF) werden langsam zugetropft, das Gemisch wird auf Raumtemperatur erwärmt und 15 Minuten nachgerührt. Anschließend wird wieder auf -78°C abgekühlt und 15,8 g (66 mmol) 3-(4-Bromo-butyl)-bicyclo[4.2.0]octa-1(6),2,4-triene zugetropft. Die Reaktion kommt über Nacht auf Raumtemperatur und wir dann vorsichtig mit einer kleinen Menge Wasser und Essigsäure gequencht, anschließend wird Toluol zugegeben. Nach Phasentrennung wird die organische Phase dreimal mit je 500 ml Wasser gewaschen, über Natriumsulfat getrocknet und am Rotationsverdampfer vom Lösungsmittel befreit. Der Feststoff wird dann mit Heptan über eine Kieselgelfritte eluiert und das farblose Eluat am Rotationsverdampfer eingeengt. Umkristallisation aus Ethanol ergab 13,3 g (23,3 mmol, 53% d. Th.) Mon-9.

### Beispiele 11 bis 13

### Synthese der Monomeren Mon-10 bis Mon-12

Analog Beispiel 10 werden mit den in der folgenden Tabelle 3 dargestellten Edukten die Monomere Mon-10 bis Mon-12 in den entsprechenden Ausbeuten erhalten.

**Tabelle 3**

| Beispiel | Bez. Produkt | Edukt | Produkt | AusBeute (%) |
|---|---|---|---|---|
| 10 | Mon-9 | 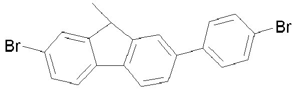 | 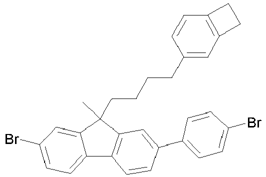 | 53 |
| 11 | Mon-10 | 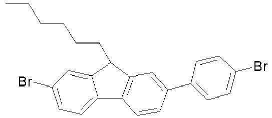 | 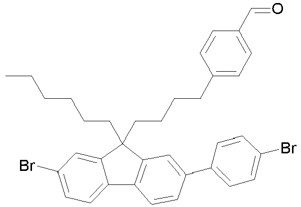 | 48 |
| 12 | Mon-11 | 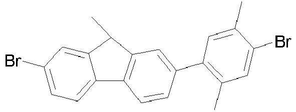 | 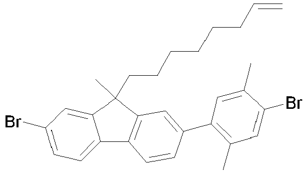 | 65 |
| 13 | Mon-12 | 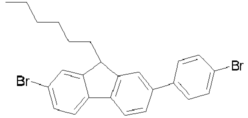 | 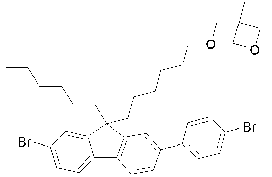 | 28 |

### Beispiel 14

### Synthese des Monomeren Mon-13

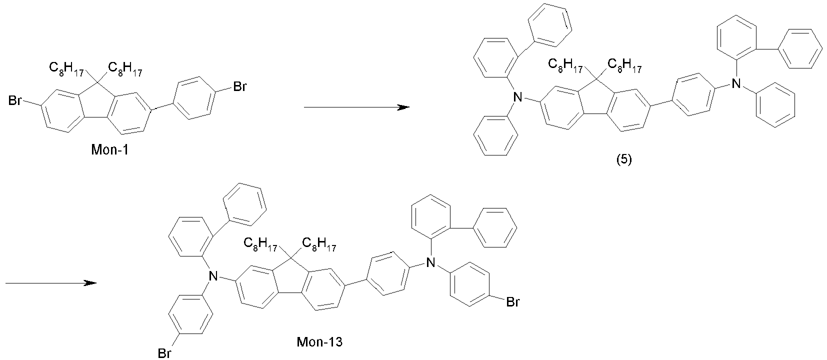

20 g (32 mmol) Monomer Mon-1, 23,6 g (96 mmol) Biphenyl-2-yl-phenyl-amine, 15,4 g (160 mmol) Natrium-t-butylat und 216 mg (0,96 mmol) Palladiumacetat werden in 400 ml Toluol gelöst. Die Mischung wird bei 45°C mit Argon gesättigt, anschließend werden 1,92 ml (19,2 mmol) Tri-t-butylphosphin zugegeben und der Ansatz wird für 12 Stunden unter Rückfluß gerührt. Anschließend wird die Reaktion auf Raumtemperatur abgekühlt, Wasser zugegeben, die organische Phase abgetrennt, dreimal mit Wasser gewaschen, über Natriumsulfat getrocknet und am Rotationsverdampfer vom Lösungsmittel befreit. Der zurückbleibende Rohstoff wird mehrmals aus einem Butanol/Ethanol Gemisch umkristallisiert. Es wurden 19 g (19,8 mmol, 62% d. Th.) Feststoff (5) erhalten.

19 g (19,8 mmol) Feststoff (5) werden in 1000 ml THF vorgelegt. Die Lösung wird mit einem Eis/Salz Bad auf -10°C abgekühlt. Anschließend wird 6,9 g (38.6 mmol) N-Bromsuccinimid zugegeben. Es wird für 1,5 Stunden bei -10°C gerührt, anschließend kommt der Ansatz über Nacht auf Raumtemperatur. Der Ansatz wird dann am Rotationsverdampfer vom Lösungsmittel befreit, in heißem Ethanol ausgerührt und filtriert. Der verbleibende Feststoff wird mehrmals in i-Propanol umkristallisiert. Es wurden 17 g (15 mmol, 76% d. Th.) Mon-13 erhalten.

### Beispiele 15 und 16

### Synthese der Monomeren Mon-14 und Mon-15

Analog Beispiel 14 werden mit den in der folgenden Tabelle 4 dargestellten Edukten die Monomere Mon-14 und Mon-15 in den entsprechenden Ausbeuten erhalten.

**Tabelle 4**

| Beispiel | Bez. Produkt | Edukt | Produkt | AusBeute (%) |
|---|---|---|---|---|
| 14 | Mon-13 | 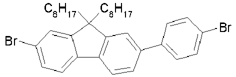 | 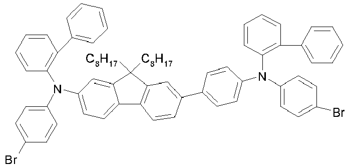 | 76 |
| 15 | Mon-14 | 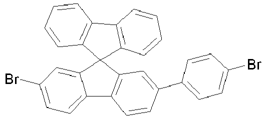 | 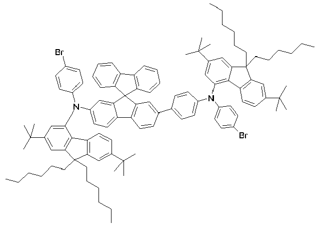 | 58 |
| 16 | Mon-15 | 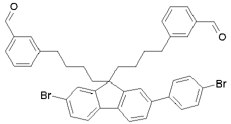 | 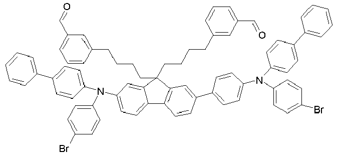 | 44 |

### Beispiel 17

### Synthese des Monomeren Mon-1-BE

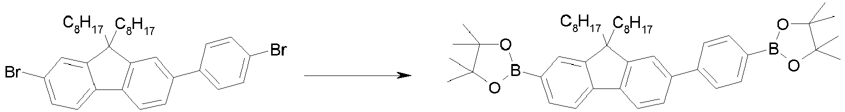

10 g (16 mmol) Monomer Mon-1 werden zusammen mit 10,2 g (40 mmol) Bis(pinacolato)diboron, 5,2 g (53 mmol) Kaliumacetat, 0.35 g (0.48 mmol) Pd(dppf)Cl₂*CH₂Cl₂ in 200 ml DMSO vorgelegt. Das Gemisch wird auf 40°C erhitzt und 20 Minuten lang mit Argon gesättigt. Anschließend wird die Reaktion bei 80°C über Nacht gerührt und auf Raumtemperatur abgekühlt. Nach Zugabe von 150 ml Wasser und 150 ml Essigester wird die organische Phase abgetrennt, 3 mal mit Wasser gewaschen, über Natriumsulfat getrocknet und schließlich am Rotationsverdampfer eingeengt. Der verbleibende Feststoff wird mehrmals in heißem Heptan gelöst und mit Ethanol wieder ausgefällt. Es wurden 8,3 g (11,5 mmol, 72% d.Th.) Monomer Mon-1-BE erhalten.

### Beispiele 18 bis 20

### Synthese der Monomeren Mon-6-BE, Mon-9-BE und Mon-13-BE

Analog Beispiel 17 werden mit den in der folgenden Tabelle 5 dargestellten Edukten die Monomere Mon-6-BE, Mon-9-BE und Mon-13-BE in den entsprechenden Ausbeuten erhalten.

**Tabelle 5**

| Beispiel | Bez. Produkt | Edukt | Produkt | Ausbeute (%) |
|---|---|---|---|---|
| 17 | Mon-1-BE | 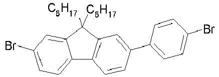 | 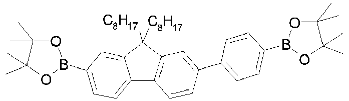 | 72 |
| 18 | Mon-6-BE | 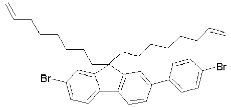 | 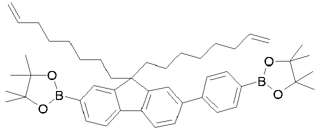 | 83 |
| 19 | Mon-9-BE | 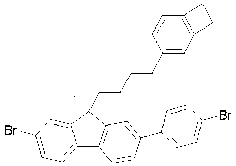 | 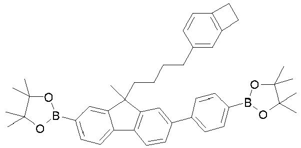 | 67 |
| 20 | Mon-13-BE | 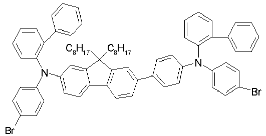 | 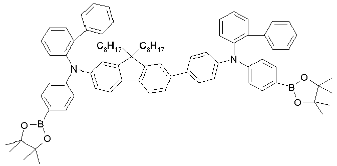 | 55 |

### Weitere Monomere:

Weitere Monomere zur Herstellung der erfindungsgemäßen Polymere sind bereits im Stand der Technik beschrieben, kommerziell erhältlich oder werden gemäß Literaturvorschrift hergestellt und sind in der nachfolgenden Tabelle 6 zusammengefaßt:

**Tabelle 6**

| Monomer | Struktur | Synthese gemäß |
|---|---|---|
| Mon-101-BE | 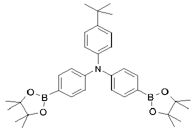 | WO 99/048160 A1 |
| Mon-102-BE | 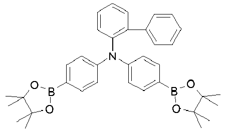 | WO 2013/156130 |
| Mon-102 | 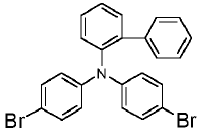 | WO 2013/156130 |
| Mon-103 | 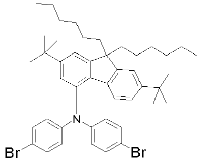 | WO 2013/156130 |
| Mon-103-BE | 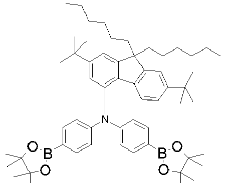 | WO 2013/156130 |
| Mon-104 | 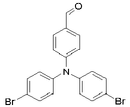 | WO 2010/097155 A1 |
| Mon-104-BE | 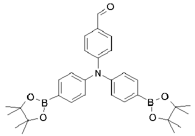 | WO 2010/097155 A1 |
| Mon-105 | 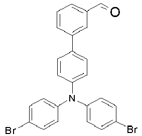 | analog: WO 2013/156130 |
| Mon-106-BE | 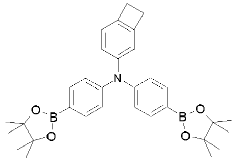 | WO 2009/102027 |
| Mon-107 | 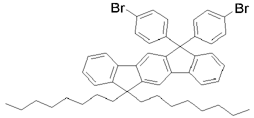 | WO 2010/136111 |
| Mon-1 07-BE | 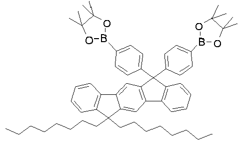 | WO 2010/136111 |
| Mon-108 | 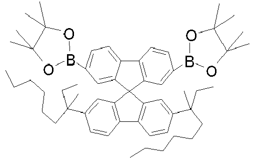 | WO 2003/020790 |
| Mon-109-BE | 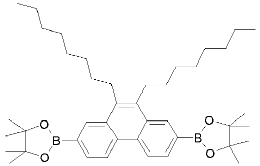 | WO 2005/104264 |
| Mon-110 | 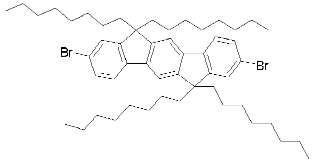 | Macromolecules 2000, 33, 2016-2020 |
| Mon-110-Be | 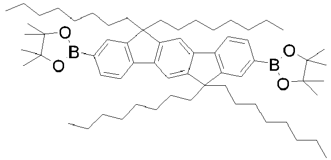 | Macromolecules 2000, 33, 2016-2020 |
| Mon-111 | 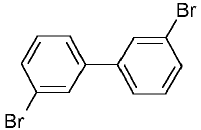 | CAS 16400-51-4 |
| Mon-112 | 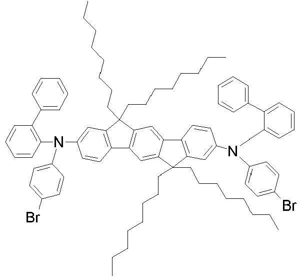 | WO 2013/156125 A1 |

### Teil B: Synthese der Polymere

### Beispiele 21 bis 41

Herstellung der Vergleichspolymere V1, V2 , V3 und V4 sowie der erfindungsgemäßen Polymere Po1 bis Po17.

Die Vergleichspolymere V1, V2, V3 und V4, sowie die erfindungsgemäßen Polymere Po1 bis Po17 werden durch SUZUKI-Kupplung gemäß dem in der WO 03/048225 beschriebenen Verfahren aus den im Teil A offenbarten Monomeren hergestellt.

Die auf diese Weise hergestellten Polymere V1 bis V4 sowie Po1 bis Po17 enthalten die Wiederholungseinheiten nach Abspaltung der Abgangsgruppen in den in der folgenden Tabelle 7 angegebenen prozentualen Anteilen (Prozentangaben = mol%). Bei den Polymeren, die aus Monomeren hergestellt werden, die Aldehydgruppen aufweisen, werden diese nach der Polymerisation durch WITTIG Reaktion gemäß dem in der WO 2010/097155 beschriebenen Verfahren in vernetzbare Vinylgruppen überführt. Die entsprechend in Tabelle 7 aufgeführten sowie im Teil C eingesetzten Polymere weisen somit vernetzbare Vinylgruppen anstelle der ursprünglich vorhandenen Aldehydgruppen auf.

Die Palladium- und Bromgehalte der Polymeren werden per ICP-MS bestimmt. Die ermittelten Werte liegen unter 10 ppm.

Die Molekulargewichte M_{w} sowie die Polydispersitäten D werden mittels Gelpermeationschromatographie (GPC) (Model: Agilent HPLC System Series 1100) ermittelt (Säule: PL-RapidH von Polymer Laboratories; Lösungsmittel: THF mit 0,12 Vol% o-Dichlorbenzol; Detektion: UV und Brechungsindex; Temperatur: 40°C). Kalibriert wird mit Polystyrolstandards.

| Beispiel | Polymer | erfindungsgemäße Monomere | | | | | | weitere Monomere | | | | | | Molekulargew. M_{w} (g/mol) | Polydisp. D |
|---|---|---|---|---|---|---|---|---|---|---|---|---|---|---|---|
| 21 | V1 | | | | | | | Mon-110 | 50% | Mon-101-BE | 50% | | | 145 000 | 2,5 |
| 22 | V2 | | | | | | | Mon-110 | 50% | Mon-101-BE | 40% | Mon-104-BE | 10% | 125 000 | 2,9 |
| 23 | V3 | | | | | | | Mon-110-BE | 25% | Mon-102-BE | 25% | Mon-111 | 50% | 85 000 | 5,3 |
| 24 | V4 | | | | | | | Mon-112 | 50% | Mon-101-BE | 50% | | | 160 000 | 2,3 |
| 25 | Po1 | Mon-1 | 50% | | | | | Mon-101-BE | 50% | | | | | 123 000 | 2,6 |
| 26 | Po2 | Mon-4 | 50% | | | | | Mon-103-BE | 50% | | | | | 153 000 | 3,2 |
| 27 | Po3 | Mon-1 | 50% | | | | | Mon-101-BE | 40% | | | Mon-104-BE | 10% | 98 000 | 3,5 |
| 28 | Po4 | Mon-3 | 50% | | | | | Mon-102-BE | 30% | | | Mon-106-BE | 20% | 180 000 | 2,8 |
| 29 | Po5 | Mon-1-BE | 50% | Mon -9 | 10 % | | | Mon-103 | 40% | | | | | 135 000 | 3,2 |
| 30 | Po6 | Mon-5 | 30% | Mon -6 | 10 % | Mo n-8 | 10 % | Mon-103-BE | 50% | | | | | 155 000 | 2,9 |

| | | | | | | | | | | | | | | | |
|---|---|---|---|---|---|---|---|---|---|---|---|---|---|---|---|
| 31 | Po7 | | | Mon-7 | 10% | | | Mon-101 | 40% | Mon-110-BE | 50% | | | 189 000 | 1,9 |
| 32 | Po8 | | | Mon-10 | 10% | Mon -11 | 10% | Mon-109-BE | 30% | Mon-102-BE | 20% | Mon-102 | 30 % | 220 000 | 2,7 |
| 34 | Po10 | Mon-13-BE | 50% | | | | | Mon-102 | 30% | Mon-105 | 20% | | | 114 000 | 2,5 |
| 35 | Po11 | Mon-14 | 30% | Mon-15 | 20% | | | Mon-108-BE | 50% | | | | | 136 000 | 2,4 |
| 36 | Po12 | Mon-2 | 30% | | | | | Mon-103-BE | 50% | Mon-105 | 20% | | | 163 000 | 2,6 |
| 37 | Po13 | Mon-1-BE | 25% | | | | | Mon-102-BE | 25% | Mon-111 | 50% | | | 74 000 | 4,8 |
| 38 | Po14 | Mon-15 | 25% | Mon-3 | 25% | | | Mon-107-BE | 50% | | | | | 185 000 | 1,8 |
| 39 | Po15 | Mon-13 | 20% | Mon-12 | 25% | | | Mon-107-BE | 50% | | | | | 155 000 | 3,1 |
| 40 | Po16 | Mon-13 | 50% | | | | | Mon-101-BE | 50% | | | | | 195 000 | 2,7 |
| 41 | Po17 | Mon-16 | 50% | | | | | Mon-103-BE | 50% | | | | | 68 000 | 3,2 |

### Teil C: Herstellung der OLEDs

### Beispiele 21 bis 41

Die Vergleichspolymere sowie die erfindungsgemäßen Polymere werden aus Lösung verarbeitet.

Ob die vernetzbaren Varianten der Polymere nach Vernetzung eine vollständig unlösliche Schicht ergeben, wird analog zu der WO 2010/097155 getestet.

In Tabelle 8 ist die verbliebene Schichtdicke der ursprünglich 100 nm nach dem in WO 2010/097155 beschriebenen Waschvorgang aufgeführt. Verringert sich die Schichtdicke nicht, so ist das Polymer unlöslich und somit die Vernetzung ausreichend.

**Tabelle 8:**

| Kontrolle der Restschichtdicke von ursprünglich 100 nm nach Waschtest | |
|---|---|
| Polymer | Restschichtdicke nach Waschtest [in nm] Vernetzung bei 220°C für 30 Minuten |
| V1 | 22,5 |
| V2 | 99 |
| Po3 | 99,5 |
| Po5 | 98 |
| Po10 | 98,5 |
| Po12 | 99 |

Wie Tabelle 8 zu entnehmen ist, vernetzt das Vergleichspolymer V1, das keine Vernetzungsgruppe trägt, bei Ausheizen bei 220°C für 30 Minuten fast gar nicht. Das Vergleichspolymer V2 sowie die erfindungsgemäßen Polymere Po3, Po5, Po10 und Po12 vernetzen bei 220°C vollständig.

Die Herstellung lösungsbasierter OLEDs ist in der Literatur bereits vielfach beschrieben, z.B. in der WO 2004/037887 und der WO 2010/097155. Das Verfahren wird auf die im Folgenden beschriebenen Gegebenheiten (Schichtdickenvariation, Materialien) angepasst.

Die erfindungsgemäßen Polymere werden in zwei verschiedenen Schichtabfolgen verwendet:
Aufbau A ist wie folgt:
   - Substrat,
   - ITO (50 nm),
   - PEDOT :PSS (20 nm),
   - Lochtransportschicht (HTL) (20 nm),
   - Emissionsschicht (EML) (60 nm),
   - Lochblockierschicht (HBL) (10 nm)
   - Elektronentransportschicht (ETL) (40 nm),
   - Kathode.
Aufbau B ist wie folgt:
   - Substrat,
   - ITO (50 nm),
   - PEDOT:PSS (20 nm),
   - Lochtransportschicht (HTL) (40 nm),
   - Emissionsschicht (EML) (30 nm),
   - Elektronentransportschicht (ETL) (20 nm),
   - Kathode.

Als Substrat dienen Glasplättchen, die mit strukturiertem ITO (Indium-ZinnOxid) der Dicke 50 nm beschichtet sind. Diese werden mit PEDOT:PSS beschichtet. Das Aufschleudern erfolgt an Luft aus Wasser. Die Schicht wird für 10 Minuten bei 180°C ausgeheizt. PEDOT:PSS wird bezogen von Heraeus Precious Metals GmbH & Co. KG, Deutschland. Auf diese beschichteten Glasplättchen werden die Lochtransport- sowie die Emissionsschicht aufgebracht.

Als Lochtransportschicht werden die erfindungsgemäßen Verbindungen sowie Vergleichsverbindungen verwendet, jeweils in Toluol gelöst. Der typische Feststoffgehalt solcher Lösungen liegt bei ca. 5 g/l, wenn, wie hier, die für eine Device typische Schichtdicken von 20 bzw. 40 nm mittels Spincoating erzielt werden soll. Die Schichten werden in einer Inertgasatmosphäre, im vorliegenden Fall Argon, aufgeschleudert und für 30 Minuten bei 220°C im Fall der vernetzten Polymere (Aufbau A) und 10 Minuten bei 180°C im Fall der unvernetzten Polymere (Aufbau B) ausgeheizt.

Die Emissionsschicht setzt sich immer aus mindestens einem Matrixmaterial (Hostmaterial, Wirtsmaterial) und einem emittierenden Dotierstoff (Dotand, Emitter) zusammen. Weiterhin aufreten können Mischungen aus mehreren Matrixmaterialien sowie Co-Dotanden. Eine Angabe wie H1 (92%) : Dotand (8%) bedeutet hierbei, dass das Material H1 in einem Gewichtsanteil von 92% und der Dotand in einem Gewichtsanteil von 8% in der Emissionsschicht vorliegt. Die Mischung für die Emissionsschicht wird für Aufbau A in Toluol gelöst. Der typische Feststoffgehalt solcher Lösungen liegt bei ca. 18 g/l, wenn, wie hier, die für eine Device typische Schichtdicke von 60 nm mittels Spincoating erzielt werden soll. Die Schichten werden in Inertgasatmosphäre, im vorliegenden Fall Argon, aufgeschleudert und 10 Minuten bei 150°C ausgeheizt.

In Aufbau B wird die Emissionsschicht durch thermische Verdampfung in einer Vakuumkammer gebildet. Dabei kann die Schicht aus mehr als einem Material bestehen, die einander durch Co-Verdampfung in einem bestimmten Volumenanteil beigemischt werden. Eine Angabe wie H3:Dotand (95%:5%) bedeutet hierbei, dass die Materialien H3 und Dotand in einem Volumenanteil von 95%:5% in der Schicht vorliegen.

Die im vorliegenden Fall verwendeten Materialien sind in Tabelle 9 gezeigt.

**Tabelle 9:**

| Strukturformeln der in der Emissionsschicht verwendeten Materialien | |
|---|---|
| 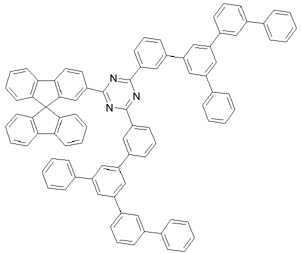 | 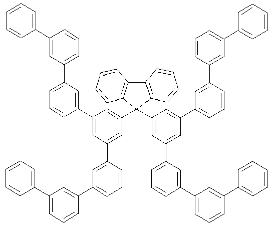 |
| H1 | H2 |
| 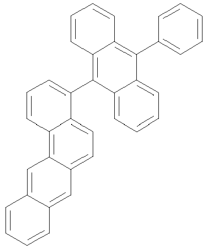 | |
| H3 | |
| 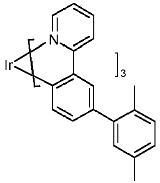 | 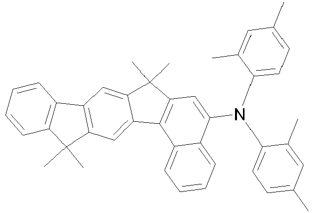 |
| TEG | SEB |

Die Materialien für die Lochblockierschicht und Elektronentransportschicht werden ebenfalls in einer Vakuumkammer thermisch aufgedampft und sind in Tabelle 10 gezeigt. Die Lochblockierschicht besteht aus ETM1. Die Elektronentransportschicht besteht aus den zwei Materialien ETM1 und ETM2, die einander durch Co-Verdampfung in einem Volumenanteil von jeweils 50% beigemischt werden.

**Tabelle 10:**

| Verwendete HBL- und ETL-Materialien | |
|---|---|
| 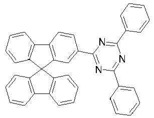 | 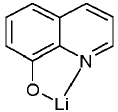 |
| ETM1 | ETM2 |

Die Kathode wird durch die thermische Verdampfung einer 100 nm dicken Aluminiumschicht gebildet.

Der genaue Aufbau der OLEDs ist Tabelle 11 zu entnehmen.

**Tabelle 11:**

| Aufbau der OLEDs | | | |
|---|---|---|---|
| Beispiel | HTL Polymer | Aufbau | EML Zusammensetzung |
| 42 | V1 | B | H3 95%; SEB 5% |
| 43 | V2 | A | H1 30%; H2 55%; TEG 15% |
| 44 | V3 | B | H3 95%; SEB 5% |
| 45 | Po3 | A | H1 30%; H2 55%; TEG 15% |
| 46 | Po5 | A | H1 30%; H2 55%; TEG 15% |
| 47 | Po10 | A | H1 30%; H2 55%; TEG 15% |
| 48 | Po12 | A | H1 30%; H2 55%; TEG 15% |
| 49 | Po13 | B | H3 95%; SEB 5% |

Die OLEDs werden standardmäßig charakterisiert. Hierfür werden die Elektrolumineszenzspektren, Strom-Spannungs-Leuchtdichte-Kennlinien (IUL-Kennlinien) unter Annahme einer Lambert'schen Abstrahlcharakteristik sowie die (Betriebs-)Lebensdauer bestimmt. Aus den IUL-Kennlinien werden Kennzahlen bestimmt wie die Betriebsspannung (in V) und die externe Quanteneffizienz (in %) bei einer bestimmten Helligkeit. LD80 @ 1000 cd/m² ist die Lebensdauer, bis die OLED bei einer Starthelligkeit von 1000 cd/m² auf 80 % der Anfangsintensität, also auf 800 cd/m², abgefallen ist.

Die Eigenschaften der verschiedenen OLEDs sind in den Tabellen 12a und 12b zusammengefasst. Die Beispiele 42 und 44 zeigen Vergleichsbauteile, alle anderen Beispiele zeigen Eigenschaften von erfindungsgemäßen OLEDs.

Tabellen 12a und 12b:
Eigenschaften der OLEDs

**Tabelle 12a**

| Beispiel | Effizienz bei 1000 cd/m² | Spannung bei 1000 cd/m² | LD80 bei 10000 cd/m² |
|---|---|---|---|
| | % EQE | [V] | [h] |
| 42 | 4.9 | 4.5 | 120 |
| 44 | 8.0 | 4.6 | 160 |
| 49 | 9.7 | 4.8 | 160 |

**Tabelle 12b**

| Beispiel | Effizienz bei 1000 cd/m² | Spannung bei 1000 cd/m² | LD80 bei 1000 cd/m² |
|---|---|---|---|
| | % EQE | [V] | [h] |
| 43 | 17.0 | 4.2 | 110 |
| 45 | 18.8 | 4.3 | 125 |
| 46 | 18.9 | 4.2 | 130 |
| 47 | 17.9 | 3.9 | 260 |
| 48 | 18.1 | 3.8 | 230 |

Wie die Tabellen 12a und 12b zeigen, ergeben die erfindungsgemäßen Polymere bei Einsatz als Lochtransportschicht in OLEDs Verbesserungen gegenüber dem Stand der Technik. Durch ihr höheres Triplett-Niveau und die größere Bandlücke sind vor allem die Effizienzen der hergestellten grün und blau emittierenden OLEDs verbessert.

Dass die erfindungsgemäßen Polymere ein höheres Triplett-Level haben als ihre direkten Vergleichspolymere, zeigen quantenmechanische Berechnungen anhand einiger ausgewählten Polymere. Die Ergebnisse sind in Tabelle 13 gezeigt.

**Tabelle 13: Vergleich der gerechneten T1 Level**

| Polymer | V1 | Po1 | Po2 | V2 | Po3 | V3 | Po13 | V4 | Po16 |
|---|---|---|---|---|---|---|---|---|---|
| T1 (eV) | 2,31 | 2,43 | 2,49 | 2,31 | 2,45 | 2,38 | 2,52 | 2,31 | 2,45 |

## Patentansprüche

1. Polymer, das 1 bis 100 mol% mindestens einer Wiederholungseinheit der folgenden Formel (la) aufweist: 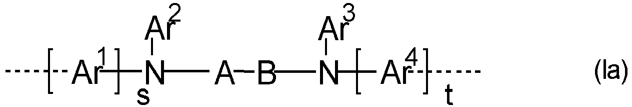 wobei
A ein polycyclisches, aromatisches oder heteroaromatisches Ringsystem mit 10 bis 30 aromatischen oder heteroaromatischen Ringatomen ist, das mit einem oder mehreren Resten R substituiert sein kann,
B ein mono- oder polycyclisches, aromatisches oder heteroaromatisches Ringsystem mit 5 bis 10 aromatischen oder heteroaromatischen Ringatomen ist, das mit einem oder mehreren Resten R substituiert sein kann, wobei die Anzahl der aromatischen oder heteroaromatischen Ringatome von A größer ist als die Anzahl der aromatischen oder heteroaromatischen Ringatome von B,
Ar¹, Ar², Ar³ und Ar⁴ bei jedem Auftreten, jeweils gleich oder verschieden, ein mono- oder polycyclisches, aromatisches oder heteroaromatisches Ringsystem mit 5 bis 60 aromatischen Ringatomen ist, das mit einem oder mehreren Resten R substituiert sein kann,
s und t, jeweils gleich oder verschieden, 0 oder 1 sind,
R bei jedem Auftreten gleich oder verschieden H, eine geradkettige Alkyl- oder Alkoxygruppe mit 1 bis 10 C-Atomen oder eine Alkenyl- oder Alkinylgruppe mit 2 bis 10 C-Atomen oder eine verzweigte oder cyclische Alkyl- oder Alkoxygruppe mit 3 bis 10 C-Atomen, die jeweils mit einem oder mehreren Resten R¹ substituiert sein kann, wobei eine oder mehrere nicht benachbarte CH₂-Gruppen durch R'C=CR', C=O, C=NR¹, NR¹, O oder CONR¹ ersetzt sein können, oder ein aromatisches oder heteroaromatisches Ringsystem mit 5 bis 20 aromatischen Ringatomen, das jeweils durch einen oder mehrere Reste R¹ substituiert sein kann, oder eine Aryloxy- oder Heteroaryloxy-gruppe mit 5 bis 20 aromatischen Ringatomen, die durch einen oder mehrere Reste R¹ substituiert sein kann, oder eine Aralkyl- oder Heteroaralkylgruppe mit 5 bis 20 aromatischen Ringatomen, die durch einen oder mehrere Reste R¹ substituiert sein kann, oder eine Diarylaminogruppe, Diheteroarylaminogruppe oder Arylheteroarylaminogruppe mit 10 bis 20 aromatischen Ringatomen, welche durch einen oder mehrere Reste R¹ substituiert sein kann, oder eine vernetzbare Gruppe Q, wobei zwei oder mehrere Reste R auch miteinander ein mono- oder polycyclisches, aliphatisches, aromatisches und/oder benzoannelliertes Ringsystem bilden können;
R¹ bei jedem Auftreten gleich oder verschieden H, D, F oder ein aliphatischer Kohlenwasserstoffrest mit 1 bis 20 C-Atomen, ein aromatischer und/oder ein heteroaromatischer Kohlenwasserstoffrest mit 5 bis 20 C-Atomen ist, in dem auch ein oder mehrere H-Atome durch F ersetzt sein können; wobei zwei oder mehrere Substituenten R¹ auch miteinander ein mono- oder polycyclisches, aliphatisches, aromatisches oder heteroaromatisches Ringsystem bilden können;
Q eine endständige oder cyclische Alkenylgruppe, eine endständige Dienyl- oder Alkinylgruppe, eine Alkenyloxy-, Dienyloxy- oder Alkinyloxygruppe, eine Acrylsäuregruppe, eine Oxetan- oder Oxirangruppe, eine Silangruppe oder eine Cyclobutangruppe ist, und
die gestrichelten Linien Bindungen zu benachbarten Wiederholungseinheiten im Polymer darstellen.

2. Polymer nach Anspruch 1, **dadurch gekennzeichnet, dass** das polycyclische, aromatische oder heteroaromatische Ringsystem A in den Wiederholungseinheiten der Formel (la) ausgewählt ist aus den folgenden Einheiten A1 bis A8:
| | |
|---|---|
| 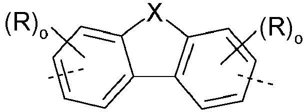 | 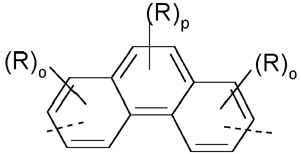 |
| A1 | A2 |
| 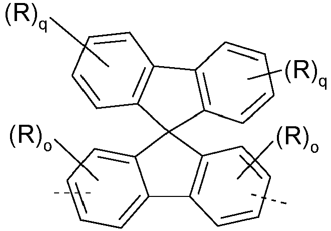 | 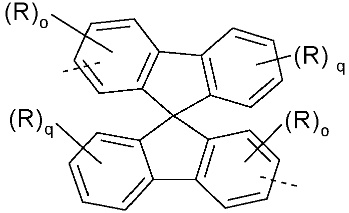 |
| A3 | A4 |
| 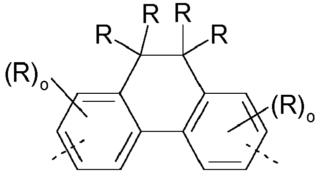 | 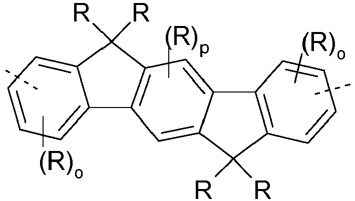 |
| A5 | A6 |
| 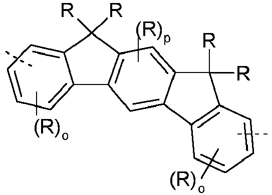 | 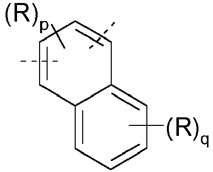 |
| A7 | A8 |
wobei R die in Anspruch 1 angegebenen Bedeutungen annehmen kann,
X = CR², NR, SiR², O, S, C=O oder P=O ist,
o = 0, 1,2 oder 3 ist,
p = 0, 1 oder 2 ist, und
q = 0, 1, 2, 3 oder 4 ist.

3. Polymer nach Anspruch 1 oder 2, **dadurch gekennzeichnet, dass** das mono- oder polycyclische, aromatische oder heteroaromatische Ringsystem B in den Wiederholungseinheiten der Formel (la) ausgewählt ist aus den folgenden Einheiten B1 bis B4:
| | |
|---|---|
| 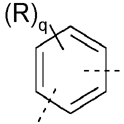 | 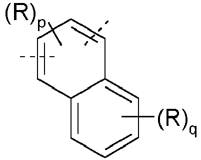 |
| B1 | B2 |
| 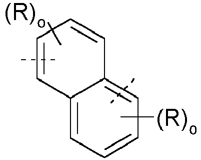 | 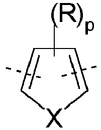 |
| B3 | B4 |
wobei R, o, p, q und X die in Anspruch 2 in Bezug auf die Ringsysteme A angegebenen Bedeutungen annehmen können.

4. Polymer nach einem oder mehreren der Ansprüche 1 bis 3, **dadurch gekennzeichnet, dass** die mono- oder polycyclischen, aromatischen oder heteroaromatischen Ringsysteme Ar² und Ar³ in den Wiederholungseinheiten der Formel (la) ausgewählt sind aus den folgenden Einheiten Ar1 bis Ar10:
| | |
|---|---|
| 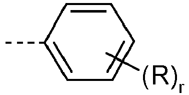 | 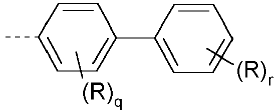 |
| Ar1 | Ar2 |
| 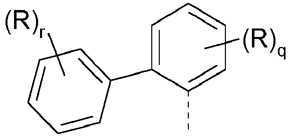 | 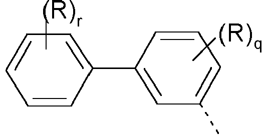 |
| Ar3 | Ar4 |
| 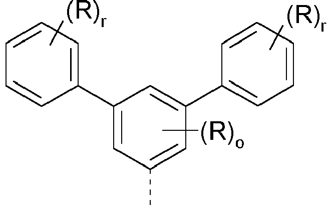 | 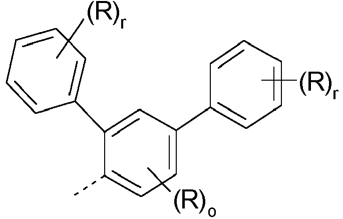 |
| Ar5 | Ar6 |
| 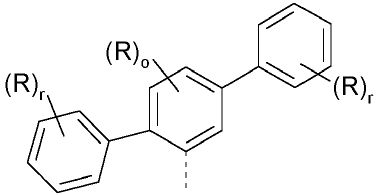 | 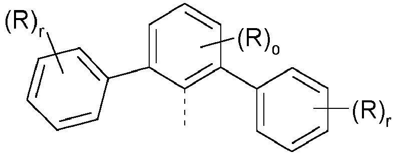 |
| Ar7 | Ar8 |
| 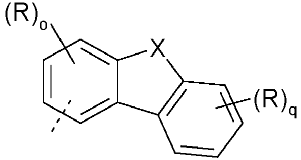 | 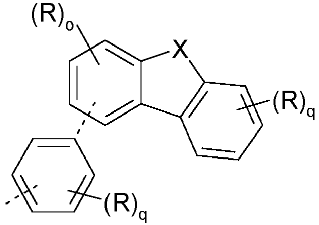 |
| Ar9 | Ar10 |
wobei R, o, q und X die in Anspruch 2 in Bezug auf die Ringsysteme A angegebenen Bedeutungen annehmen können, und
r = 0, 1, 2, 3, 4 oder 5 ist.

5. Polymer nach einem oder mehreren der Ansprüche 1 bis 4, **dadurch gekennzeichnet, dass** die mono- oder polycyclischen, aromatischen oder heteroaromatischen Ringsysteme Ar¹ und Ar⁴ in den Wiederholungseinheiten der Formel (la) ausgewählt sind aus den folgenden Einheiten Ar11 bis Ar20:
| | |
|---|---|
| 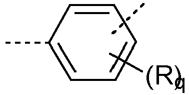 | 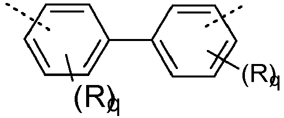 |
| Ar11 | Ar12 |
| 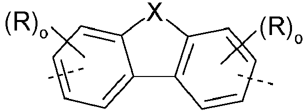 | 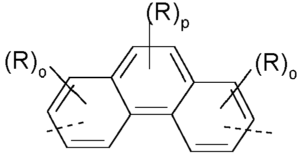 |
| Ar13 | Ar14 |
| 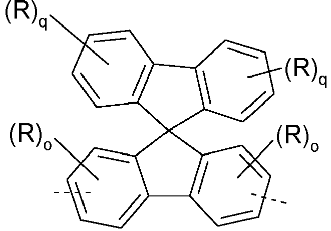 | 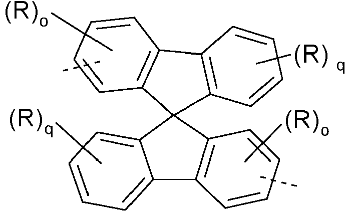 |
| Ar15 | Ar16 |
| 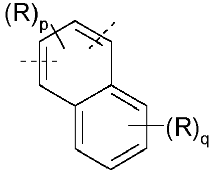 | 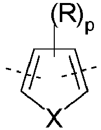 |
| Ar17 | Ar18 |
wobei R, o, q, p und X die in Anspruch 2 in Bezug auf die Ringsysteme A angegebenen Bedeutungen annehmen können.

6. Polymer nach einem oder mehreren der Ansprüche 1 bis 5, **dadurch gekennzeichnet, dass** der Anteil an Wiederholungseinheiten der Formel (la) im Polymer im Bereich von 50 bis 95 mol% liegt, bezogen auf 100 mol% aller copolymerisierbaren Monomere, die im Polymer als Wiederholungseinheiten enthalten sind.

7. Polymer nach einem oder mehreren der Ansprüche 1 bis 6, **dadurch gekennzeichnet, dass** das Polymer neben Wiederholungseinheiten der Formel (la) noch weitere, von den Wiederholungseinheiten der Formel (la) verschiedene Wiederholungseinheiten aufweist.

8. Polymer nach einem oder mehreren der Ansprüche 1 bis 7, **dadurch gekennzeichnet, dass** das Polymere neben einer oder mehrerer Wiederholungseinheiten der Formel (la) sowie gegebenenfalls weiteren Wiederholungseinheiten noch mindestens eine Wiederholungseinheit, aufweist, die mindestens eine vernetzbare Gruppe Q aufweist, wobei Q die in Anspruch 1 angegebenen Bedeutungen annehmen kann.

9. Polymer nach Anspruch 8, **dadurch gekennzeichnet, dass** die Struktureinheit, die die mindestens eine vernetzbare Gruppe aufweist, ausgewählt ist aus den Wiederholungseinheiten der Formeln (IIIa) bis (IIIf) 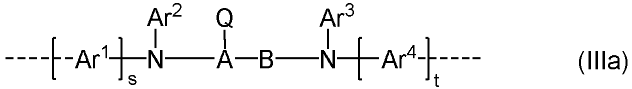 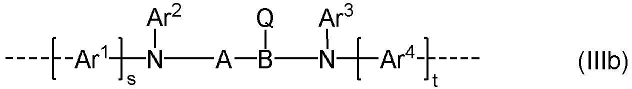 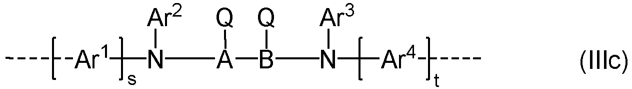 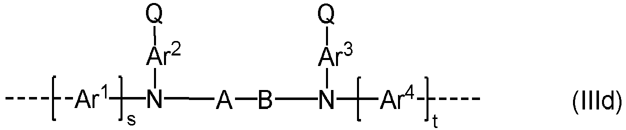 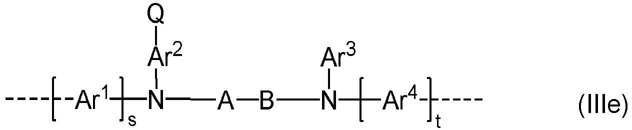 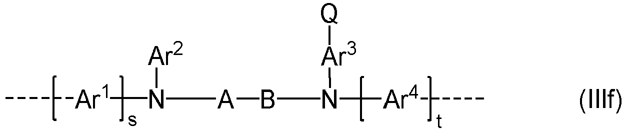 wobei A, B, Ar¹, Ar², Ar³, Ar⁴, Q, s und t die in Anspruch 1 in Bezug auf Formel (la) angegebenen Bedeutungen annehmen können.

10. Verfahren zur Herstellung eines Polymeren nach einem oder mehreren der Ansprüche 1 bis 9, **dadurch gekennzeichnet, dass** es durch Polymerisation gemäß SUZUKI, Polymerisation gemäß YAMAMOTO, Polymerisation gemäß STILLE oder Polymerisation gemäß HARTWIG-BUCHWALD hergestellt wird.

11. Polymer Blend enthaltend ein oder mehrere Polymere nach einem oder mehreren der Ansprüche 1 bis 9, welche mindestens eine Wiederholungseinheit der Formel (la) enthalten, sowie eine oder mehrere weitere polymere, oligomere, dendritische und/oder niedermolekulare Substanzen.

12. Lösungen oder Formulierungen aus einem oder mehreren Polymeren nach einem oder mehreren der Ansprüche 1 bis 9 oder einem Polymer Blend nach Anspruch 11 in einem oder mehreren Lösungsmitteln.

13. Verwendung eines Polymeren nach einem oder mehreren der Ansprüche 1 bis 9 in organischen Elektrolumineszenzvorrichtungen (OLED), organischen lichtemittierenden elektrochemischen Zellen (OLEC), organischen Feld-Effekt-Transistoren (OFET), organischen integrierten Schaltungen (O-IC), organischen Dünnfilmtransistoren (TFT), organischen Solarzellen (O-SC), organischen Laserdioden (O-Laser), organischen photovoltaischen (OPV) Elementen oder Vorrichtungen oder organischen Photorezeptoren (OPC.

14. Organische Elektrolumineszenzvorrichtungen (OLED), organische lichtemittierende elektrochemische Zellen (OLEC), organische Feld-Effekt-Transistoren (OFET), organische integrierte Schaltungen (O-IC), organische Dünnfilmtransistoren (TFT), organische Solarzellen (O-SC), organische Laserdioden (O-Laser), organische photovoltaische (OPV) Elemente oder Vorrichtungen und organische Photorezeptoren (OPC), mit einer oder mehreren aktiven Schichten, wobei mindestens eine dieser aktiven Schichten ein oder mehrere Polymere nach einem oder mehreren der Ansprüche 1 bis 9 enthält.

## Claims

1. Polymer which contains 1 to 100 mol% of at least one recurring unit of the following formula (Ia): 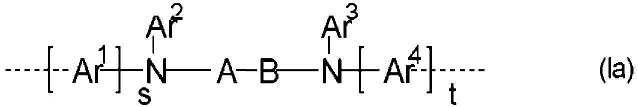 where
A is a polycyclic, aromatic or heteroaromatic ring system having 10 to 30 aromatic or heteroaromatic ring atoms, which may be substituted by one or more radicals R,
B is a mono- or polycyclic, aromatic or heteroaromatic ring system having 5 to 10 aromatic or heteroaromatic ring atoms, which may be substituted by one or more radicals R, where the number of aromatic or heteroaromatic ring atoms of A is greater than the number of aromatic or heteroaromatic ring atoms of B,
Ar¹, Ar², Ar³ and Ar⁴ are on each occurrence, in each case identically or differently, a mono- or polycyclic, aromatic or heteroaromatic ring system having 5 to 60 aromatic ring atoms, which may be substituted by one or more radicals R,
s and t are, in each case identically or differently, 0 or 1,
R is on each occurrence, identically or differently, H, a straightchain alkyl or alkoxy group having 1 to 10 C atoms or an alkenyl or alkynyl group having 2 to 10 C atoms or a branched or cyclic alkyl or alkoxy group having 3 to 10 C atoms, which may in each case be substituted by one or more radicals R¹, where one or more non-adjacent CH₂ groups may be replaced by R¹C=CR¹, C=O, C=NR¹, NR¹, O or CONR¹, or an aromatic or heteroaromatic ring system having 5 to 20 aromatic ring atoms, which may in each case be substituted by one or more radicals R¹, or an aryloxy or heteroaryloxy group having 5 to 20 aromatic ring atoms, which may be substituted by one or more radicals R¹, or an aralkyl or heteroaralkyl group having 5 to 20 aromatic ring atoms, which may be substituted by one or more radicals R¹, or a diarylamino group, diheteroarylamino group or arylheteroarylamino group having 10 to 20 aromatic ring atoms, which may be substituted by one or more radicals R¹, or a crosslinkable group Q, where two or more radicals R may also form a mono- or polycyclic, aliphatic, aromatic and/or benzo-fused ring system with one another;
R¹ is on each occurrence, identically or differently, H, D, F or an aliphatic hydrocarbon radical having 1 to 20 C atoms, an aromatic and/or heteroaromatic hydrocarbon radical having 5 to 20 C atoms, in which, in addition, one or more H atoms may be replaced by F; where two or more substituents R¹ may also form a mono- or polycyclic, aliphatic, aromatic or heteroaromatic ring system with one another;
Q is a terminal or cyclic alkenyl group, a terminal dienyl or alkynyl group, an alkenyloxy, dienyloxy or alkynyloxy group, an acrylic acid group, an oxetane or oxirane group, a silane group or a cyclobutane group, and
the dashed lines represent bonds to adjacent recurring units in the polymer.

2. Polymer according to Claim 1, **characterised in that** the polycyclic, aromatic or heteroaromatic ring system A in the recurring units of the formula (Ia) is selected from the following units A1 to A8:
| | |
|---|---|
| 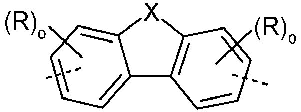 | 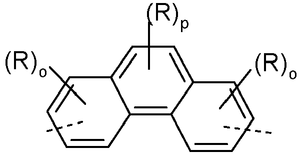 |
| A1 | A2 |
| 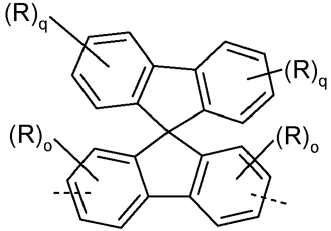 | 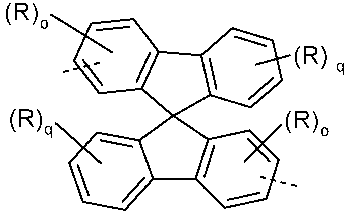 |
| A3 | A4 |
| 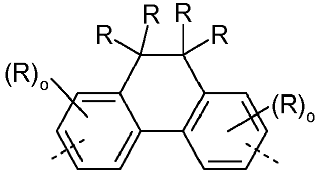 | 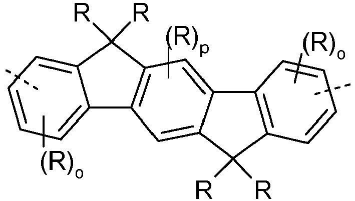 |
| A5 | A6 |
| 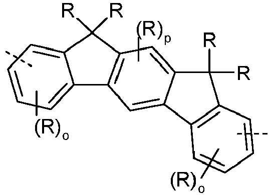 | 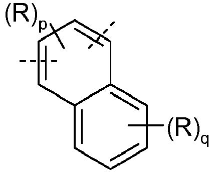 |
| A7 | A8 |
where R can adopt the meanings indicated in Claim 1,
X = CR², NR, SiR², O, S, C=O or P=O,
o = 0, 1, 2 or 3,
p = 0, 1 or 2, and
q = 0, 1, 2, 3 or 4.

3. Polymer according to Claim 1 or 2, **characterised in that** the mono- or polycyclic, aromatic or heteroaromatic ring system B in the recurring units of the formula (Ia) is selected from the following units B1 to B4:
| | |
|---|---|
| 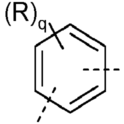 | 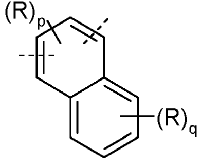 |
| B1 | B2 |
| 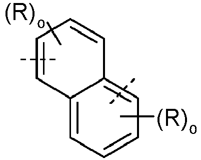 | 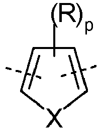 |
| B3 | B4 |
where R, o, p, q and X can adopt the meanings indicated in Claim 2 in relation to the ring systems A.

4. Polymer according to one or more of Claims 1 to 3, **characterised in that** the mono- or polycyclic, aromatic or heteroaromatic ring systems Ar² and Ar³ in the recurring units of the formula (Ia) are selected from the following units Ar1 to Ar10:
| | |
|---|---|
| 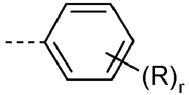 | 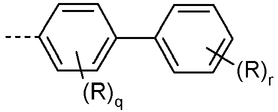 |
| Ar1 | Ar2 |
| 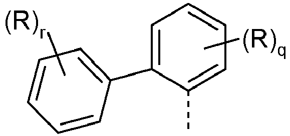 | 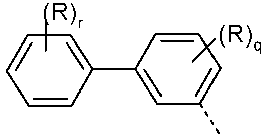 |
| Ar3 | Ar4 |
| | |
|---|---|
| 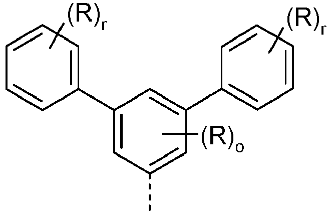 | 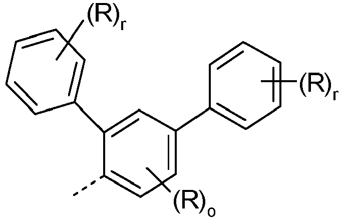 |
| Ar5 | Ar6 |
| 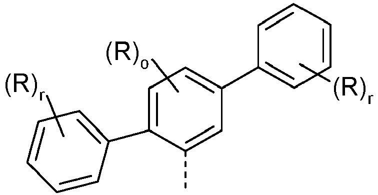 | 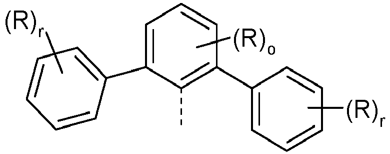 |
| Ar7 | Ar8 |
| 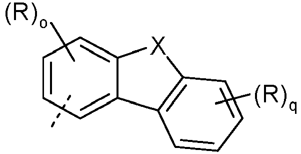 | 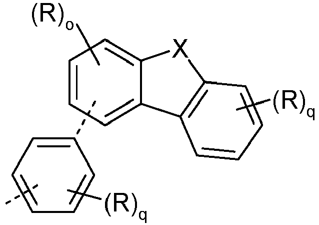 |
| Ar9 | Ar10 |
where R, o, q and X can adopt the meanings indicated in Claim 2 in relation to the ring systems A, and
r = 0, 1, 2, 3, 4 or 5.

5. Polymer according to one or more of Claims 1 to 4, **characterised in that** the mono- or polycyclic, aromatic or heteroaromatic ring systems Ar¹ and Ar⁴ in the recurring units of the formula (Ia) are selected from the following units Ar11 to Ar18:
| | |
|---|---|
| 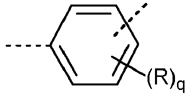 | 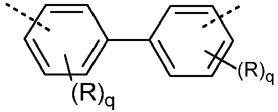 |
| Ar11 | Ar12 |
| 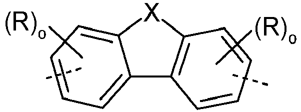 | 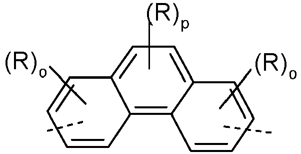 |
| Ar13 | Ar14 |
| 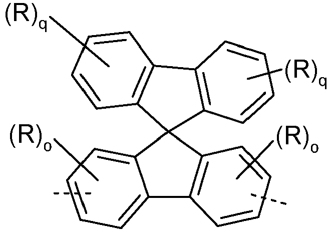 | 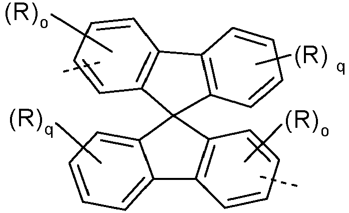 |
| Ar15 | Ar16 |
| 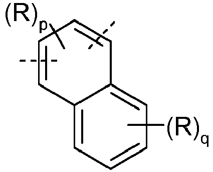 | 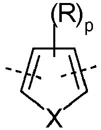 |
| Ar17 | Ar18 |
where R, o, q, p and X can adopt the meanings indicated in Claim 2 in relation to the ring systems A.

6. Polymer according to one or more of Claims 1 to 5, **characterised in that** the proportion of recurring units of the formula (Ia) in the polymer is in the range from 50 to 95 mol%, based on 100 mol% of all copolymerisable monomers present as recurring units in the polymer.

7. Polymer according to one or more of Claims 1 to 6, **characterised in that**, besides recurring units of the formula (Ia), the polymer also contains further recurring units that are different from the recurring units of the formula (Ia).

8. Polymer according to one or more of Claims 1 to 7, **characterised in that**, besides one or more recurring units of the formula (Ia) and optionally further recurring units, the polymer also contains at least one recurring unit that contains at least one crosslinkable group Q, where Q can adopt the meanings indicated in Claim 1.

9. Polymer according to Claim 8, **characterised in that** the structural unit that contains the at least one crosslinkable group is selected from the recurring units of the formulae (IIIa) to (IIIf) 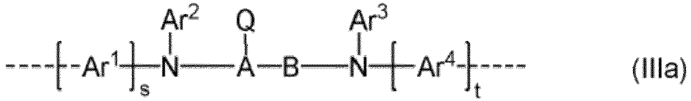 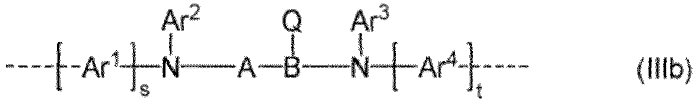 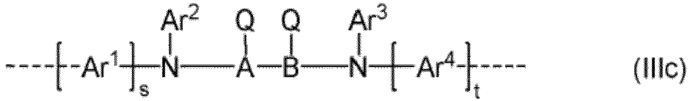 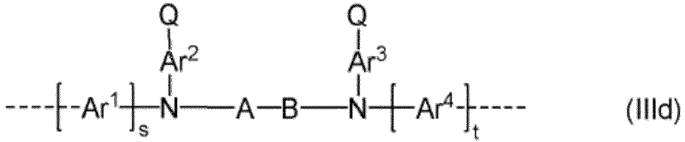 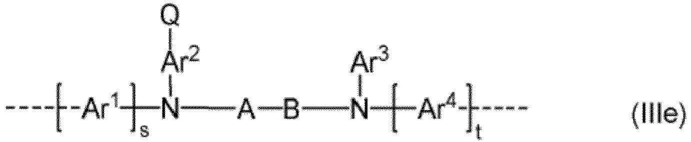 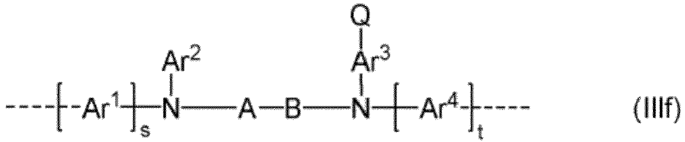 where A, B, Ar¹, Ar², Ar³, Ar⁴, Q, s and t can adopt the meanings indicated in Claim 1 relation to formula (Ia).

10. Process for the preparation of a polymer according to one or more of Claims 1 to 9, **characterised in that** it is prepared by SUZUKI polymerisation, YAMAMOTO polymerisation, STILLE polymerisation or HARTWIG-BUCHWALD polymerisation.

11. Polymer blend comprising one or more polymers according to one or more of Claims 1 to 9 which contain at least one recurring unit of the formula (Ia), and one or more further polymeric, oligomeric, dendritic and/or low-molecular-weight substances.

12. Solutions or formulations of one or more polymers according to one or more of Claims 1 to 9 or a polymer blend according to Claim 11 in one or more solvents.

13. Use of a polymer according to one or more of Claims 1 to 9 in organic electroluminescent devices (OLEDs), organic light-emitting electrochemical cells (OLECs), organic field-effect transistors (OFETs), organic integrated circuits (O-ICs), organic thin-film transistors (TFTs), organic solar cells (O-SCs), organic laser diodes (O-lasers), organic photovoltaic (OPV) elements or devices or organic photoreceptors (OPCs).

14. Organic electroluminescent devices (OLEDs), organic light-emitting electrochemical cells (OLECs), organic field-effect transistors (OFETs), organic integrated circuits (O-ICs), organic thin-film transistors (TFTs), organic solar cells (O-SCs), organic laser diodes (O-lasers), organic photovoltaic (OPV) elements or devices and organic photoreceptors (OPCs), having one or more active layers, where at least one of these active layers comprises one or more polymers according to one or more of Claims 1 to 9.

## Revendications

1. Polymère qui contient de 1 à 100% molaire d'au moins un motif récurrent de formule (la) suivante : 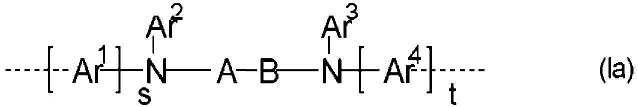 dans laquelle
A est un noyau polycyclique, aromatique ou hétéroaromatique ayant de 10 à 30 atomes de cycle aromatique ou hétéroaromatique, qui peut être substitué par un ou plusieurs radicaux R,
B est un noyau mono- ou polycyclique, aromatique ou hétéroaromatique ayant de 5 à 10 atomes de cycle aromatique ou hétéroaromatique, qui peut être substitué par un ou plusieurs radicaux R, où le nombre d'atomes de cycle aromatique ou hétéroaromatique de A est supérieur au nombre d'atomes de cycle aromatique ou hétéroaromatique de B,
Ar¹, Ar², Ar³ et Ar⁴ sont à chaque occurrence, dans chaque cas de manière identique ou différente, un noyau mono- ou polycyclique, aromatique ou hétéroaromatique ayant de 5 à 60 atomes de cycle aromatique, qui peut être substitué par un ou plusieurs radicaux R,
s et t valent, dans chaque cas de manière identique ou différente, 0 ou 1,
R est à chaque occurrence, de manière identique ou différente, H, un groupement alkyle ou alcoxy à chaîne linéaire ayant de 1 à 10 atomes de C ou un groupement alcényle ou alcynyle ayant de 2 à 10 atomes de C ou un groupement alkyle ou alcoxy ramifié ou cyclique ayant de 3 à 10 atomes de C, qui peut dans chaque cas être substitué par un ou plusieurs radicaux R¹, où un ou plusieurs groupements CH₂ non adjacents peuvent être remplacés par R¹C=CR¹, C=O, C=NR¹, NR¹, O ou CONR¹, ou un noyau aromatique ou hétéroaromatique ayant de 5 à 20 atomes de cycle aromatique, qui peut dans chaque cas être substitué par un ou plusieurs radicaux R¹, ou un groupement aryloxy ou hétéroaryloxy ayant de 5 à 20 atomes de cycle aromatique, qui peut être substitué par un ou plusieurs radicaux R¹, ou un groupement aralkyle ou hétéroaralkyle ayant de 5 à 20 atomes de cycle aromatique, qui peut être substitué par un ou plusieurs radicaux R¹, ou un groupement diarylamino, un groupement dihétéroarylamino ou un groupement arylhétéroarylamino ayant de 10 à 20 atomes de cycle aromatique, qui peut être substitué par un ou plusieurs radicaux R¹, ou un groupement réticulable Q, où deux, ou plus, radicaux R peuvent également former un noyau monoou polycyclique, aliphatique, aromatique et/ou benzocondensé les uns avec les autres ;
R¹ est à chaque occurrence, de manière identique ou différente, H, D, F ou un radical hydrocarboné aliphatique ayant de 1 à 20 atomes de C, un radical hydrocarboné aromatique et/ou hétéroaromatique ayant de 5 à 20 atomes de C, dans lequel, de plus, un ou plusieurs atomes de H peuvent être remplacés par F ; où deux, ou plus, substituants R¹ peuvent également former un noyau mono- ou polycyclique, aliphatique, aromatique ou hétéroaromatique les uns avec les autres ;
Q est un groupement alcényle terminal ou cyclique, un groupement diényle ou alcynyle terminal, un groupement alcényloxy, diényloxy ou alcynyloxy, un groupement acide acrylique, un groupement oxétane ou oxirane, un groupement silane ou un groupement cyclobutane, et
les lignes en pointillés représentent des liaisons à des motifs récurrents adjacents dans le polymère.

2. Polymère selon la revendication 1, **caractérisé en ce que** le noyau polycyclique, aromatique ou hétéroaromatique A dans les motifs récurrents de formule (la) est choisi parmi les motifs A1 à A8 suivants :
| | |
|---|---|
| 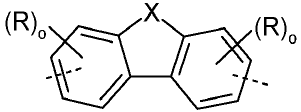 | 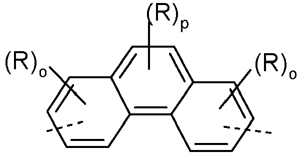 |
| A1 | A2 |
| 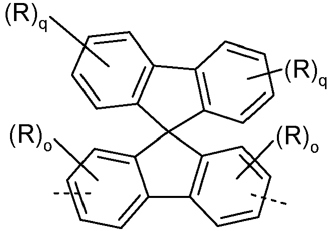 | 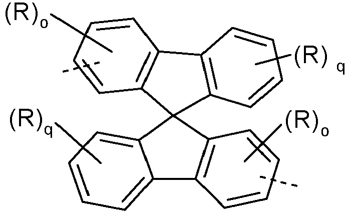 |
| A3 | A4 |
| 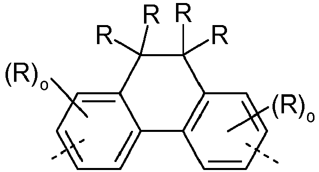 | 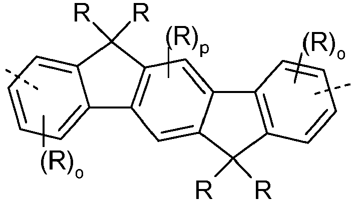 |
| A5 | A6 |
| 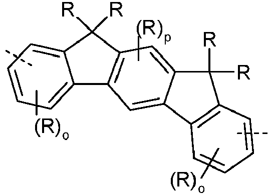 | 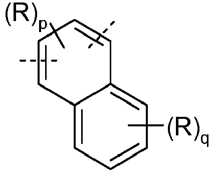 |
| A7 | A8 |
où R peut adopter les significations indiquées selon la revendication 1,
X = CR², NR, SiR², O, S, C=O ou P=O,
o = 0, 1, 2 ou 3,
p = 0, 1 ou 2, et
q = 0, 1, 2, 3 ou 4.

3. Polymère selon la revendication 1 ou 2, **caractérisé en ce que** le noyau mono- ou polycyclique, aromatique ou hétéroaromatique B dans les motifs récurrents de formule (la) est choisi parmi les motifs B1 à B4 suivants :
| | |
|---|---|
| 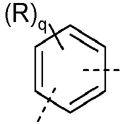 | 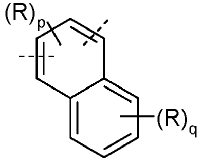 |
| B1 | B2 |
| 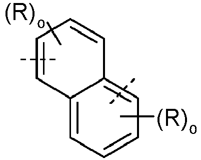 | 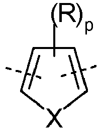 |
| B3 | B4 |
où R, o, p, q et X peuvent adopter les significations indiquées selon la revendication 2 par rapport aux noyaux A.

4. Polymère selon l'une ou plusieurs parmi les revendications 1 à 3, **caractérisé en ce que** les noyaux mono- ou polycycliques, aromatiques ou hétéroaromatiques Ar² et Ar³ dans les motifs récurrents de formule (la) sont choisis parmi les motifs Ar1 à Ar10 suivants :
| | |
|---|---|
| 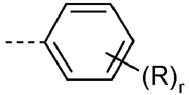 | 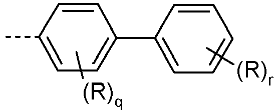 |
| Ar1 | Ar2 |
| 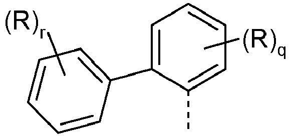 | 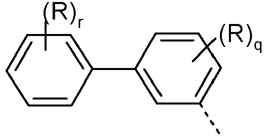 |
| Ar3 | Ar4 |
| 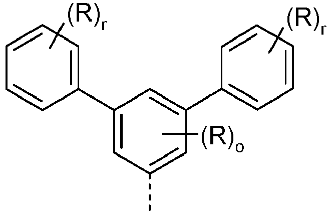 | 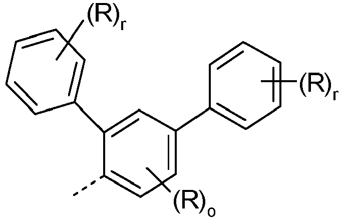 |
| Ar5 | Ar6 |
| 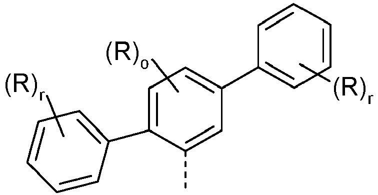 | 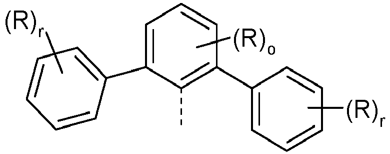 |
| Ar7 | Ar8 |
| 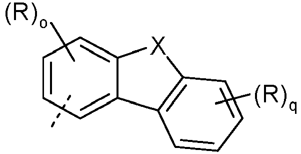 | 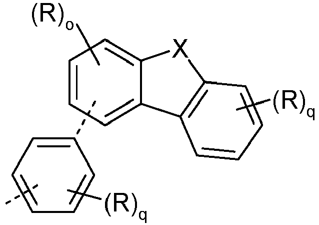 |
| Ar9 | Ar10 |
où R, o, q et X peuvent adopter les significations indiquées selon la revendication 2 par rapport aux noyaux A, et
r = 0, 1, 2, 3, 4 ou 5.

5. Polymère selon l'une ou plusieurs parmi les revendications 1 à 4, **caractérisé en ce que** les noyaux mono- ou polycycliques, aromatiques ou hétéroaromatiques Ar¹ et Ar⁴ dans les motifs récurrents de formule (la) sont choisis parmi les motifs Ar11 à Ar18 suivants :
| | |
|---|---|
| 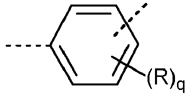 | 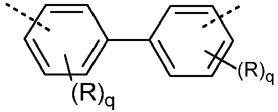 |
| Ar11 | Ar12 |
| 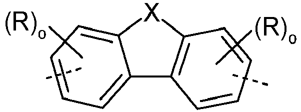 | 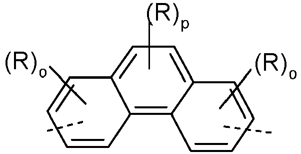 |
| Ar13 | Ar14 |
| 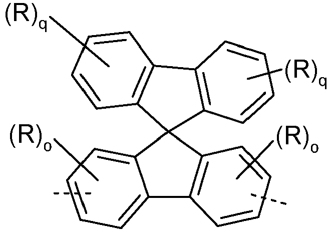 | 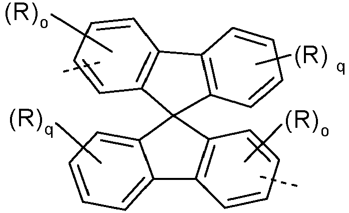 |
| Ar15 | Ar16 |
| 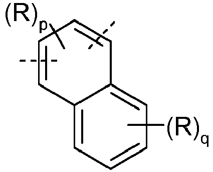 | 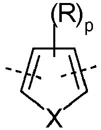 |
| Ar17 | Ar18 |
où R, o, q, p et X peuvent adopter les significations indiquées selon la revendication 2 par rapport aux noyaux A.

6. Polymère selon l'une ou plusieurs parmi les revendications 1 à 5, **caractérisé en ce que** la proportion de motifs récurrents de formule (la) dans le polymère se trouve dans la plage allant de 50 à 95% molaire, sur la base de 100% molaire de tous les monomères copolymérisables présents comme motifs récurrents dans le polymère.

7. Polymère selon l'une ou plusieurs parmi les revendications 1 à 6, **caractérisé en ce que**, outre les motifs récurrents de formule (la), le polymère contient également d'autres motifs récurrents qui sont différents des motifs récurrents de formule (la).

8. Polymère selon l'une ou plusieurs parmi les revendications 1 à 7, **caractérisé en ce que**, outre les un ou plusieurs motifs récurrents de formule (la) et éventuellement d'autres motifs récurrents, le polymère contient également au moins un motif récurrent qui contient au moins un groupement réticulable Q, où Q peut adopter les significations indiquées selon la revendication 1.

9. Polymère selon la revendication 8, **caractérisé en ce que** le motif structurel qui contient le au moins un groupement réticulable est choisi parmi les motifs récurrents de formules (IIIa) à (IIIf) 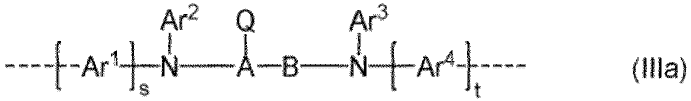 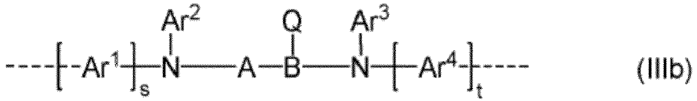 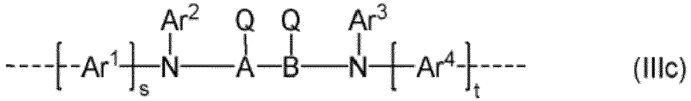 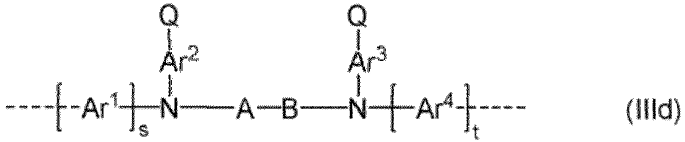 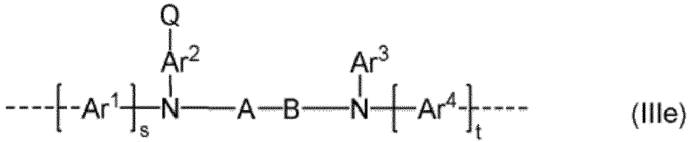 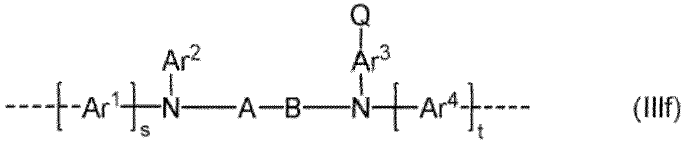 où A, B, Ar¹, Ar², Ar³, Ar⁴, Q, s et t peuvent adopter les significations indiquées selon la revendication 1 par rapport à la formule (la).

10. Procédé de préparation d'un polymère selon l'une ou plusieurs parmi les revendications 1 à 9, **caractérisé en ce qu'**il est préparé par polymérisation de SUZUKI, polymérisation de YAMAMOTO, polymérisation de STILLE ou polymérisation de HARTWIG-BUCHWALD.

11. Mélange polymère comprenant un ou plusieurs polymères selon l'une ou plusieurs parmi les revendications 1 à 9, qui contient au moins un motif récurrent de formule (la), et une ou plusieurs autres substances polymères, oligomères, dendritiques et/ou de bas poids moléculaire.

12. Solutions ou formulations d'un ou plusieurs polymères selon l'une ou plusieurs parmi les revendications 1 à 9 ou mélange polymère selon la revendication 11, dans un ou plusieurs solvants.

13. Utilisation d'un polymère selon l'une ou plusieurs parmi les revendications 1 à 9, dans des diodes électroluminescentes organiques (OLED), des cellules électrochimiques organiques émettant de la lumière (OLEC), des transistors organiques à effet de champ (OFET), des circuits intégrés organiques (O-IC), des transistors organiques à couche mince (TFT), des cellules solaires organiques (O-SC), des diodes laser organiques (O-lasers), des éléments ou dispositifs photovoltaïques organiques (OPV) ou des photorécepteurs organiques (OPC).

14. Diodes électroluminescentes organiques (OLED), cellules électrochimiques organiques émettant de la lumière (OLEC), transistors organiques à effet de champ (OFET), circuits intégrés organiques (O-IC), transistors organiques à couche mince (TFT), cellules solaires organiques (O-SC), diodes laser organiques (O-lasers), éléments ou dispositifs photovoltaïques organiques (OPV) et photorécepteurs organiques (OPC), ayant une ou plusieurs couches actives, où au moins l'une de ces couches actives comprend un ou plusieurs polymères selon l'une ou plusieurs parmi les revendications 1 à 9.
